Europäisches Patentamt

European Patent Office

Office européen des brevets

(11) Publication number : **0 660 422 A2**

(12) **EUROPEAN PATENT APPLICATION**

(21) Application number : 94309574.5

(22) Date of filing : 20.12.94

(51) Int. Cl.[6] : **H01L 31/20, H01L 31/075**

(30) Priority : 20.12.93 JP 319566/93
19.12.94 JP 315219/94

(43) Date of publication of application :
28.06.95 Bulletin 95/26

(84) Designated Contracting States :
CH DE FR GB IT LI

(71) Applicant : **CANON KABUSHIKI KAISHA**
**30-2, 3-chome, Shimomaruko,**
**Ohta-ku**
**Tokyo (JP)**

(72) Inventor : **Fujioka, Yasushi, c/o Canon**
**Kabushiki Kaisha**
**30-2, 3-chome Shimomaruko Ohta-ku**
**Tokyo (JP)**
Inventor : **Okabe, Shotaro, c/o Canon**
**Kabushiki Kaisha**
**30-2, 3-chome Shimomaruko Ohta-ku**
**Tokyo (JP)**

Inventor : **Kanai, Masahiro, c/o Canon**
**Kabushiki Kaisha**
**30-2, 3-chome Shimomaruko Ohta-ku**
**Tokyo (JP)**
Inventor : **Tamura, Hideo, c/o Canon Kabushiki**
**Kaisha**
**30-2, 3-chome Shimomaruko Ohta-ku**
**Tokyo (JP)**
Inventor : **Yasuno, Atsushi, c/o Canon**
**Kabushiki Kaisha**
**30-2, 3-chome Shimomaruko Ohta-ku**
**Tokyo (JP)**
Inventor : **Sakai, Akira, c/o Canon Kabushiki**
**Kaisha**
**30-2, 3-chome Shimomaruko Ohta-ku**
**Tokyo (JP)**
Inventor : **Hori, Tadashi, c/o Canon Kabushiki**
**Kaisha**
**30-2, 3-chome Shimomaruko Ohta-ku**
**Tokyo (JP)**

(74) Representative : **Beresford, Keith Denis Lewis**
**et al**
**BERESFORD & Co.**
**2-5 Warwick Court**
**High Holborn**
**London WC1R 5DJ (GB)**

(54) **Method of and apparatus for fabrication of photovoltaic cell.**

(57) The present invention is intended to fabricate a photovoltaic cell which demonstrates high efficiency and low deterioration. The present invention is also intended to uniformly form this photovoltaic cell at a high speed on a large area without unevenness by a roll-to-roll method. A top cell of an i-type semiconductor layer is formed by an RF plasma CVD method and a middle cell and/or a bottom cell are formed by a microwave plasma CVD method. A top cell of an impurity-doped layer at an incident light side is formed by plasma doping and a middle cell and/or a bottom cell are formed by the RF plasma CVD method.

The above-described objects are attained by providing film forming chambers respectively corresponding to the layers of a 2-layer or 3-layer tandem type photovoltaic cell and continuously forming semiconductor stacking films by a roll-to-roll method.

FIG. 12

EP 0 660 422 A2

## BACKGROUND OF THE INVENTION

### Field of the Invention

The present invention relates to a method of and an apparatus for high speed fabrication of a photovoltaic cell such as a solar cell, more particularly, a photovoltaic cell which is made of a silicon-based amorphous semiconductor and fabricated by a plasma CVD process, and provides a high conversion efficiency.

### Related Background Art

Lately, many serious problems of environmental pollution and contamination have been caused and reported. Meantime, a power generation system using solar cells which are photoelectric conversion devices utilizing light has been given interests and attentions as a clean power generation system capable of being free from those problems such as radioactive contamination resulting from nuclear power generation and a global tendency of higher temperature climate caused by thermal power generation and uneven distribution of an energy source which is not expected in the case of the sun shinning on every part of the globe, obtaining a relatively high power generation efficiency without requiring large complicated facilities and further meeting the increasing demands for power in the future without causing destructive effects on the global environment. Therefore, various researches and developments have been carried on to implement practical applications.

As can be seen, what is basically required to establish a power generation system using solar cells as means for covering some demands for power is that the solar cells to be used are able to provide sufficiently high photoelectric conversion efficiency and excellent stability of characteristics and can be mass-produced.

In this connection, it is generally known that a solar cell of approximately 3kW output is required per household to cover all the demands for power of each common household. Assuming the photoelectric conversion efficiency of the solar cell as, for example, approximately 10%, a total area of the solar cell to obtain the power required for the household is approximately 30m$^2$. For instance, the solar cells having the total area of 3,000,000m$^2$ are required to supply the power for 100,000 households.

For the above, those solar cells, which can be fabricated by decomposing a material gas such as silane, which can be easily obtained, in a glow discharging process and depositing amorphous semiconductor films such as amorphous silicon on a relatively inexpensive substrate made of a glass or metal sheet, have been preferred for high efficiency in volume production and possibility of fabrication with lower cost than for solar cells to be made using single crystal silicon, and therefore various methods and apparatuses for such solar cells have been proposed.

The specification of USP No. 4,400,409 discloses a continuous plasma CVD apparatus using a roll-to-roll system. It is described that, according to this apparatus, a cell having a semiconductor junction and a large area can be continuously formed by providing a plurality of glow discharging regions in the apparatus, arranging a flexible strip type substrate with a desired width and a sufficient length along a passage where the substrate passes through the plurality of glow discharging regions in sequence, and continuously feeding the substrate in its lengthwise direction while depositing a required conductive semiconductor layer on the substrate in respective glow discharging regions. From the above it will be appreciated that this roll-to-roll system is a method suited for volume production of semiconductor devices each having a large area.

On the other hand, a plasma process using microwaves has lately drawn attentions in this field. Microwaves enable for their high frequency to raise an energy density to a higher level than the conventional high frequencies such as radio frequencies and are therefore suitable for efficient generation and proper maintenance of the plasma.

As having been disclosed a roll-to roll type deposition film forming method and an apparatus thereof using the microwave plasma CVD process, for example, in Japanese Patent Application Laid-Open No. 3-30419, it is described that a deposition film can be formed even under a low pressure by generating the plasma with microwaves, polymerization of active species, which will be a cause of deterioration of characteristics of the deposition film, is prevented, a high quality deposition film is obtained, formation of particles such as polysilane in the plasma is controlled, and a film forming speed can be remarkably improved.

Japanese Patent Application Laid-Open No. 3-30419 discloses an apparatus adapted to form an i-type semiconductor layer by means of the microwave plasma CVD method and n and p-type semiconductor layers by means of an RF plasma CVD process, to continuously fabricate a p-i-n structure photo voltaic cell by the roll-to-roll type process. For photovoltaic cells made of an amorphous semiconductor, a p-i-n or n-i-p-type film structure is generally used. In this layer structure, the i-type semiconductor layer requires a certain specified film thickness to absorb an incident light while n and p-type semiconductor layers only require an extremely small film thickness as large as approximately 1/10 of that of the i-type semiconductor layer. Therefore, also even in the case of forming an i-type semiconductor layer, which requires a certain film thickness, by the microwave plasma CVD method which provides a high film forming speed in the roll-to-roll system, n-type and p-type semiconductor layers can be formed by an RF plasma CVD method in which the film forming speed is relatively slow. In addition, a high level of skill is required to form an extremely thin semiconductor film in high reproducibility by the microwave plasma CVD method which provides an extremely high film forming speed and therefore an RF plasma CVD method in which the film forming speed is relatively slow permits to more easily form an extremely thin semiconductor layer with excellent reproducibility.

In case of using the microwave plasma CVD method which provides a high film forming speed to form the i-type semiconductor layer in the roll-to-roll system, the feeding speed of the strip substrate can be substantially accelerated as compared with the RF plasma CVD method. When the feeding speed of the strip substrate is increased, a time necessary for forming the film is fixed in formation of n and p-type semiconductor layers and therefore a length of a film forming chamber need be extended in proportion to the feeding speed in the strip substrate feeding direction. However, even the RF plasma CVD method has a limit in formation of a thin homogeneous amorphous semiconductor layer on a large area with high reproducibility and there will be unavoidably caused variations of the film thickness, for example, an excessively larger or smaller film thickness than specified and unevenness of characteristics such as conductivity. Particularly, the film thickness of a p-type or n-type impurity-doped layer to be arranged at a incident light side of the i-type semiconductor layer should be reduced as least required to prevent a decrease of the amount of an incident light into the i-type semiconductor layer due to absorption of the light by the impurity-doped layer. However, it has been difficult for the conventional RF plasma CVD method to form a thin homogeneous impurity-doped layer on a large area in the extended film forming chamber and such difficulty has been a cause of variations and unevenness in the characteristics of the photovoltaic cell thus formed.

In most cases, photovoltaic cells such as, for example, solar cells or batteries are unitized by connecting in series or parallel unit modules of the photovoltaic cells to obtain a desired current or voltage. These unit modules are required to show less variations and unevenness in the characteristics of an output voltage and an output current across unit modules and, in a step for forming the unit modules, the characteristics of the semiconductor stacking films which are the largest factors which determine the characteristics are required to have a uniformity. A mass productivity of photovoltaic cells such as solar cells can be raised and the production costs can be substantially reduced by making it possible to form semiconductor stacking films with excellent characteristics over a large area in order to simplify the unit module assembly processes. In this connection, there has been a problem that the characteristics of the semiconductor stacking films for a photovoltaic cell to be fabricated are prone to show variations and unevenness in a continuous forming apparatus for the semiconductor stacking films for which the conventional i-type semiconductor is formed by the microwave CVD method and n-type and p-type semiconductor layers are formed by the RF plasma CVD method.

Alternatively, an ion implantation method has been known as a method for forming n-type and p-type amorphous semiconductor layers. According to the ion implantation method, the thickness of n-type and p-type semiconductor layers can be controlled by controlling the implantation strength of impurity ions. An ion implanter for implanting impurity ions, which generally comprises an ion producing unit, a unit for extracting ions in terms of beams, a beam scanning unit, is complicated in configuration and expensive and is therefore unsuitable for low cost production of photovoltaic cells made of an amorphous semiconductor with high productivity, has not been used as means for forming the impurity-doped layers.

On the other hand, as a method for forming extremely light junctions required for super LSIs and the like, a plasma doping method for introducing impurities by means of a plasma of impurity gases, not by the plasma of impurity gases, has lately been given attentions and is reported in the super LSI process handbook (published in 1990 by Science Forum). The collection of "Preprint of the 35th Lecture Meeting of the Applied Physics Federation 30p-M-6, 1988" discloses that the impurities can be doped into the amorphous silicon film by exposing an i-type amorphous silicon film to a high frequency plasma of impurity gases. However, application of this plasma doping method to formation of the impurity-doped layer of the photovoltaic cell such as a solar cell has not been disclosed and it has been absolutely unknown as to how satisfactory photovoltaic cells can be fabricated by the plasma doping method in fabrication of tandem type photovoltaic cells.

A characteristic deterioration phenomenon (Staebler-Wronski effect) caused along with light irradiation, which is not found in crystal-based solar cells, appears in amorphous silicon-based solar cells and is therefore an important subject for implementation of power application as well as achievement of cost reduction based on high efficiency-oriented technology and large area production technology. For a solution of the mechanism of light deterioration and countermeasures thereof, a number of researches and studies have been conducted in various aspects regarding semiconductor materials in view of reduction of impurities, devices in view of the tandem type cell structure and treatments for recovering the characteristics such as thermal annealing treatment. Particularly, the use of the tandem type cell structure, which enables to reduce the film thickness of the i-type semiconductor layer and control the light deterioration, has been noted in recent years since high efficiency can be attained by stacking solar cells with different band gaps. Particularly, of these tandem type cell structures, a 3-layer tandem type cell structure permits utilization of incident light spectrum in a wider range of wavelength and is therefore superior to a 2-layer tandem structure in obtaining a high photoelectric conversion efficiency and a high output voltage.

However, the 2-layer or 3-layer tandem type photovoltaic cells comprise a plurality of layers more than six or nine layers and the subject in this case has been how the semiconductor stacking films composed of a multiple layer structure can be continuously formed at a high rate with excellent reproducibility.

## SUMMARY OF THE INVENTION

As described above, the conventional roll-to-roll type semiconductor stacking films continuous forming apparatus includes a problem that the characteristics of the photovoltaic cells to be fabricated are prone to appear with variations and unevenness when the i-type semiconductor layer having a large film thickness is formed by the microwave plasma CVD method which enables film formation at a high speed. An object of the present invention made in view of the above problems is to provide a photovoltaic cell on which semiconductor stacking films for the photovoltaic cell having excellent characteristics is formed on a large area without variations and unevenness, a fabrication method, and an apparatus capable of continuously fabricating such photovoltaic cells at high speed.

Another object of the present invention is to provide semiconductor stacking films for the 2-layer or 3-layer tandem type photovoltaic cells capable of controlling deterioration of characteristics and providing high photoelectric conversion efficiency and high output voltage and an apparatus capable of continuously fabricating such photovoltaic cells with excellent reproducibility at a high speed.

A 2-layer tandem type photovoltaic cell, a fabrication method thereof, and a fabrication apparatus therefor according to the present invention are respectively:

a photovoltaic cell which has a stacking structure comprising a silicon-based amorphous semiconductor, including a first semiconductor layer having a first conductivity type, a first i-type semiconductor layer a main part of which is formed by a microwave plasma CVD method, a second semiconductor layer having a conductivity type opposite to the first conductivity type, a third semiconductor layer having the first conductivity type, a second i-type semiconductor layer formed by an RF plasma CVD method, and a fourth semiconductor layer having a conductivity type opposite to the first conductivity type, whereby the second semiconductor layer is formed by the RF plasma CVD method and the fourth semiconductor layer is formed by plasma doping;

a photovoltaic cell fabrication method for forming stacking films made of a silicon-based amorphous semiconductor on a substrate, comprising a step for forming an n(or p)-type by the RF plasma CVD method, a step for forming the i-type semiconductor layer by the microwave plasma CVD method, a step for forming a p(or n)-type semiconductor layer by the RF plasma CVD method, a step for forming the n(or p)-type semiconductor layer by the RF plasma CVD method, a step for forming the i-type semiconductor layer by the RF plasma CVD method, and a step for forming the p(or n)-type semiconductor layer by plasma doping; and

a photovoltaic cell fabrication apparatus for continuously forming stacking films made of a silicon-based amorphous semiconductor on a strip type substrate wherein at least a strip type substrate unwinding chamber, an n(or p)-type semiconductor layer film forming chamber by the RF plasma CVD method, an i-type semiconductor layer film forming chamber by the microwave plasma CVD method, a p(or n)-type semiconductor layer film forming chamber by the RF plasma CVD method, an n(or p)-type semiconductor layer film forming chamber by the RF plasma CVD method, an i-type semiconductor layer film forming chamber by the RF plasma CVD method, a p(or n)-type semiconductor layer film forming chamber by plasma doping, and a strip type substrate takeup chamber are arranged in this order along a direction where the strip type substrate is moved and connected with on another with gas gates, thereby continuously forming the stacking films made of a silicon-based amorphous semiconductor on the strip type substrate which is continuously moved to pass through the above-described film forming chambers.

Preferably, in the apparatus for fabricating a photovoltaic cell according to the present invention, the i-type semiconductor layer film forming chamber by the RF plasma CVD method is further arranged with a gas gate between the i-type semiconductor layer film forming chamber by the microwave plasma CVD method and the n(or p)-type semiconductor layer film forming chamber by the RF plasma CVD method which are arranged with the gas gates.

In addition, preferably, in the apparatus for fabricating the photovoltaic cell according to the present invention, the i-type semiconductor layer film forming chamber by the RF plasma CVD method is further arranged with a gas gate between the i-type semiconductor layer film forming chamber by the microwave plasma CVD method and the p(or n)-type semiconductor layer film forming chamber by the RF plasma CVD method which are arranged with the gas gates.

A 3-layer tandem type photovoltaic cell, a fabrication method thereof, and a fabrication apparatus therefor according to the present invention are respectively:

a photovoltaic cell which has a stacking structure comprising a silicon-based amorphous semiconductor, including a first semiconductor layer having a first conductivity type, a first i-type semiconductor layer a main part of which is formed by a microwave plasma CVD method, a second semiconductor layer having a conductivity type opposite to the first conductivity type, a third semiconductor layer having the first conductivity type, a second i-type semiconductor layer a main part of which is formed by a microwave plasma CVD method, a fourth semiconductor layer having a conductivity type opposite to the first conductivity type, a fifth semiconductor layer having the first conductivity type, a third semiconductor layer formed by the RF plasma CVD method, and a sixth semiconductor layer having a conductivity type opposite to the first conductivity type whereby the second semiconductor layer and the fourth semiconductor layer are formed by the RF plasma CVD method and the sixth semiconductor layer is formed by plasma doping;

a photovoltaic cell fabrication method for forming stacking films made of a silicon-based amorphous semiconductor on a substrate, comprising a step for forming an n(or p)-type by the RF plasma CVD method, a step for forming the i-type semiconductor layer by the microwave plasma CVD method, a step for forming a p(or n)-type semiconductor layer by the RF plasma CVD method, a step for forming the n(or p)-type semiconductor layer by the RF plasma CVD method, a step for forming the i-type semiconductor layer by the microwave plasma CVD method, a step for forming the p(or n)-type semiconductor layer by the RF plasma CVD method, a step for forming the n(or p)-type semiconductor layer by the RF plasma CVD method, a step for forming the i-type semiconductor layer by the RF plasma CVD method, and a step for forming the p(or n)-type semiconductor layer by plasma doping; and

a photovoltaic cell fabrication apparatus for continuously forming stacking films made of a silicon-based amorphous semiconductor on a strip type substrate wherein at least a strip type substrate unwinding chamber, an n(or p)-type semiconductor layer film forming chamber by the RF plasma CVD method, an i-type semiconductor layer film forming chamber by the microwave plasma CVD method, a p(or n)-type semiconductor layer film forming chamber by the RF plasma CVD method, an n(or p)-type semiconductor layer film forming chamber by the RF plasma CVD method, an i-type semiconductor layer film forming chamber by the microwave plasma CVD method, a p(or n)-type semiconductor layer film forming chamber by the RF plasma CVD method, an n(or p)-type semiconductor layer film forming chamber by the RF plasma CVD method, an i-type semiconductor layer film forming chamber by the RF plasma CVD method, a p(or n)-type semiconductor layer film forming chamber by plasma doping, and a strip type substrate takeup chamber are arranged in this order along a direction where the strip type substrate is moved and connected with gas gates, thereby continuously forming the stacking films made of a silicon-based amorphous semiconductor on the strip type substrate which is continuously moved to pass through the above-described film forming chambers.

Preferably, in the apparatus for fabricating a photovoltaic cell according to the present invention, the i-type semiconductor layer film forming chamber by the RF plasma CVD method is further arranged with a gas gate at least at a position between the i-type semiconductor layer film forming chamber by the microwave plasma CVD method and the n(or p)-type semiconductor layer film forming chamber by the RF plasma CVD method which are arranged with the gas gates.

In addition, preferably, in the apparatus for fabricating the photovoltaic cell according to the present invention, the i-type semiconductor layer film forming chamber by the RF plasma CVD method is further arranged with a gas gate at least at a position between the i-type semiconductor layer film forming chamber by the microwave plasma CVD method and the p(or n)-type semiconductor layer film forming chamber by the RF plasma CVD method which are arranged with the gas gates.

BRIEF DESCRIPTION OF THE DRAWINGS

Fig. 1 is a schematic cross sectional view showing an example of a continuous fabrication apparatus for a 2-layer tandem type photovoltaic cell according to the present invention;

Fig. 2 is a schematic cross sectional view showing an example of a continuous fabrication apparatus for a 3-layer tandem type photovoltaic cell according to the present invention;

Fig. 3 is a schematic cross sectional view showing an example of a film forming chamber by means of the microwave plasma CVD method in the apparatus according to the present invention;

Fig. 4 is a schematic diagram showing an example of a film forming chamber unit;

Fig. 5 is a schematic cross sectional view showing an example of a film forming chamber by means of the RF plasma CVD method in the apparatus according to the present invention;

Fig. 6A is a schematic cross sectional view showing an example of a strip type substrate unwinding chamber in the apparatus according to the present invention, and Fig. 6B is a schematic cross sectional view showing an example of a strip type substrate takeup chamber;

Fig. 7 is a schematic diagram showing an example of a steering mechanism;

Fig. 8 is a schematic cross sectional view showing an example of a continuous fabrication apparatus for a 2-layer tandem type photovoltaic cell according to the present invention;

Fig. 9 is an another schematic cross sectional view showing an example of a continuous fabrication apparatus for a 2-layer tandem type photovoltaic cell according to the present invention;

Fig. 10 is an another schematic cross sectional view showing an example of a continuous fabrication apparatus for a 3-layer tandem type photovoltaic cell according to the present invention;

Fig. 11 is an another schematic cross sectional view showing an example of a continuous fabrication apparatus for a 3-layer tandem type photovoltaic cell according to the present invention;

Fig. 12 is a schematic cross sectional view showing an example of a 2-layer tandem type photovoltaic cell according to the present invention;

Fig. 13 is a schematic cross sectional view showing an example of another 2-layer tandem type photovoltaic cell according to the present invention;

Fig. 14 is a schematic cross sectional view showing an example of an additional 2-layer tandem type photovoltaic cell according to the present invention;

Fig. 15 is a schematic cross sectional view showing an example of a 3-layer tandem type photovoltaic cell according to the present invention;

Fig. 16 is a schematic cross sectional view showing an example of another 3-layer tandem type photovoltaic cell according to the present invention; and

Fig. 17 is a schematic cross sectional view showing an example of an additional 3-layer tandem type photovoltaic cell according to the present invention.

## DETAILED DESCRIPTION OF THE PREFERRED EMBODIMENTS

The present invention is described below in detail, referring to the accompanying drawings.

[2-layer Tandem Type Photovoltaic Cell]

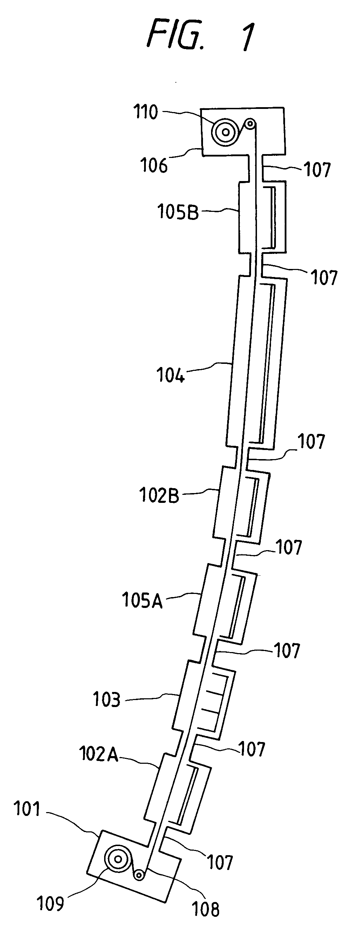

Fig. 1 is a schematic illustration showing a basic example of the continuous forming apparatus for semiconductor stacking films according to the present invention. In Fig. 1, the continuous forming apparatus for semiconductor stacking films according to the present invention basically comprises a strip type substrate unwinding chamber 101 for members, an n(or p)-type semiconductor layer film forming chamber 102A which is a first conductive type layer formed by an RF plasma CVD method, an i-type semiconductor layer film forming chamber 103 internally having three film forming chambers by a microwave plasma CVD method, a p(or n)-type semiconductor layer film forming chamber 104A of the second conductivity type different from the first conductivity type by the RF plasma CVD method, an n(or p)-type semiconductor layer film forming chamber 102B by the RF plasma CVD method, an i-type semiconductor layer film forming chamber 104 by the RF plasma CVD method, a p(or n)-type semiconductor layer film forming chamber 105 by plasma doping, and a strip type substrate takeup chamber 106, which are connected with one another with gas gates 107.

In the apparatus according to the present invention, the strip type substrate 108 is unwound from a bobbin 109 in the strip type unwinding chamber 101 and moved to pass through six film forming chambers, which are connected with the gas gates, until the strip type substrate is taken up by a bobbin 110 in the strip type substrate takeup chamber 106, whereby the stacking films made of an amorphous semiconductor of an n-i-p-n-i-p structure or a p-i-n-p-i-n structure are formed on the surface.

The present invention was completed through examinations based on the following findings the present inventors obtained from the earnest studies.

The inventors have formed a 2-layer tandem type photovoltaic cell made of an amorphous silicon-based semiconductor with an n-i-p-n-i-p structure or a p-i-n-p-i-n structure by forming an upper most i-type semiconductor layer with a relatively small film thickness as viewed from an incident light plane by the RF plasma CVD method, a lowermost i-type semiconductor layer with a relatively large thickness as viewed from the incident light plane by the microwave plasma CVD method, and n and p-type semiconductor layers by the RF plasma CVD in the roll-to-roll type apparatus shown in Fig. 1.

In this conventional apparatus, a film forming speed in the i-type semiconductor layer film forming chamber 103 by the microwave plasma CVD method has been extremely high as approximately 8nm/sec to permit high speed film formation of semiconductor stacking films for the 2-layer tandem type photovoltaic cell. Though the i-type semiconductor layer of the upper n-i-p structure photovoltaic cell has been formed by the RF plasma CVD method which provides the relatively slow film forming speed, a stronger light than to the i-type semiconductor layer of the lower cell is irradiated onto the i-type semiconductor layer of the upper cell in the 2-layer tandem type photovoltaic cell and the i-type semiconductor of the upper cell can be smaller in thickness than the i-type semiconductor layer of the lower cell to obtain the same level of output current, and therefore high speed formation of the whole semiconductor layer films has not been impeded by the slow film formation speed of the i-type semiconductor layer. Such high speed film formation which has thus been enabled makes it possible to speed up the transfer speed of the strip type substrate. For example, even though the transfer speed of the strip type substrate is raised up to approximately 100cm/min., the i-type semiconductor layer of approximately 300nm can be formed by providing three film forming chambers, each having a length of approximately 20cm, in the i-type semiconductor film forming chamber 103.

A silicon-based material such as amorphous silicon carbide with a large band gap and fine crystalline silicon with a small absorption factor of short wave light are preferably used for an impurity-doped layer at the incident light side of the i-type semiconductor layer of the photovoltaic cell to prevent absorption of light by the impurity-doped layer. In this connection, the inventors have used fine crystalline silicon with which a conductivity higher as much as approximately three digits than amorphous silicon can be obtained in the impurity-doped layer at the incident light side. In this case, there has been a problem as described below in high speed formation of a fine crystalline layer of a high conductivity factor into which impurities were doped by the RF plasma CVD method.

Specifically, the problem is such that, if the film forming speed is raised by increasing the flow rate of material gas which contains silicon atoms, the ratio of a high frequency power to the flow rate of material gas lowers, a fine crystalline film cannot be formed, the film is formed as an amorphous layer, and the conductivity factor suddenly lowers, thereby deteriorating the characteristics of the photovoltaic cell. On the other hand, if the high frequency power is increased and the film forming speed is raised, the distribution of the film forming speed and the conductivity factor in the film forming region is increased, an extremely thin film cannot be uniformly formed over the whole film forming region, a huge amount of high frequency power is required for fine crystallization, and an extremely large power supply is required and simultaneously it is difficult to uniformly supply the power. In addition, there is a problem that abnormal discharging is apt to occur. For the above reasons, the RF plasma CVD method is limited in formation of the extremely thin layer of fine crystalline silicon with a high conductivity factor at a high speed and therefore a thin layer of approximately 10nm should be formed at a film forming speed of approximately 10nm/min. on less.

Accordingly, for forming the i-type semiconductor layer by the microwave plasma CVD method in the conventional roll-to-roll type apparatus, a film forming chambers which are long in the feeding direction of the strip type substrate have been required to form an impurity-doped layer at the incident light side of the i-type semiconductor layer.

Though it has been very difficult to uniformly form a high quality extremely thin impurity-doped layer of approximately 10nm in such long film forming chambers 105A and 105B, the present inventors have studied the adaptability of the film forming conditions to the characteristics of the photovoltaic cell which is fabricated by varying the flow rate of material gas to be introduced in order to find better film forming conditions. Through the studies, the present inventors have found that the photovoltaic cell could be fabricated despite of decreasing the flow rate of silicon material gas $SiH_4$ to be supplied to the film forming chamber 105B, where the impurity-doped layer located nearest the incident light side is formed, finally to zero. In other words, the present inventors have found that the impurity-doped layer could be formed on the i-type semiconductor layer even by a plasma which does not contain a material gas of silicon atoms and a 2-layer tandem type photovoltaic cell of the n-i-p-n-i-p or p-i-n-p-i-n structure could be fabricated. This process can never be imagined from the conventional idea that the impurity-doped layer is formed by stacking silicon films in which impurities have been doped.

In analyses of distributions of silicon element and impurity elements of the fabricated photovoltaic cell in a direction of film thickness by the secondary ion mass spectroscopy (SIMS), it has been ascertained that an extremely thin high density impurity-doped layer of approximately 10nm was formed on the i-type semiconductor layer even when the surface of the i-type semiconductor layer was exposed to the plasma without flowing $SiH_4$. Similarly, in analyses of variations and unevenness of the impurity-doped layer on the i-type semiconductor layer of the fabricated photovoltaic cell, it has been ascertained that the uniformity of the film thickness of the impurity-doped layer in the case where $SiH_4$ is not supplied is higher than in the case where $SiH_4$ as much as required for stacking the films having the specified film thickness.

It is deemed that a reason why the impurity-doped layer is thus formed without supplying material gas of silicon $SiH_4$ is that a silicon-based amorphous semiconductor containing impurities is not deposited and a doping gas containing impurities such as $B_2H_6$ and $PH_3$ is ionized into impurity ions by the plasma and implanted in an extremely thin region near the surface of the i-type semiconductor layer by the energy of plasma, that is, by the so-called plasma doping.

In addition, though the cause is unknown, the present inventors have come to find in their experiments that, in case of forming a relatively thin fine crystalline film of approximately 50nm such as the impurity-doped layer of the photovoltaic cell, a crystallinity in the p-type fine crystalline film formed by plasma-doping the i-type film with a plasma containing $B_2H_6$ and other impurities after depositing the i-type film with the plasma containing only $SiH_4$ is better than the p-type fine crystalline film deposited by the plasma of mixed gas containing material gas $SiH_4$ of silicon and impurity gas of $B_2H_6$. In case of plasma-doping the fine crystalline i-type semiconductor layer, it is important to prevent deterioration of the crystallinity of the i-type semiconductor layer. For this, it is preferable to supply a large volume of hydrogen gas simultaneously with a gas containing impurity elements in plasma doping.

The hydrogen gas is made to become excited hydrogen by the plasma and acts on the film surface to fine the surface of the film and improve the crystallinity of the impurity-doped layer to be formed. The flow rate of hydrogen gas is preferably ten times or more than the gas (not diluted) containing impurity elements and more preferably 100 times or over.

When the temperature on the surface of the deposited film is high, the action of the excited hydrogen on the film surface is lowered due to desorption of hydrogen from the surface of the deposited film. Therefore, the temperature of the substrate in plasma doping is preferably 400°C or under, more preferably 300°C or under, and optimally 200°C or under.

In deposition of a fine crystalline film containing B as a p-type impurity by the plasma CVD method, the crystallinity is prone to deteriorate and an amorphous film tends to be formed.

This is the same in stacking the photovoltaic cell having a p-i-n junction in two or more multiple layers.

In fabrication of the photovoltaic cell by plasma doping on the i-type semiconductor layer without flowing $SiH_4$ gas as described above, the present inventors fabricated seven types of photovoltaic cells by varying the discharging frequency from 1kHz to 10kHz, 75kHz, 400kHz, 1MHz, 4MHz, 13.56MHz while maintaining the discharging power at a fixed level, and carrying out plasma doping at respective discharging frequencies. Consequently, the inventors found that the photovoltaic cells with satisfactory characteristics could be formed without variations and unevenness in large areas at respective discharging frequencies from 1kHz to 13.56MHz.

In addition, the present inventors have adapted the apparatus shown in Fig. 1 to form all impurity-doped layers at the incident light side of the i-type semiconductor layer without flowing $SiH_4$ gas even in the film forming chamber 105A.

Compared with a case that the layers are formed by the RF plasma CVD method while flowing $SiH_4$ gas, deterioration of curve factors have been observed in the output characteristics (the voltage-current characteristics when the light is irradiated) of the tandem type photovoltaic cell to be fabricated and satisfactory characteristics of the cell could not be obtained. However, when only the impurity-doped layer nearest the incident light side in the film forming chamber 105B was formed by the plasma doping, such deterioration of the curve factors has not been observed.

When a single type photovoltaic cell having the i-type semiconductor layer formed by the microwave plasma CVD method is fabricated by forming the films only in the film forming chambers 102A, 103 and 105A in the apparatus shown in Fig. 1, the above-described deterioration of the curve factors is not observed and satisfactory characteristics of the cell can be obtained even though the method for forming the impurity-doped layer in the film forming chamber 105A is changed from the RF plasma CVD method to the plasma doping method.

In other words, it is clarified that the deterioration of the curve factors is observed only when the impurity-doped layer at the incident light side of the i-type semiconductor layer is formed by plasma doping and an opposite conductivity type semiconductor layer is further deposited on the impurity-doped layer.

The present invention based on the above findings is intended to realize an apparatus capable of fabricating a high quality photovoltaic cell on a large area at a high speed without variations and unevenness. Specifically, the present invention is intended to solve a problem that it has been difficult to a thin and homogeneous impurity-doped layer in a large area on the i-type semiconductor layer in the conventional roll-to-roll type continuous forming apparatus for semiconductor stacking films which forms the i-type semiconductor layer by the microwave plasma CVD method and n- and p-type semiconductor layers by the RF plasma CVD method and variations and unevenness have been prone to occur in the characteristics of the photovoltaic cell to be fabricated, by adapting the apparatus to form the impurity-doped layer nearest the incident light side by plasma doping, and to continuously fabricate a high quality 2-layer tandem type photovoltaic cell at a high speed on a large area without variations and unevenness.

[3-layer Tandem Type Photovoltaic Cell]

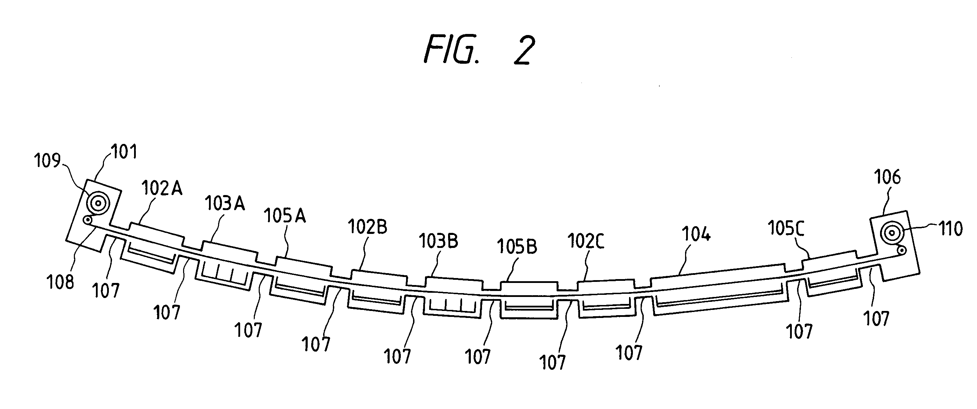

Fig. 2 is a schematic illustration showing a basic example of a continuous forming apparatus for semiconductor stacking films according to the present invention. In Fig. 2, the continuous forming apparatus for semiconductor stacking films according to the present invention basically comprises a strip type substrate unwinding chamber 101, an n(or p)-type semiconductor layer film forming chamber 102A by an RF plasma CVD method, an i-type semiconductor layer film forming chamber 103A internally having three film forming chambers by a microwave plasma CVD method, a p(or n)-type semiconductor layer film forming chamber 104A by the RF plasma CVD method, an n(or p)-type semiconductor layer film forming chamber 102B by an RF plasma CVD method, an i-type semiconductor layer film forming chamber 103A internally having three film forming chambers by a microwave plasma CVD method, a p(or n)-type semiconductor layer film forming chamber 104B by the RF plasma CVD method, an n(or p)-type semiconductor layer film forming chamber 102C by an RF plasma CVD method, an i-type semiconductor layer film forming chamber 104 by the RF plasma CVD method, a p(or n)-type semiconductor layer film forming chamber 105C by plasma doping, and a strip type substrate takeup chamber 106, which are connected with one another with gas gates 107.

In the apparatus according to the present invention, the strip type substrate 108 is unwound from a bobbin 109 in the strip type unwinding chamber 101 and moved to pass through six film forming chambers, which are connected with the gas gates, until the strip type substrate is taken up by a bobbin 110 in the strip type substrate takeup chamber 106, whereby the stacking films made of an amorphous semiconductor of a n-i-p-n-i-p-n-i-p structure or a p-i-n-p-i-n-p-i-n structure are formed on the surface.

The present invention was completed through examinations based on the following findings the present inventors obtained from the earnest studies.

The inventors have formed a 3-layer tandem type photovoltaic cell made of an amorphous silicon-based semiconductor with an n-i-p-n-i-p-n-i-p structure or a p-i-n-p-i-n-p-i-n structure by forming two upper most i-type semiconductor layers with a relatively small film thickness as viewed from an incident light plane by the RF plasma CVD method, two lower most i-type semiconductor layers with a relatively large thickness as viewed from the incident light plane by the microwave plasma CVD method, and n- and p-type semiconductor layers by the RF plasma CVD in the roll-to-roll type apparatus shown in Fig. 2.

In this conventional apparatus, a film forming speed in the i-type semiconductor layer film forming chambers 103A and 103B by the microwave plasma CVD method has been extremely high as approximately 8nm/sec to permit high speed film formation of semiconductor stacking films for the 3-layer tandem type photovoltaic cell. Though the i-type semiconductor layer of the upper most n-i-p structure photovoltaic cell has been formed by the RF plasma CVD method which provides the relatively slow film forming speed, a strongest light is irradiated onto the i-type semiconductor layer of the upper most cell of 3-layer tandem type photovoltaic cells which are connected in series and the i-type semiconductor of the upper most cell can be smaller in thickness among the i-type semiconductor layers of three cells to obtain the same level of output current, and therefore high speed formation of the whole semiconductor layer films has not been impeded by the slow film formation speed of the i-type semiconductor layer. Such high speed film formation which has thus been enabled makes it possible to speed up the transfer speed of the strip type substrate. For example, even though the transfer speed of the strip type substrate is raised up to approximately 100cm/min., the i-type semiconductor layer of approximately 300nm can be formed by providing three film forming chambers, each having a length of approximately 20cm, in the i-type semiconductor film forming chambers 103A and 103B.

Likewise the 2-layer tandem type photovoltaic cell, a silicon-based material such as amorphous silicon carbide with a large band gap and fine crystalline silicon with a small absorption factor of short wave light are preferably used for an impurity-doped layer at the incident light side of the i-type semiconductor layer of the photovoltaic cell to prevent absorption of light by the impurity-doped layer. In this connection, the inventors have used fine crystalline silicon with which a conductivity higher as much as approximately three digits than amorphous silicon can be obtained in the impurity-doped layer at the incident light side. In this case, there has been a problem as described with respect to the 2-layer tandem type cell in high speed formation of a fine crystalline layer of a high conductivity factor into which impurities were doped by the RF plasma CVD method.

In other words, the present inventors found that the impurity-doped layer is formed on the i-type semiconductor layer by a gas plasma which does not contain the material gas of silicon atoms and the 3-layer tandem type photovoltaic cell of the n-i-p-n-i-p-n-i-p or p-i-n-p-i-n-p-i-n structure can be formed. This finding can never be attained in the conventional idea of forming the impurity-doped layer by depositing silicon films in which impurities are doped.

In addition, the present inventors have adapted the apparatus shown in Fig. 2 to form all impurity-doped layers at the incident light sides of the i-type semiconductor layer without flowing $SiH_4$ gas in the film forming chambers 105A and 105B.

Compared with a case that the layers are formed by the RF plasma CVD method while flowing $SiH_4$ gas, deterioration of curve factors have been observed in the output characteristics (the voltage-current characteristics when the light is irradiated) of the tandem type photovoltaic cell to be fabricated and satisfactory characteristics of the cell could not be obtained. However, when only the impurity-doped layer nearest the incident light side in the film forming chamber 105C was formed by the plasma doping, such deterioration of the curve factors has not been observed.

When a single type photovoltaic cell having the i-type semiconductor layer formed by the microwave plasma CVD method is fabricated by forming the films only in the film forming chambers 102A, 103A and 105A in the apparatus shown in Fig. 2, the above-described deterioration of the curve factors is not observed and satisfactory characteristics of the cell can be obtained even though the method for forming the impurity-doped layer in the film forming chamber 105A is changed from the RF plasma CVD method to the plasma doping method.

In other words, it is clarified that the deterioration of the curve factors is observed only when the impurity-doped layer at the incident light side of the i-type semiconductor layer is formed by plasma doping and an opposite conductivity type semiconductor layer is further deposited on the impurity-doped layer.

The present invention based on the above findings is intended to realize an apparatus capable of fabricating a high quality photovoltaic cell on a large area at a high speed without variations and unevenness. Specifically, the present invention is intended to solve a problem that it has been difficult to a thin and homogeneous impurity-doped layer in a large area on the i-type semiconductor layer in the conventional roll-to-roll type continuous forming apparatus for semiconductor stacking films which forms the i-type semiconductor layer by the microwave plasma CVD method and n- and p-type semiconductor layers by the RF plasma CVD method and variations and unevenness have been prone to occur in the characteristics of the photovoltaic cell to be fabricated, by adapting the apparatus to form the impurity-doped layer nearest the incident light side by plasma doping, and to continuously fabricate a high quality 2-layer tandem type photovoltaic cell at a high speed on a large area without variations and unevenness.

### i-type Semiconductor Layer Film Forming Chamber by Microwave Plasma CVD Method

In the apparatus which uses 2-layer or 3-layer tandem type photovoltaic cells according to the present invention, the i-type semiconductor layer film forming chamber which depends on the microwave plasma CVD method refers to a film forming chamber for continuously forming substantially genuine silicon-based amorphous semiconductor layers on a continuously moving strip type substrate by the microwave plasma CVD method.

A plurality of i-type semiconductor layer film forming chambers which depend on the microwave plasma CVD method in the apparatus according to the present invention can be provided as being interconnected to meet higher moving speeds of the strip type substrate without expanding the dimensions of one film forming chamber over the specified dimensions or form one layer under a plurality of film forming conditions.

In the apparatus according to the present invention, a microwave power for forming a plasma need be introduced into the film forming chamber which depends on the microwave plasma CVD method. In this case, means for supplying the microwave power can be means such as a microwave introducing window which comprises a microwave transmitting member as disclosed in Japanese Patent Application Laid-Open No. 3-30419, a microwave leak waveguide as disclosed in Japanese Patent Application Laid-Open No. 3-30420, and a microwave radiation antenna as disclosed in Japanese Patent Application Laid-Open No. 3-30421 and means which is made meet ECR conditions by combining these means with a magnetic forming device.

The following described in detail the microwave introducing window, which comprises the microwave transmitting member, to be used as microwave power input means.

The microwave transmitting member is provided at the extreme end part of the microwave introducing window to separate a vacuum atmosphere in the film forming chamber from external air where the microwave introducing window is installed and designed to have a construction capable of withstanding a pressure difference between the internal space and the external space. Practically, the microwave transmitting member is a flat plate or a bell jar type, tablet type or a conical type member of which cross section along a microwave propagating direction is preferably circular, rectangular or elliptical.

A thickness of the microwave transmitting member in the microwave propagating direction should preferably be designed in view of a dielectric constant of a material to be used so that reflection of the microwave is minimized. For example, in a case that the microwave transmitting member is a flat plate, the thickness is preferably approximately equal to a 1/2 of the wavelength of microwave. In addition, a material of the microwave transmitting member is preferably capable of transmitting of microwave energy radiated through the microwave introducing window into the film forming chamber with a least loss and excels in air tightness which completely prevents flowing of air into the film forming chamber, and specifically it can be glass or fine ceramics made of quartz, alumina, silicon nitride, beryllia, magnesia, zirconia, boron nitride, and silicon carbonate.

It is preferable to uniformly cool the microwave transmitting member to prevent thermal deterioration (cracks and breakage) or the like due to heating by microwave energy and/or plasma energy.

Practical cooling means can be cooling air flow to be blown onto the surface of the microwave transmitting member which faces the external air side, cooling media such as air, water, oil and freon for cooling the microwave introducing window or cooling means for cooling the microwave transmitting member through a part which comes in contact with the microwave introducing window. A plasma of high electron density can be generated by cooling the microwave transmitting member to a sufficiently low temperature without causing any damage such as cracks due to heat produced on the microwave transmitting member even when a relatively high microwave power is introduced into the film forming chamber.

As on the strip type substrate, stacking of films occurs at a portion of the microwave transmitting member which is exposed to the microwave plasma. Depending on the type and characteristics of films to be stacked, the microwave power to be radiated from the microwave introducing window is absorbed or reflected by the stacking films, an input amount of microwave energy into the film forming chamber formed by the strip type substrate decreases and, when a value of variation of the microwave energy remarkably increases as compared that immediately after the radiation is started, not only it is difficult to maintain the microwave plasma but also the film forming speed of the stacking films may be slowed down and the characteristics may be varied. In such case, films stacked on the microwave transmitting member can be removed by dry etching, wet etching or a mechanical method such as blasting to restore the original condition. Particularly, dry etching is more preferable as a method for removing the stacked films while maintaining the vacuum condition.

The microwave transmitting member is taken out from the film forming chamber by the so-called load lock method while maintaining the vacuum condition in the film forming chamber together with microwave applicator means and the films stacked on the microwave transmitting member can be exfoliated by wet etching or a mechanical removing method for recycling or replaced with a new component part.

In addition, another method can be used by which stacking films are adhered and formed on a sheet made of a microwave transmitting material equivalent to the microwave transmitting member by continuously feeding this sheet along the surface of the microwave transmitting member at the film forming chamber side, and the sheet is ejected out of the microwave plasma region.

Furthermore, a metal member or a microwave reflecting member, which finely and vertically divides the microwave field can be arranged at the film forming chamber side of the microwave transmitting member as disclosed in Japanese Patent Application Laid-Open No. 3-110798 to make the plasma difficult to be generated at the divided portions despite that a microwave power is introduced into the film forming chamber and consequently a distance between the plasma in the film forming chamber and the microwave introducing window is extended to prevent the film from being adhered onto the microwave introducing window.

The microwave introducing window has a construction capable of introducing a microwave power supplied from the microwave power supply into the film forming chamber and transforming material gas for forming the stacking films introduced into the film forming chamber to the plasma.

Specifically, the microwave transmitting member which is mounted on the extreme end part of the microwave transmitting waveguide so that air tightness can be maintained is used. The microwave introducing window can be based on the same standard as for the microwave transmitting waveguide or can be made according to the other standard. The dimensions and shape of the microwave introducing window are preferably determined and designed so that a microwave transmitting mode in the microwave introducing window is a single mode to ensure efficient transmission of the microwave power in the film forming chamber and stable generation, maintenance and control of the microwave plasma. Even a microwave introducing window through which the microwave power is transmitted in a plurality of modes can be used by appropriately selecting microwave plasma generating conditions such as the material gas, pressure and microwave power. The transmission mode for the microwave introducing window to be designed to accept the single mode can be, for example, $TE_{10}$ mode, $TE_{11}$ mode, $eH_1$ mode, $TM_{11}$ mode, and $TM_{01}$ mode. Preferably, $TE_{10}$ mode, $TE_{11}$ mode and $eH_1$ mode are selected. A waveguide which permits transmission of the above-described transmission modes is connected to the microwave introducing window, and preferably the transmission mode in the waveguide should be equal to the transmission mode in the microwave applicator means. A type of waveguide is appropriately selected in accordance with a microwave frequency band and a transmission mode and at least a cutoff frequency is preferably smaller than a frequency to be used. Specifically, a waveguide with an inside diameter of a rectangular section and width 96cm x height 27cm can be enumerated for microwave of 2.45GHz, in addition to those waveguides having rectangular, circular and elliptical cross sections in conformity to the JIS, EIAJ, IEC and JAN etc.

Since the microwave power to be supplied from the microwave power supply is efficiently introduced into the film forming chamber through the microwave introducing window, a problem regarding the reflected microwave resulting from the microwave introducing window can be easily avoided and relatively stable discharging can be maintained in the microwave circuit without using a microwave matching circuit such as a three-stub tuner or an E-H tuner. However, in a case that strong reflected microwaves due to abnormal discharging are produced before and after the discharging is started, it is preferable to provide the above-described microwave matching circuit to protect the microwave power supply.

In the apparatus according to the present invention, the microwave introduction by the means for introducing the microwave power into the film forming chamber which depends on the above-described microwave plasma CVD method can be made in any direction such as, for example, a direction normal to the semiconductor layer forming surface of the strip type substrate when the plasma is formed in the film forming chamber, a direction parallel to the semiconductor layer forming surface of the strip type substrate and normal to a direction of movement of the substrate or a direction parallel to the semiconductor layer forming surface of the strip type substrate and to a direction of movement of the substrate, or can be made simultaneously in several directions. Preferably, the microwave power is introduced in a direction parallel to the semiconductor layer forming surface of the strip type substrate and normal to the direction of movement thereof.

Though the number of means for introducing the microwave power into the film forming chamber which depends on the microwave plasma CVD method can be as many as required as far as the plasma is formed in the film forming chamber, a plurality of means is preferably provided if a large plasma forming space is available. In case of introducing the microwave power in the direction parallel to the semiconductor layer forming surface of the strip type substrate and normal to the direction of movement thereof, a substantially uniform plasma can be formed on the strip type substrate merely by introducing the microwave from one side of the strip type substrate if the width of the strip type substrate is relatively small but it is preferable to introduce the microwave from both sides of the strip type substrate if the width of the strip type substrate is large.

In a case that a plurality of microwave introducing means is provided, microwave power supplies can be provided to supply the microwave power to respective means or a microwave power from a few number of power supplies can be divided by a power divider and supplied to respective means.

In case of arranging a plurality of microwave introducing means to oppose to one another in the film forming chamber, which depends on the microwave plasma CVD method, of the apparatus according to the present invention, these means should be arranged so that the microwave power which is radiated from one microwave introducing means and received by the other microwave introducing means does not reach the microwave power supply connected to the latter microwave introducing means to cause adverse effects such as a damage of the microwave power supply and abnormal oscillation of the microwave.

Practically, a plurality of microwave introducing means should be arranged so that the directions of microwave fields which run through the microwave means are not parallel to each other. In other words, the waveguides should be arranged so that the longer sides or the surfaces including the lengthwise axis of waveguides to be connected to the microwave introducing means are not parallel to each other.

In the apparatus according to the present invention, the strip type substrate should be passed through the film forming chambers, where the microwave plasma CVD method is used, to continuously form a semiconductor layer. As a shape of the strip type substrate in the film forming chambers, a flat shape as disclosed in the specification of USP No. 4566403 and a $\Omega$ shape as disclosed in Japanese Patent Application Laid-Open No. 3-30419 can be enumerated.

In the apparatus according to the present invention, a material gas for forming stacking films in the film forming chamber, which depends on the microwave plasma CVD method, is discharged into the film forming chamber from a gas guide tube, which is arranged in the film forming chamber through which the strip type substrate passes and provided with a single gas discharging hole or a plurality of gas discharging holes, into the film forming chamber, and transformed to the plasma by the microwave power supplied to form a microwave plasma region. A material which will not be damaged in the microwave plasma is preferably used as a material for forming the gas guide tube. Specifically, this material can be heat-resistant metals such as stainless steel, Ni, Ti, and W, and these metals to which ceramics such as alumina and silicon nitride is flame-coated.

Though the material gas can be introduced at any positions of the film forming chamber, it is preferable to introduce the material gas from a plurality of positions in the widthwise direction of the strip type substrate so that a plasma is uniformly formed at least in the widthwise direction of the strip type substrate.

In the apparatus according to the present invention, a vacuum pump is used as means for evacuating the film forming chamber, which depends on the microwave plasma CVD method, to pressure suitable for forming the semiconductor layer. According to the microwave plasma CVD method, the plasma can be maintained at a lower pressure than in the RF plasma CVD method and high quality stacking films can be quickly formed by lowering the pressure for forming the stacking films and therefore the film forming chamber is preferably evacuated by a vacuum pump capable of obtaining a higher level of vacuum than in the film forming chamber which depends on the RF plasma CVD method. Specifically, vacuum pumps adapted to obtain such high level of vacuum include a turbo molecular pump, an oil diffusion pump, a cryo pump and a pump made up by combining one of these pump with a rotary pump or a mechanical booster pump. Preferably, the turbo molecular pump or the oil diffusion pump which is combined with the rotary pump or the mechanical booster pump is used.

A plurality of evacuation pipes (evacuation ports) for evacuating the film forming chambers which depend on the microwave plasma method can be provided for such purposes as to discharge a large volume of material gas and decomposed material gas, discharge a gas from respective plasma spaces when the film forming chamber is partitioned to form a plurality of plasma spaces without diffusion of gas, form a plurality of material gas flows in a plurality of directions in the film forming chamber, or divide the evacuation means into means for rough evacuation to obtain a low level of vacuum and means for evacuation to obtain a high level of vacuum.

It is preferable to arrange evacuation pipes (evacuation ports) for evacuating the film forming chambers which depend on the microwave plasma method, which are made of a metal mesh or a metal sheet provided with such small holes at a high density as to admit passing of gas and prevent passing of microwaves while preventing leakage of microwaves, so that the plasma may not become unstable due to leakage of the microwave power to be introduced into the film forming chamber from the plasma forming spaces and noise may not enter into external electronic devices.

In the apparatus according to the present invention, it is preferable to provide temperature control means for controlling the strip type substrate, which is moved in the film forming chamber to form a semiconductor layer thereon, to a temperature suited to form the semiconductor layer in the film forming chamber which depends on the microwave plasma CVD method.

Since the cooling effect of the substrate by convention of the gas is low under a low pressure suitable for the microwave plasma CVD method, the strip type substrate is exposed to a high density microwave plasma and may therefore be heated to a higher temperature than specified in a process where the semiconductor layer is formed. Accordingly, it is preferable to provide temperature control means so that the strip type substrate is heated to a temperature suitable to forming the semiconductor layer before the strip type substrate enters into the plasma forming space and a fixed temperature is maintained in the plasma forming space. For example, for a large microwave power to be introduced, a heater for heating the strip type substrate the temperature of which is lowered during passing through the gas gate is arranged in front of the plasma forming space and cooling means for maintaining the strip type substrate to be heated by the plasma at a fixed temperature is arranged in the plasma forming space.

It is preferable to control the temperature of the strip type substrate from its rear side during formation of the film since the semiconductor layer is formed on the surface of the strip type substrate in the film forming chamber.

For heating the strip type substrate, it is preferable to use radiation type heater means such as a lamp heater capable of non-contact heating since the strip type substrate is continuously moved in the film forming chamber and, as temperature measuring means for controlling the temperature of the strip type substrate, it is preferable to use a moving surface thermometer using a quick responsive thermocouple of a small thermal capacity which is capable of measuring a temperature of a moving surface or a radiation thermometer capable of non-contact measurement.

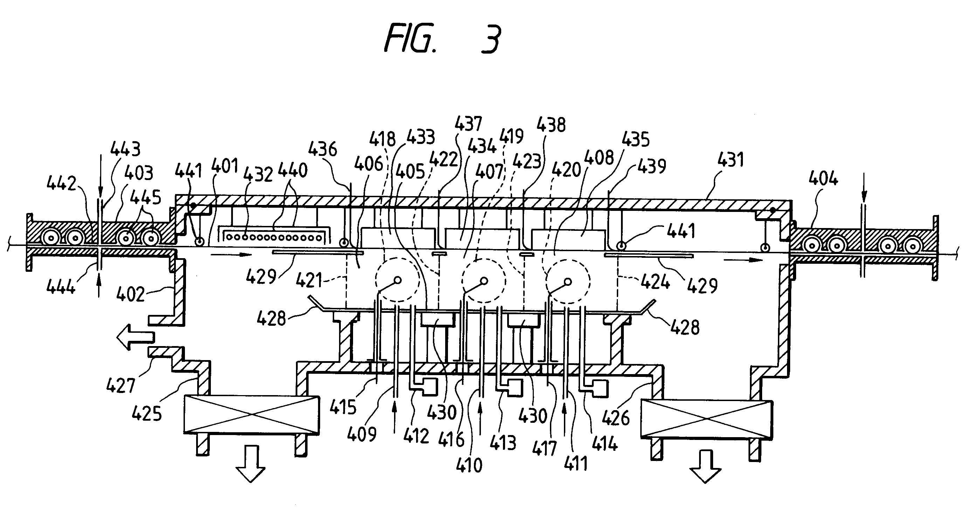

Fig. 3 is a schematic cross sectional view showing an preferable example of the film forming chamber which depends on the microwave plasma CVD method for use in the apparatus according to the present invention.

[Discharging Chamber Unit]

In Fig. 3, the strip type substrate 401 is entered into a vacuum container 402 through a gas gate 403, moved from left to right and ejected to a gas gate 404.

A box type film forming chamber unit 405 is remountably installed in the vacuum container 402, and a silicon-based amorphous semiconductor layer is formed on the surface (lower surface) of the strip type substrate which moves in the upper parts of the film forming chambers by forming the plasma in the film forming chambers 406, 407 and 408 which are made by partitioning the internal space of the film forming chamber 405 with perforated partitions 421, 422, 423 and 424.

A plurality of film forming chambers for forming the i-type semiconductor layer are provided to form the i-type semiconductor layer in which the characteristics such as the band gap of the film in the direction of film thickness are changed by varying the film forming conditions in respective film forming chambers; for example, an i-type semiconductor layer with the band gap varied as 1.7eV, 1.6eV or 1.5eV in the direction of film thickness can be formed on the strip type substrate which is continuously moved by forming stacking films with band gaps of 1.7eV, 1.6eV and 1.5eV in three film forming chambers 406, 407 and 408. The film thickness of stacking films formed in respective film forming chambers can be changed and the profile of the characteristic in the film thickness direction can be changed by varying the film forming speeds in respective film forming chambers or shifting the positions of the perforated partitions 422 and 423 which are provided to be movable to partition the film forming chambers.

In addition, the profile of the characteristics in the direction of film thickness can be changed by varying the opening ratio of the perforated partitions 422 and 423. Mutual mixing intrusion of material gases between the film forming chambers is limited by reducing the opening ratio of the partitions so as to discontinuously vary the composition of material gas depending on the film forming chamber, and the characteristics of the film to be formed can be discontinuously changed in the direction of film thickness. Material gases of respective film forming chambers are mutually mixed nearby the partitions by raising the opening ratio of the partitions so as to continuously change the composition of material gases of respective film forming chambers, and the characteristics of the film to be formed can be continuously changed in the direction of film thickness.

Film forming chambers 406, 407 and 408 are provided with holes at several positions of the bottom walls through which material gas introducing tubes 409, 410 and 411 connected to a material gas supply system, not shown, pressure measuring tubes 412, 413 and 414 connected to pressure gauges and bias electrodes 415, 416 and 417 connected to respective film forming chambers, not shown because of the same construction as above, are introduced for introducing material gases into respective film forming chambers, measuring the pressures and supplying a DC or RF bias power.

The film forming chambers are also provided with openings which are arranged in contact with the side wall of the film forming chamber unit corresponding to the microwave introducing windows 418, 419 and 420 connected to the microwave power supply, not shown, to supply the microwave power to respective film forming chambers.

Material gas introducing tubes 409, 410 and 411 are provided with a plurality of nozzles in the widthwise direction of the strip type substrate so as to uniformly introduce material gas in the widthwise direction of the strip type substrate, the bias electrodes 415, 416 and 417 are provided with the connections at the coaxial structure parts in the vacuum container and extended in the widthwise direction of the strip type substrate in front of the centers of the microwave introducing windows in the film forming chambers. These bias electrodes can be divided into the T-shaped electrode parts made of metals such as SUS and Ni and the conductor parts connected to the current introducing terminals of the wall of the vacuum container.

Each film forming chamber is partitioned with perforated metal partitions 421, 422, 423 and 424 and the gas in the film forming chamber is discharged out of the film forming chamber unit 405 through small holes provided almost over the whole surface of each perforated partition and further discharged together with the gate gas flowing from gas gates 403 and 404 from the evacuation pipes 425 and 426, which are connected to high vacuum pumps, not shown, through the gate valves, to the outside of the vacuum container 402. The vacuum container 402 is provided with the evacuation pipe 427 for rough evacuation connected to low vacuum pumps other than evacuation pipes 425 and 426.

Holes of perforated metal partitions 421, 422, 423 and 424 are provided almost over the whole surfaces to be as small as enough to prevent the microwave to be introduced into the film forming chambers from transmitting therethrough and to be as large as enough to admit the gas and a particle receiving plate 428 is provided outside the perforated partitions to catch silicon particles and film flakes which are produced in the film forming chambers and ejected from the holes of the perforated partitions to prevent dropping into evacuation pipes 425 and 408.

In addition, a plasma leakage guard 429 is arranged at the inlet, the outlet and both end parts of the strip type substrate 401 of the film forming chamber unit 405 to prevent leakage of the plasma in the film forming chambers to the outside. The thickness of the semiconductor film to be formed in the film forming chambers 406 and 408 can be adjusted by adjusting the length of part of the plasma leakage guard 429 above the film forming chambers 406 and 408 in the direction of movement of the strip type substrate.

The film forming chamber unit 405 is arranged to be mountable on the film forming chamber temperature control unit 430 so as to be temperature-controlled by heating and cooling. In stead of baking the strip type substrate by heating the film forming chamber unit 405 before formation of the film, the change of the wall temperature of the film forming chamber can be limited or controlled by cooling or heating with the film forming chamber temperature control unit 430 during formation of the film.

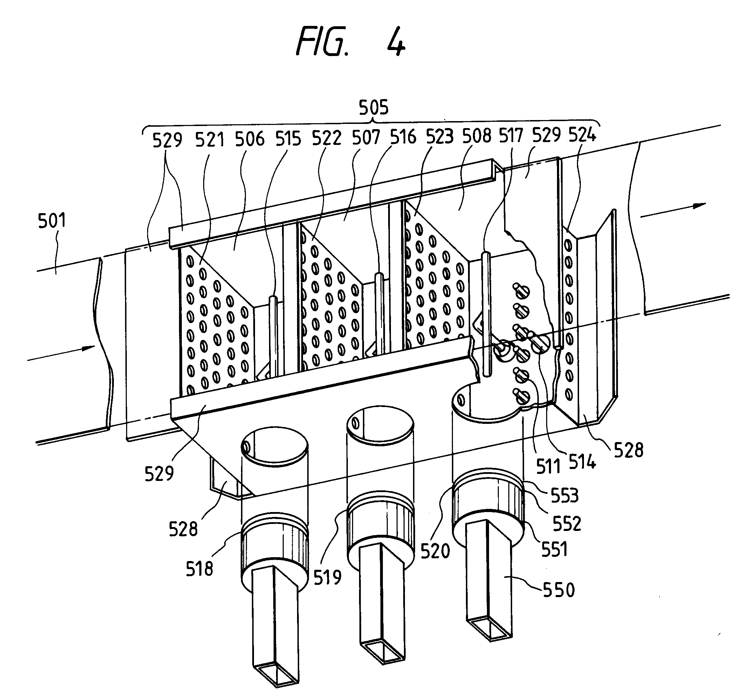

Fig. 4 is a schematic diagram showing a perspective view of the film forming chamber unit shown in Fig. 3.

In Fig. 4, the strip type substrate and the film forming chamber unit are partly cut away and the microwave introducing windows are slightly shifted from the original positions to more explicitly observe the internal constructions. 501 to 529 in Fig. 4 correspond to 401 to 429 in Fig. 3 and are identical to the latter.

As known from Figs. 3 and 4, when the strip type substrate is fed through the film forming chambers, the film forming chambers can be taken out upwardly from the vacuum container by opening the upper cover 431 of the vacuum container and disconnecting the electrode parts of the bias electrodes in the film forming chambers. When a large amount of silicon layer is deposited on the internal walls of the film forming chambers, the film forming chambers can be removed from the vacuum container and easily cleaned chemical or physical means such as etching or blasting treatment.

[Microwave Introducing Window]

In the film forming chamber which depends on the microwave plasma CVD method shown in Figs. 3 and 4, the microwave introducing windows for introducing the microwaves into the film forming chambers are means for efficiently introducing the microwave power supplied from the microwave power supply, not shown, to the waveguide through the isolator, the power monitor and the matching unit into respective film forming chambers, as shown in Fig. 4.

A continuous microwave power of 2.45GHz supplied through the square waveguide 550 is converted from square $TE_{10}$ mode to circular $TE_{11}$ mode by a cavity resonator type mode converter 551 and introduced into the pressure-reduced film forming chambers through the microwave introducing windows 518, 519 and 520 onto which alumina ceramics discs 552 and 553 with a thickness as thick as 1/2 and 1/4 of the wavelength of microwave are stacked.

Air tightness of the film forming chamber is maintained by the disc 552 of thickness as thick as 1/2 of wavelength at the mode converter side of two stacked alumina ceramics discs and the periphery of the film forming chamber is water-cooled and the air side is forcibly air-cooled by the Vortex cooler (trademark). A small columnar disc made of alumina ceramics, not shown, is adhered to two positions of the air side surface of the disc 552 as thick as 1/2 of the wavelength to carry out matching to raising the efficiency of introduction of the microwave power into the film forming chambers. When a large amount of silicon film is deposited on the film forming chamber side surface of the disc 553 as thick as 1/4 of wavelength, only the disc as thick as 1/4 of wavelength can be taken out and easily cleaned by etching treatment, blasting treatment or a similar treatment.

[Strip Type Substrate Temperature Control Mechanism]

In the film forming chamber which depends on the microwave plasma CVD method show in Fig. 3, a lamp heater 432 and substrate temperature control units 433, 434 and 435, which are fixed to an openable cover 431 of the vacuum container 402, are provided on the upper (rear-side) surface of the strip type substrate 401 in the vacuum container 402 to temperature-control the strip type substrate 401 to a specified temperature from the rear side while measuring the temperature by thin sheet type thermocouples 436, 437, 438 and 439 which are kept in face contact with the rear surface of the strip type substrate and has a small capacity and a large contact area.

Though the temperature of the strip type substrate 401 is lowered when it passes through the gas gate 403, the strip type substrate 401 is heated to a specified temperature suited to film formation by the lamp heater 432 arranged in front of the discharging chamber 406 until it reaches the discharging chamber 406, and the temperature of the strip type substrate 401 is adjusted to a fixed degree during formation of stacking films by the substrate temperature control units 433, 434 and 435 provided on the discharging chambers 406, 407 and 408.

The construction of the lamp heater 432 is such that a plurality of bar type infrared lamps as long as enough to uniformly heat the width of the strip type substrate are arranged in a direction normal to the moving direction of the strip type substrate, and a dual construction reflector 440 is provided to collect the light radiated from the lamps to the strip type substrate side to raise the heating efficiency and simultaneously prevent the cover 431 of the vacuum container from being heated. A wiring cover, not shown, is provided for wires for supplying power to the lamp heater 432 to prevent sparking and leakage on and from wires due to a leaking plasma from the discharging unit 405.

Temperature control units 433, 434 and 435 on the discharging chambers are used to control the temperature of the strip type substrate on which a film is being formed, and the temperature of the strip type substrate heated to a specified temperature by the lamp heater 432 is controlled so that it is varied by cooling with the material gas introduced into the film forming chamber or heating with a high energy plasma and maintained at a specified level while the film is being formed.

[Strip Type Substrate Support Mechanism]

In the film forming chamber which depends on the microwave plasma CVD method shown in Fig. 3, support rollers 441 which rotate and support the rear surface of the strip type substrate are provided at several positions at the side facing the upper surface (rear surface) of the strip type substrate 401 in the vacuum container 402 so that the strip type substrate 401 is straightly tensioned in the vacuum container 402.

A permanent magnet, not shown, which has a high Curie point and generates a magnetic force as large as not to affect the plasma is incorporated in the support roller 441 to make the support roller and the strip type substrate closely contact each other when a strip type substrate made of a magnetic material such as ferrite-based stainless steel is used.

The surface of the support roller 441 is formed with a conductive material such as stainless steel and electrically grounded to ground the conductive strip type substrate 401.

## Film Forming Chamber by the RF Plasma CVD Method

In the apparatus using the cells according to the present invention, the film forming chamber which depends on the RF plasma CVD method is for continuously forming a silicon-based amorphous semiconductor on the strip type substrate, which is continuously moved, by the RF plasma CVD method.

In the present invention, the film forming chamber which depends on the RF plasma CVD method is arranged to form the impurity-doped layers except the impurity-doped layer located nearest the incident light side and the i-type semiconductor layer nearest the incident light side and preferably further arranged as the film forming chamber for forming an extremely thin i-type semiconductor layer by the RF plasma CVD method between the film forming chamber for forming the impurity-doped layer and the film forming chamber for forming the i-type semiconductor layer by the microwave plasma CVD method.

For fabrication of the photovoltaic cell, the plasma formed by the microwave plasma CVD method for forming the i-type semiconductor layer provides a high energy and therefore the impurity-doped layer below the i-type semiconductor layer may be slightly sputter-etched, depending on the discharging conditions, when formation of the i-type semiconductor layer is started.

If the impurity-doped layer is sputter-etched when the i-type semiconductor layer is formed, impurities are doped into the i-type semiconductor layer and the characteristics of the i-type semiconductor layer are changed to cause variations in the characteristics of the photovoltaic cell. To prevent such sputter etching of the impurity-doped layer caused by the microwave plasma, it is preferable to further arrange a film forming chamber for forming the i-type semiconductor layer with a low energy plasma formed by the RF plasma CVD method between the impurity-doped layer below the i-type semiconductor layer and the i-type semiconductor layer formed by the microwave plasma CVD method to form a thin i-type semiconductor layer on the impurity-doped layer by the RF plasma CVD method so that the impurity-doped layer may not be directly exposed to the microwave plasma.

Though a reason has not yet been clarified, the present inventors have ascertained that the characteristics of the photovoltaic cell to be fabricated can be improved by inserting an extremely thin i-type semiconductor layer of approximately 10 to 20nm formed by the RF plasma CVD method between the i-type semiconductor layer and the impurity-doped layer to be formed thereon. Accordingly, it is preferable to further arrange a film forming chamber for forming the i-type semiconductor layer by the RF plasma CVD method between the film forming chamber for forming the i-type semiconductor layer by the microwave plasma CVD method and the film forming chamber for forming the impurity-doped layer by the RF plasma CVD method to form an extremely thin i-type semiconductor layer by the RF plasma CVD method between the i-type semiconductor layer formed by the microwave CVD method and the impurity-doped layer to be formed thereon.

In the apparatus according to the present invention, a plurality of film forming chambers which depend on the RF plasma CVD method can be provided as being connected to meet higher moving speeds of the strip type substrate or form one layer under a plurality of film forming conditions without expanding the dimensions of each film forming chamber.

In the apparatus according to the present invention, a capacity coupling system which uses discharging electrodes and an induction coupling system which uses RF coils are available as a system for introducing an RF power into the film forming chambers which depend on the RF plasma CVD method. Preferably, a capacity coupling system which uses parallel flat plate electrodes is employed.

In the apparatus according to the present invention, it is preferable to provide temperature control means in the film forming chamber which depends on the RF plasma CVD method to control the strip type substrate on which semiconductor layers are formed while being moved in the film forming chamber to a temperature suitable for forming the semiconductor layers.

To maintain the temperature of the strip type substrate at a fixed temperature when the semiconductor film is to be formed, it is preferable to provide temperature control means capable of heating the strip type substrate to a temperature suitable for forming the semiconductor layer before the strip type substrate i fed into the plasma forming space and maintaining the temperature thereof in the plasma forming space.

Temperature control during formation of the film is preferably carried out from the rear side of the strip type substrate since a semiconductor layer is formed on the surface thereof in the film forming chamber.

Since the strip type substrate is continuously moved in the film forming chamber, it is preferable for heating the strip type substrate to use radiation type heating means such as, for example, a lamp heater capable of non-contact heating and for measuring the temperature of the strip type substrate to use such temperature measuring means as a moving surface thermometer, which is capable of measuring the surface temperature of a moving object and employs a thermocouple with small thermal capacity and quick responding speed, or a radiation thermometer which permits non-contact measurement.

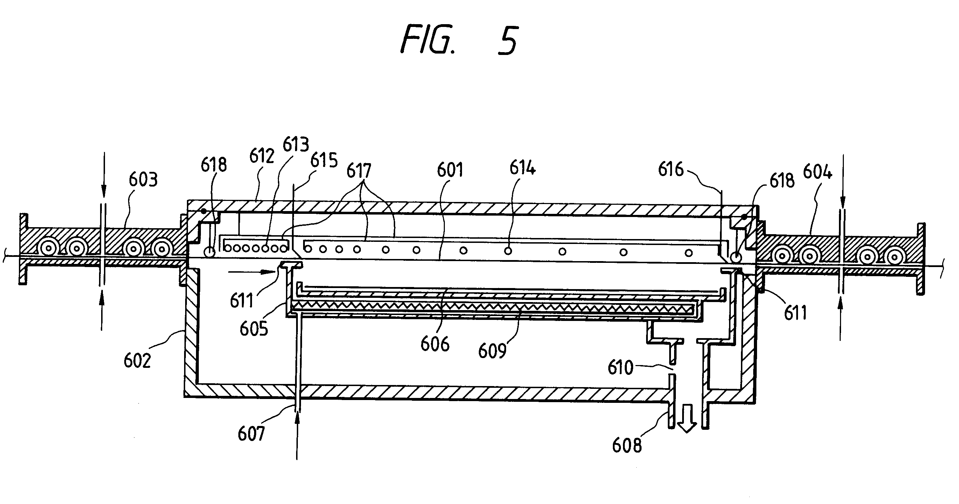

Fig. 5 is a schematic cross sectional view of the film forming chamber which depends on the RF plasma CVD method in the apparatus according to the present invention.

[Discharging Chamber]

In Fig. 5, the strip type substrate 601 enters into the vacuum container through the gas gate 603, moves from left to right in the diagram and exits to the gas gate 604.

A discharging chamber 605 is provided in the vacuum container 602 to form a plasma in the discharging chamber 605 by introducing RF power from the RF power supply, not shown, between the strip type substrate which is electrically grounded and the discharging electrode and a silicon-based amorphous semiconductor is formed on the lower surface (upper surface) of the strip type substrate. In the discharging chamber 605, a material gas introducing pipe 607 connected to a material gas supply system, not shown, and an exhaust pipe 608 connected to the discharging unit, not shown, are provided to form a gas flow parallel to the moving direction of the strip type substrate.

A block heater 609 is provided in a flow passage for material gas to preheat the material gas before decomposition by the plasma and heat the discharging chamber 605 in order to promote decomposition of the material gas around the blow-out portion and reduce adhesion of polysilane particles to the internal wall of the discharging chamber 605. A discharging chamber outlet port 610 is provided in a discharging gas exit passage so that external gases (a gate gas flowing from the gas gate, a discharged gas from the internal wall of the vacuum container 602, etc.) of the discharging chamber 605 are discharged to the exhaust pipe 608 without passing through the discharging chamber 605 to prevent intrusion of impurities into the stacking films.

A plasma leakage guard 611 is provided at the inlet and outlet ports for the strip type substrate 601 at the upper part of the discharging chamber 605 and both ends in the widthwise direction to prevent leakage of the plasma from the discharging chamber 605.

[Temperature Control Mechanism for Strip Type Substrate]

In the film forming chamber which depends on the RF plasma CVD method shown in Fig. 5, lamp heaters 613 and 614, which are fixed to the openable cover 612 of the vacuum container 602, are provided at the upper surface (rear surface) side of the strip type substrate 601 in the vacuum container 602 to heat the strip type substrate 601 from its rear side to a specified temperature while monitoring the temperature of the substrate by the thermocouples 615, 616 which are kept in contact with the rear surface of the strip type substrate. Though the temperature of the strip type substrate 601 is lowered when it passes through the gas gate 603, the strip type substrate 601 is heated to a specified temperature suitable for formation of the film by the lamp heater 613 provided ahead the discharging chamber 605 until the strip type substrate reaches the discharging chamber 605 and the temperature thereof is maintained at a fixed level by the lamp heater 614 provided on the discharging chamber 605 while the stacking films are being formed.

The construction of the lamp heaters 613, 614 is such that a plurality of bar type infrared lamps as long as enough to uniformly heat the width of the strip type substrate are arranged in a direction normal to the moving direction of the strip type substrate and the intervals of the lamps are adjusted so that these lamps located before the discharging chamber 605 are arranged in a high density and those located after the discharging chamber 605 are arranged in a more coarse density as located away from the discharging chamber 605. The lamp heaters 613, 614 are respectively provided with a dual construction reflector 617 which collects the light radiated from the lamps onto the strip type substrate to raise the heating efficiency and simultaneously prevent the cover 612 of the vacuum container from being heated. In addition, a wiring cover, not shown, is provided for wires for supplying power to the lamp heaters 613, 614 to prevent sparking on and leakage and from wires due to a leaking plasma from the discharging chamber 605.

[Strip Type Substrate Support Mechanism]

In the film forming chamber which depends on the RF plasma CVD method, suport rollers 618 which rotate and support the rear surface of the strip type substrate at positions near the inlet and outlet ports of the vacuum container 602 so that the strip type substrate 601 is tensioned to be straightforward in the vacuum container 602 and a fixed distance to the discharging electrode 606 is maintained.

A permanent magnet, not shown, which has a high Curie point and generates a magnetic force as large as not to affect the plasma is incorporated in the support roller 618 to make the support roller 618 and the strip type substrate 601 closely contact each other when a strip type substrate made of a magnetic material such as ferrite-based stainless steel is used.

The surface of the support roller 618 is formed with a conductive material such as stainless steel and electrically grounded to ground the conductive strip type substrate 601.

Film Forming Chamber by Plasma Doping

In the apparatus using the photovoltaic cells according to the present invention, the film forming chamber, which depends on plasma doping, refers to a film forming chamber (discharging treatment chamber) for continuously forming an impurity-doped layer by exposing the surface of an i-type semiconductor layer on the strip type substrate which is continuously moved to a glow discharging plasma of a gas containing impurity elements, and plasma doping.

A gas containing impurity elements for use in plasma doping according to the present invention may contain gases containing silicon atoms such as $SiH_4$, $Si_2H_6$ and $SiF_4$ to stabilize discharging as well as diluted gases such as hydrogen and He in addition to gases containing impurity elements such as, for example, $B_2H_6$, $BF_3$ and $PH_3$ as least as possible to form semiconductor layers with desired film thickness by stacking deposition.

The inventors have ascertained that, in plasma doping with the same discharging power, implantation depth of impurity elements is prone to be insufficient with high frequencies, by examining a distribution of impurity elements in the direction of film thickness according to SIMS.

A preferable frequency of approximately 13.56MHz or under and a more preferable frequency of 500kHz or under can be used to form an incident light side doped layer with a suitable thickness of approximately 3 to 30nm.

Discharging is prone to be unstable at low frequencies to result in uneven plasma in the discharging space and abnormal discharging such as sparking.

Though a small clearance between the discharging chamber and the substrate is required to move the substrate for the so-called roll-to-roll system, the plasma may leak from the discharging chamber through this clearance at low frequencies.

A frequency to prevent such phenomenon is preferably 1kHz or over and more preferably 5kHz or over.

For the above reasons, the frequency should be preferably 1kHz to 13.56MHz and more preferably 5kHz to 500kHz for forming the incident light side doped layer to be used in the photovoltaic cell by plasma doping.

It is known that the photovoltaic cell with satisfying characteristics can be obtained with frequencies of 1kHz to 13.56MHz by plasma doping according to the present invention, and the construction of the film forming chamber, which depends on plasma doping, can be almost same as that of the film forming chamber which depends on the RF plasma CVD method an example of which is shown in Fig. 5.

According to the present invention, a plurality of film forming chambers can be provided to meet higher speed movement of the strip type substrate or form one layer under a plurality of film forming conditions without expanding the dimensions of each film forming chamber to be larger than specified.

In the film forming chamber, which depends on plasma doping, of the apparatus according to the present invention, it is preferable to provide temperature control means for controlling the temperature of the strip type substrate on the surface of which semiconductor layers are formed while being moved in the film forming chambers to a temperature suitable for forming the semiconductor layers or heat-backing the interiors of the film forming chambers.

Semiconductor layers are formed on the surface of the strip type substrate in the film forming chambers and therefore it is preferable to control the temperature of the strip type substrate from its rear side during formation of the films thereon.

Since the strip type substrate is continuously moved in the film forming chambers, it is preferable for heating the strip type substrate to use radiation type heater means such as a lamp heater capable of non-contact heating and for measuring the temperature of the strip type substrate to use temperature measuring means such as a moving surface temperature thermometer which employs quick responsive thermocouples capable of measuring a surface temperature of a moving object or a radiation thermometer capable of non-contact measurement.

[Strip Type Substrate Unwinding Chamber]

A strip type substrate unwinding chamber in the present invention refers to a vacuum container which accommodates the strip type substrate before formation of films thereon and continuously feeds the strip type substrate into the film forming chamber.

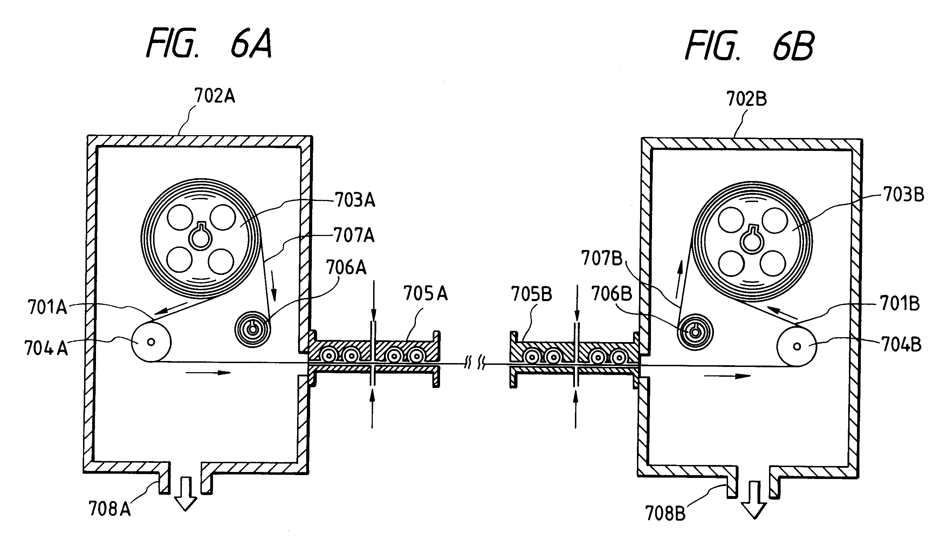

Fig. 6A is a schematic cross sectional view showing an example of an unwinding chamber for unwinding the strip type substrate in the apparatus according to the present invention.

In Fig. 6A, the strip type substrate 701A is wound likewise a coil around, a bobbin 703A in the vacuum container 702A, unwound from the bobbin 703A while being pulled by a takeup mechanism in a strip type substrate takeup chamber and supplied to the film forming chambers, after not shown, connected with a gas gate 705A having been made flat with its film forming surface (obverse surface) faced down by a roller 704A. A tension adjusting mechanism, not shown, for applying a fixed tension to the strip type substrate 701A is connected to the bobbin 703A to tension the strip type substrate and prevent it from being slackened. A film takeup bobbin 706A is connected to a takeup mechanism, not shown, and takes up a thin soft protection film 707A, which is made of resin-based sheet using polyethylene, polyethylene terephthalate, polyimide or polyamide, unwoven cloth, paper or one of these materials to which a metal such as Al is thinly deposited, together with the strip type substrate as the strip type substrate is unwound to protect the strip type substrate from frictional damage of its both surfaces. In addition, the roller 704A is provided with a steering mechanism, not shown, and adapted to slightly change the forwarding direction of the strip type substrate by slightly changing the direction of the rotation axis of the roller 704A from outside the vacuum container 702A and feed the strip type substrate to a fixed position for the gas gate 705A at all times in reference to the widthwise direction of the strip type substrate even though the position of the strip type substrate wound around the bobbin 703A is uneven in the widthwise direction of the strip type substrate.

The internal gas of the vacuum container 702A is evacuated by the evacuation pipe 708A connected to the vacuum evacuation unit, not shown.

[Strip Type Substrate Takeup Chamber]

A strip type substrate takeup chamber in the present invention refers to a vacuum container for continuously taking up the strip type substrate on which the semiconductor layer films have been formed from the film forming chamber and accommodates the substrate therein.

Fig. 6B is a schematic cross sectional view showing an example of a strip type substrate unwinding chamber in the apparatus according to the present invention.

The strip type substrate takeup chamber can have the almost same configuration of components as the strip type substrate unwinding chamber but the rotational direction of the bobbin is opposite to that of the roller.

In Fig. 6B, the strip type substrate 701B after the semiconductor stacking films have been formed enters into the vacuum container 702B through the gas gate 705B and is taken up by the bobbin 703B connected to a rotary mechanism, not shown.

A film is wound on a film takeup bobbin 706B for protecting the strip type substrate from frictional damage of both surfaces thereof at the same time the strip type substrate is taken up. The film takeup bobbin 706B supplies to the bobbin 703B a thin soft protection film 703B, which is made of a resin-based sheet using polyethylene, polyethylene terephthalate, polyimide, polyamide, etc., unwoven cloth, paper or one of these material to which a metal such as Al is thinly deposited. In addition, the roller 704B is provided with a steering mechanism, not shown, and adapted to change the forwarding direction of the strip type substrate by slightly changing the direction of the rotation axis of the roller 704A from outside the vacuum container 702B and take up the strip type substrate 701B onto the bobbin 703B at a fixed position at all times in reference to the widthwise direction thereof even though the widthwise position of the strip type substrate fed through the gas gate 705B is irregular.

The evacuation pipe 708B is used to evacuate the interior of the vacuum container 702B to be vacuum and connected to a vacuum evacuation unit, not shown.

[Steering Mechanism]

A steering mechanism is described below in detail, referring to the drawings.

In the strip type substrate takeup chamber, a horizontal deviation detecting mechanism and a steering mechanism for correcting horizontal deviation are provided in the vacuum container to prevent deviation of the strip type substrate in a direction at right angles to the moving direction of the strip type substrate.

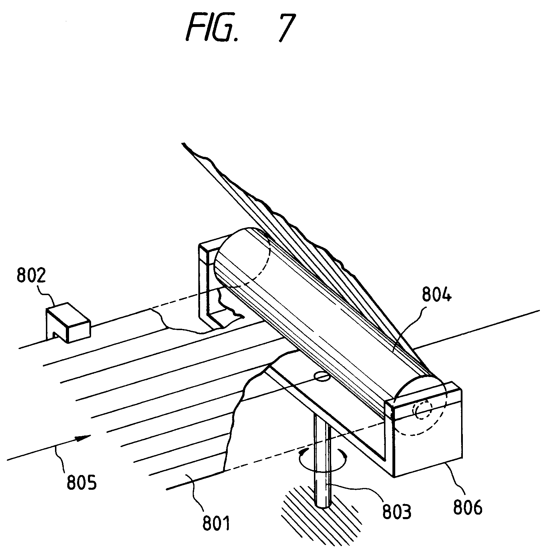

Fig. 7 is a schematic diagram for illustrating the horizontal deviation detecting mechanism and the steering mechanism. The strip type substrate is shown as a partly cutaway view for ease in understanding.

In Fig. 7, the moving direction of the strip type substrate is deflected upwardly by a roller 804. The roller 804 is connected to a rotation mechanism 803 through a bearing 806 to be rotatable around the axis which intersects the rotation axis of the roller 804, and forms the steering mechanism. The rotary shaft of this rotation mechanism 803 is extended out of the vacuum container and connected to a servo motor having a speed reducing mechanism, not shown, so that the angle of rotation can be controlled from outside the vacuum container.

Referring to Fig. 7, the stgeering mechanism is described in a case that the strip type substrate 801 is deviated to the left side of moving direction 805. The positions of the takeup bobbin, rotation mechanism 803 and the bearing 806 are adjusted so that a tension to be applied in advance to right and left rollers 804 before movement of the strip type substrate 801 is started is constant and the strip type substrate is taken up in order by the takeup bobbin. These positions should be based on the horizontal deviation of the horizontal deviation detecting mechanism = 0 and the rotation angle of the rotation mechanism = 0. When the strip type substrate 801 is moved and begins to deviate to the left, a value of horizontal deviation of the strip type substrate 801 to the left is detected. Furthermore, the rotation mechanism 803 is rotated only by a small angle in response to the above horizontal deviation so that the right side of the roller 804 can be moved in the moving direction and the left side thereof can be moved in an opposite direction to the moving direction 805 of the strip type substrate. In response to this rotation of the rotation mechanism 803, a tension applied to the strip type substrate is intensified at the right side and damped at the left side. Consequently, the strip type substrate gradually returns to the right side of the roller 804 where the tension is strong and finally returns to the original position if the rotation angle = 0 is set when the horizontal deviation = 0. When the strip type substrate is deviated to the right, the roller 804 should be rotated in an opposite direction to return the strip type substrate to the original position. This operation is automatically carried out by a feedback mechanism, not shown, which connects the steering mechanism and the horizontal deviation detecting mechanism, and the substrate is position-controlled to be within a fixed range in the widthwise direction at all times and wound around the takeup bobbin with its positions aligned in the widthwise direction.

[Gas Gate]

A gas gate according to the present invention refers to connection means arranged between the film forming chambers for moving the strip type substrate between adjacent film forming chambers and separating the material gas by connecting adjacent film forming chambers with a slit type separation passage and introducing gases such as, for example, Ar, He and $H_2$ into the separation passage to form a gas flow toward the film forming chambers.

Figs. 3, 5, 6A and 6B are respectively a schematic cross sectional view showing an example of the film forming chamber, the strip type substrate unwinding chamber, the strip type substrate takeup chamber, and gas gates for connecting these units, and the gas gates shown in Figs. 3, 5, 6A and 6B are basically the same in construction,

In Fig. 3, the gas gate 403 is provided with a slit type separation passage 442 for separating the material gas. A plurality of gas introducing ports are provided above and under the strip type substrate at a substantially central part of the separation passage 442 in the widthwise direction of the strip type substrate and gas introducing ports 443 and 444 connected to the gas supply system, not shown, to introduce the gate gas for separating the material gas from above and below the strip type substrate 401. In the separation passage 442, the strip type substrate 401 is supported at its rear side by a plurality of rotating support roller 445 so that the surface of the strip type substrate does not come in contact with the lower wall surface of the separation passage 442 and a fixed shaft clearance can be maintained.

A permanent magnet, not shown, which has a high Curie point and generates a magnetic force as large as not to affect the plasma is incorporated in the support roller 445 to make the support roller 445 and the strip type substrate 401 closely contact each other when a strip type substrate made of a magnetic material such as ferrite-based stainless steel is used.

The slit type separation passage 442 is preferably wide in the direction of the thickness of the strip type substrate and short in the moving direction thereof to prevent the semiconductor forming surface of the strip type substrate from being damaged due to contact with the lower surface of the internal wall of the separation passage resulting from undulatory movement or vibration of the strip type substrate, and narrow in the direction of the thickness of the strip type substrate and long in the moving direction thereof to prevent intrusion of the material gas between the connected film forming chambers. Accordingly, though the internal dimension of the slit type separation passage in the widthwise direction of the strip type substrate is as approximately fixed as slightly larger than the width of the strip type substrate, the internal dimension of the slit type separation passage in the direction of thickness of the strip type substrate is set to be narrower in accordance with a larger difference of pressures in the connected film forming chambers and less allowable quantities of intrusion of impurity gases. For example, the internal pressure of the i-type semiconductor layer film forming chamber which depends on the microwave CVD method is low and, in addition, allowable quantities of intrusion of impurity gases are small and therefore the internal pressure of the film forming chamber is relatively high and the internal dimension of the separation passage in the direction of thickness of the strip type substrate is made as narrow as to the gas gate for connecting the impurity-doped layer film forming chambers, which depend on the RF plasma CVD method, for introducing impurity gases is made narrow to barely admit passing of the strip type substrate in the gas gate which connects the impurity-doped film forming chambers, which depend on the RF plasma CVD method and into which impurity gases are introduced and set in a range of approximately 0.3 to 3mm. On the other hand, in the gas gate which connects the strip type substrate unwinding chamber and the strip type substrate takeup chamber where there is no substantial pressure difference and the film forming chamber which depends on the RF plasma CVD method, the internal dimension of the separation passage in the direction of thickness of the strip type substrate is set to be relatively wide in a range of approximately 1 to 5mm so that the strip type substrate can be easily moved.

[Strip Type Substrate]

Materials of the strip type substrate which is appropriately used in the apparatus according to the present invention are preferably free from deformation and strain at a temperature required for forming a semiconductor layer and has a desired strength and conductivity. Specifically, those materials which can be enumerated include sheets of metals such as stainless steel, aluminum and its alloys, iron and its alloys and copper and its alloys and composites of these metals, and materials made up by coating the surfaces of these metallic materials with different kinds of thin metal films and/or insulation thin films such as $SiO_2$, $Si_3N_4$, $Al_2O_3$ and AlN by a sputtering, depositing or plating method, and materials made up by treating for conductivity the surfaces of heat-resistant resin-based sheets such as polyimide, polyamide, polyethylene terephthalate and epoxy and the composites with glass fiber, carbon fiber, boron fiber and metal fibers with a single metal, and a transparent conductive oxide (TCO) by plating, deposition, sputtering and application.

Even though the strip type substrate is conductive as a metal, a different kind of metal layer can be formed on the semiconductor forming surface for such objects as improvement of the reflection factor of long wave light which reaches the substrate, prevention of counter diffusion of the substrate material and the semiconductor layer, improvement of adhesion and smoothing of the substrate surface.

In case of providing a metal layer as a light reflection layer, metals such as Ag, Al, Cu and AlSi whose reflection factors with a visible light to near infrared ray are high suitable for the light reflection layer.

A transparent conductive layer can be provided on these metal layers to prevent diffusion of metals from the metal layers to the semiconductor layers and raise the optical reflection power.

Transparent conductive oxides such as ZnO, $SnO_2$, $In_2O_3$, and ITO are best suited for such transparent conductive layers.

The surface of the strip type substrate can be either a smoothed surface or a slightly uneven surface. In the case of the slightly uneven surface, the surface roughness is preferable free from a defect arising from the unevenness of the semiconductor layer to be formed and within a range where a length of light passage for the incident light is increased by the so-called light confining effect.

The thickness of the strip type substrate is preferably as thin as possible in view of costs and accommodation space if a strength for maintaining a flat shape of the substrate is exhibited during movement and transfer. Specifically, the thickness is preferably 0.01mm to 5mm, more preferably 0.02mm to 2mm, and optimally 0.05mm to 1mm.

The width of the strip type substrate is preferable as large as to maintain a uniformity of the plasma formed in the film forming chambers and to be suited to modularization of the photovoltaic cell to be fabricated and specifically the width of the strip type substrate is preferably 5cm to 100cm and more preferably 10cm to 80cm.

In addition, the length is not limited and the strip type substrate can be approximately as long as to be wound in a shape of roll and further extended by welding long strip type substrates.

It is preferable to introduce a strip type substrate as described above into the apparatus according to the present invention in a mode of a coil wound on a cylindrical bobbin in a diameter within a range in which the strip type substrate is not deformed due to plasticization.

[Examples of the Apparatus]

Examples of the apparatus according to the present invention, each comprising the above-described film forming chambers are described referring to the drawings. However, the present invention is not limited to these examples.

An example of a 2-layer tandem type photovoltaic cell is described.

Apparatus Example 1-1

Fig. 1 is a schematic illustration showing a basic example of an apparatus for fabricating a photovoltaic cell according to the present invention. In Fig. 1, the photovoltaic cell fabricating apparatus according to the present invention comprises a strip type substrate unwinding chamber 101, an n(or p)-type semiconductor layer film forming chamber 102 which depends on an RF plasma CVD method, an i-type semiconductor layer film forming chamber 103 which depends on a microwave plasma CVD method, a p(or n)-type semiconductor layer film forming chamber 105A which depends on the RF plasma CVD method, an n(or p)-type semiconductor layer film forming chamber 102B which depends on the RF plasma CVD method, an i-type semiconductor layer film forming chamber 104 which depends on the RF plasma CVD method, a p(or n)-type semiconductor layer film forming chamber 105B which depends on plasma doping, and a strip type substrate takeup chamber 106.

A series of film forming chambers are arranged in a convexed profile toward the direction of gravity such as a catenary curve or an arc along a shape of the strip type substrate which may droop its own weight. The strip type substrate is tensioned without slackness by a small tensile force and maintained in a fixed shape during film formation, and a stress to be applied to the semiconductor films formed on the strip type substrate is reduced when the strip type substrate is moved to prevent defects of the film from being caused due to deformation and stress of the substrate.

In the apparatus shown in Fig. 1, the strip type substrate 108 is unwound from a bobbin 109 of the strip type substrate unwinding chamber 101 and moved to pass through six film forming chambers which are connected by gas gates 107, and amorphous semiconductor stacking films of an n-i-p-n-i-p or p-i-n-p-i-n structure are continuously formed on the surface of the strip type substrate.

The strip type substrate 108 supplied from the strip type substrate unwinding chamber 101 is treated through the gas gates in the following manner:

(1) the substrate is first introduced into the n(or p)-type semiconductor layer forming chamber 102A which depends on the RF plasma CVD method and the n(or p)-type silicon-based amorphous semiconductor layer is formed thereon by the RF plasma CVD method;

(2) the substrate is then fed into the n(or p)-type semiconductor layer forming chamber 103 which depends on the microwave plasma CVD method and the i-type silicon-based amorphous semiconductor layer is further formed and stacked by the microwave plasma CVD method;

(3) the substrate is next fed into the p(or n)-type semiconductor layer forming chamber 105A which depends on the RF plasma CVD method and the p(or n)-type silicon-based amorphous semiconductor is further formed and stacked thereon by the RF plasma CVD method;

(4) the substrate is subsequently fed into the n(or p)-type semiconductor layer forming chamber 102B which depends on the RF plasma CVD method and the n(or p)-type silicon-based amorphous semiconductor layer is further formed and stacked thereon;

(5) the substrate is fed into the i-type semiconductor layer forming chamber 104 which depends on the RF polasma CVD method and the i-type silicon-based amorphous semiconductor layer is further formed and stacked thereon; and

(6) subsequently the substrate is fed into the p(or n)-type semiconductor layer forming chamber 105B which depends on plasma doping and the p(or n)-type silicon-based amorphous semiconductor layer is further formed and stacked thereon.

Finally, the strip type substrate is taken up by the takeup chamber 106.

Apparatus Example 1-2

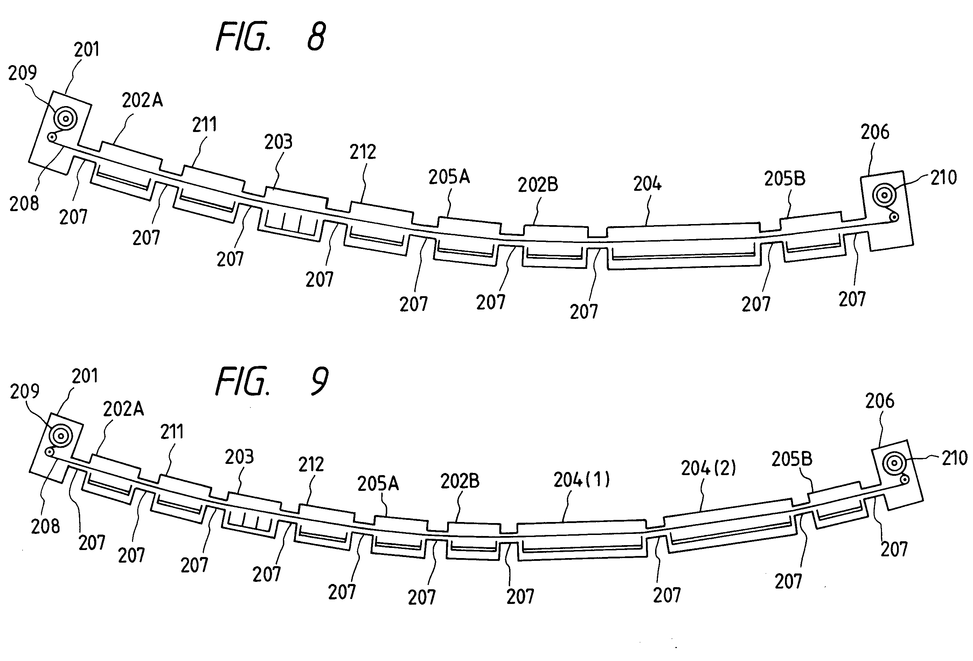

Fig. 8 is a schematic illustration showing another example of a continuous forming apparatus for semiconductor stacking films according to the present invention.

In Fig. 8, the continuous forming apparatus for semiconductor films according to the present invention comprises a strip type substrate unwinding chamber 201, an n(or p)-type semiconductor layer film forming chamber 202A which depends on the RF plasma CVD method, an extremely thin i-type semiconductor layer film forming chamber 211 which depends on the RF plasma CVD method, an i-type semiconductor layer film forming chamber 203 which depends on the microwave plasma CVD method, an extremely thin i-type semiconductor layer film forming chamber 212 which depends on the RF plasma CVD method, a p(or n)-type semiconductor layer film forming chamber 205A which depends on the RF plasma CVD method, an n(or p)-type semiconductor layer film forming chamber 202B which depends on the RF plasma CVD method, a p(or n)-type semiconductor layer film forming chamber 205B which depends on plasma doping, and a strip type substrate takeup chamber 206.

A series of film forming chambers are arranged in a convexed shape toward the direction of gravity as a catenary curve or an arc along a profile of the strip type substrate formed by drooping due to its own weight, the strip type substrate is tensioned without any slackness by a slight tensile force and maintained in a given profile during film formation, a stress to be applied to the strip type substrate and semiconductor films formed thereon is reduced when the strip type substrate is moved, and defects of the films due to deformation and stress of the substrate are prevented.

In the apparatus in Fig. 8, the strip type substrate 208 is unwound from the bobbin 209 in the strip type substrate unwinding chamber 201, moved to pass through eight film forming chambers which are connected by gas gates 207 until the strip type substrate is taken up by the bobbin 219 of the strip type substrate takeup chamber 206, and amorphous semiconductor stacking films of an n-i-p-n-i-p or p-in-p-i-n structure is continuously formed on the surface of the strip type substrate.

The strip type substrate 208 supplied from the strip type substrate unwinding chamber 201 is treated as described below through the gas gates:

(1) the substrate is first entered into the n(or p)-type semiconductor layer forming chamber 202A which depends on the RF plasma CVD method and a silicon-based amorphous semiconductor layer is formed on the surface thereof by the RF plasma CVD method;

(2) the substrate is then fed into the i-type semiconductor layer forming chamber 211 which depends on the RF plasma CVD method and an extremely thin i-type silicon-based amorphous semiconductor layer is further formed and stacked thereon by the RF plasma CVD method;

(3) the substrate is next fed into the i-type semiconductor layer forming chamber 203 which depends on the microwave plasma CVD method and an i-type silicon-based semiconductor layer is further formed and stacked thereon by the microwave plasma CVD method;

(4) the substrate is next fed into the i-type semiconductor layer forming chamber 212 which depends on the RF plasma CVD method and an extremely thin i-type silicon-based semiconductor layer is further formed and stacked thereon by the RF plasma CVD method;

(5) the substrate is subsequently fed into the p(or n)-type semiconductor layer forming chamber 205A which depends on the RF plasma CVD method and a p(or n)-type silicon-based amorphous semiconductor layer is further formed and stacked thereon by the RF plasma CVD method;

(6) the substrate is subsequently fed into the n(or p)-type semiconductor layer forming chamber 202B which depends on the RF plasma CVD method and an n(or p)-type silicon-based amorphous semiconductor layer is further formed and stacked thereon by the RF plasma CVD method;

(7) the substrate is subsequently fed into the i-type semiconductor layer forming chamber 204 which depends on the RF plasma CVD method and an i-type silicon-based amorphous semiconductor layer is further formed and stacked thereon by the RF plasma CVD method;

(8) the substrate is subsequently fed into the p(or n)-type semiconductor layer forming chamber 205B which depends on plasma doping and a p(or n)-type silicon-based amorphous semiconductor layer is formed on the i-type layer by the plasma doping method; and

the substrate is finally taken up by the strip type substrate takeup chamber 206.

## Apparatus Example 1-3

An apparatus from which the i-type semiconductor layer forming chamber 211, which depends on the RF plasma CVD method, shown in Fig. 8 and the gas gate to be connected to the chamber 211 are removed can be shown as an example of the apparatus according to the present invention.

In this case, all other than that the extremely thin semiconductor layer by the RF plasma CVD method is not formed under the i-type semiconductor layer to be formed by the microwave CVD method are the same as in the apparatus example 2.

## Apparatus Example 1-4

An apparatus from which the i-type semiconductor layer forming chamber 212, which depends on the RF plasma CVD method, shown in Fig. 8, and the gas gate to be connected to the chamber 212 are removed can be shown as an example of the apparatus according to the present invention.

In this case, all other than only the extremely thin i-type semiconductor layer which depends on the RF plasma CVD method are the same as in the apparatus example 2.

Apparatus Example 1-5

Fig. 9 is a schematic illustration showing an example of the photovoltaic cell fabrication apparatus according to the present invention. The apparatus shown in Fig. 9 is additionally provided with the i-type semiconductor layer forming chambers 204(1) and 204(2) which depend on the RF plasma CVD method instead of the same chamber 204 and the construction thereof is the same as the apparatus example 2-2 except that the i-type semiconductor layer at the incident light side to be formed by the RF plasma CVD method is formed in a plurality of semiconductor layer forming chambers.

A 3-layer tandem type photovoltaic cell fabrication apparatus is described below.

Apparatus Example 2-1

Fig. 2 is a schematic illustration showing a basic example of a photovoltaic cell fabrication apparatus according to the present invention. In Fig. 2, the photovoltaic cell fabrication apparatus according to the present invention comprises a strip type substrate unwinding chamber 101, an n(or p)-type semiconductor layer film forming chamber 102A which depends on an RF plasma CVD method, an i-type semiconductor layer film forming chamber 103A which depends on a microwave plasma CVD method, a p(or n)-type semiconductor layer film forming chamber 105A which depends on the RF plasma CVD method, an n(or p)-type semiconductor layer film forming chamber 102B which depends on the RF plasma CVD method, an i-type semiconductor layer film forming chamber 103B which depends on the microwave plasma CVD method, a p(or n)-type semiconductor layer film forming chamber 105B which depends on the RF plasma CVD method, an n(or p)-type semiconductor layer film forming chamber 102C which depends on the RF plasma CVD method, an i-type semiconductor layer film forming chamber 104 which depends on the RF plasma CVD method, a p(or n)-type semiconductor layer film forming chamber 105C which depends on plasma doping, and a strip type substrate takeup chamber 106.

A series of film forming chambers are arranged in a concaved shape toward the direction of gravity as a catenary curve or an arc along a profile of the strip type substrate formed with drooling due to its own weight, the strip type substrate is tensioned without any slackness by a slight tensile force and maintained in a given profile during film formation, a stress to be applied to the strip type substrate and semiconductor films formed thereon is reduced when the strip type substrate is moved, and defects of the films due to deformation and stress of the substrate are prevented.

In the apparatus shown in Fig. 2, the strip type substrate 108 is unwound from the bobbin 109 in the strip type substrate unwinding chamber 101, moved to pass through nine film forming chambers which are connected by gas gates 107, respectively, until the strip type substrate is taken up by the bobbin 110 of the strip type substrate takeup chamber 106, and amorphous semiconductor stacking films of an n-i-p-n-i-p or p-i-n-p-i-n structure is continuously formed on the surface of the strip type substrate.

The strip type substrate 108 supplied from the strip type substrate unwinding chamber 101 is treated as described below through the gas gates:

(1) the substrate is first entered into the n(or p)-type semiconductor layer forming chamber 102A which depends on the RF plasma CVD method and a silicon-based amorphous semiconductor layer is formed on the surface thereof by the RF plasma CVD method;

(2) subsequently, the substrate is fed into the i-type semiconductor layer forming chamber 103A which depends on the RF plasma CVD method and an extremely thin i-type silicon-based amorphous semiconductor layer is further formed and stacked thereon by the RF plasma CVD method;

(3) subsequently, the substrate is fed into the p(or n)-type semiconductor layer forming chamber 105A which depends on the RF plasma CVD method and a p(or n)-type silicon-based amorphous semiconductor layer is further formed and stacked thereon by the RF plasma CVD method;

(4) subsequently, the substrate is fed into the n(or p)-type semiconductor layer forming chamber 102B which depends on the RF plasma CVD method and an n(or p)-type silicon-based amorphous semiconductor layer is further formed and stacked thereon by the RF plasma CVD method;

(5) subsequently, the substrate is fed into the i-type semiconductor layer forming chamber 103B which depends on the microwave plasma CVD method and an i-type silicon-based amorphous semiconductor layer is further formed and stacked thereon by the microwave plasma CVD method;

(6) subsequently, the substrate is fed into the p(or n)-type semiconductor layer forming chamber 105B which depends on the RF plasma CVD method and a p(or n)-type silicon-based amorphous semiconductor layer is formed on the surface thereof by the RF plasma CVD method;

(7) subsequently, the substrate is fed into the p(or n)-type semiconductor layer forming chamber 102C which depends on the RF plasma CVD method and a p(or n)-type silicon-based amorphous semiconductor layer is formed on the surface thereof by the RF plasma CVD method;

(8) subsequently, the substrate is fed into the i-type semiconductor layer forming chamber 104 which depends on the microwave plasma CVD method and an i-type silicon-based amorphous semiconductor layer is further formed and stacked thereon by the microwave plasma CVD method;

(9) subsequently, the substrate is fed into the p(or n) type semiconductor layer forming chamber 105 and the p(or n)-type silicon-based amorphous semiconductor layer is formed thereon by plasma doping; and finally, the substrate is taken up by the strip type substrate takeup chamber 106.

## Apparatus Example 2-2

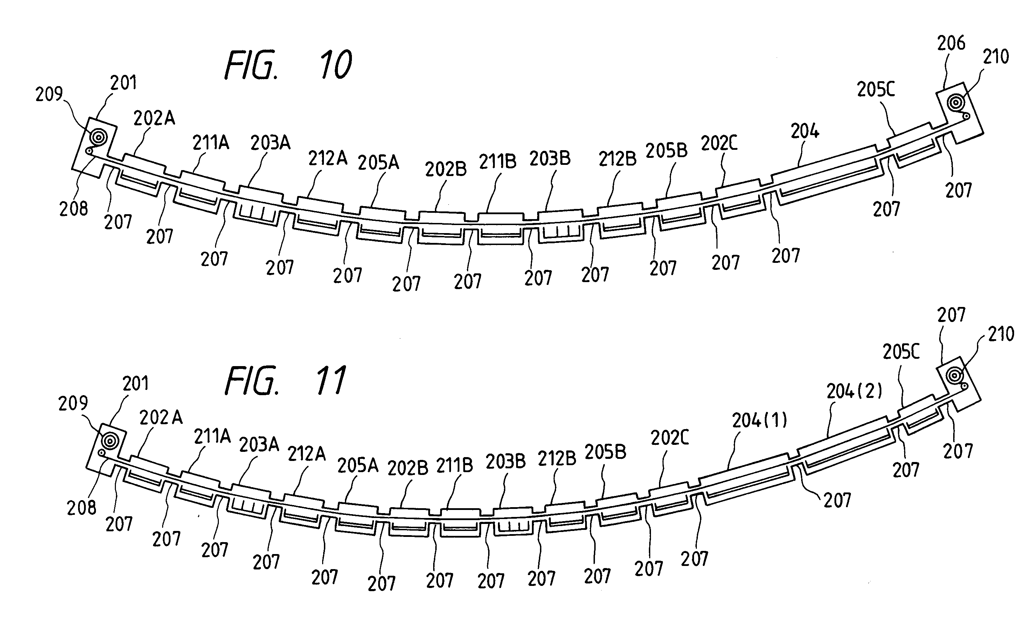

Fig. 10 is a schematic illustration showing another example of the continuous forming apparatus for semiconductor layer stacking films according to the present invention.

In Fig. 10, the continuous forming apparatus for semiconductor films according to the present invention comprises a strip type substrate unwinding chamber 101, an n(or p)-type semiconductor layer film forming chamber 202A which depends on an RF plasma CVD method, an extremely thin i-type semiconductor layer film forming chamber 211A which depends on the RF plasma CVD method, an i-type semiconductor layer film forming chamber 203A which depends on a microwave plasma CVD method, an extremely thin i-type semiconductor layer film forming chamber 212A which depends on the RF plasma CVD method, a p(or n)-type semiconductor layer film forming chamber 205A which depends on the RF plasma CVD method, an n(or p)-type semiconductor layer film forming chamber 202B which depends on the RF plasma CVD method, an extremely thin i-type semiconductor layer film forming chamber 211B which depends on the RF plasma CVD method, an i-type semiconductor layer film forming chamber 203B which depends on the microwave plasma CVD method, an extremely thin i-type semiconductor layer film forming chamber 212B which depends on the RF plasma CVD method, a p(or n)-type semiconductor layer film forming chamber 205B which depends on the RF plasma CVD method, an n(or p)-type semiconductor layer film forming chamber 202C which depends on the RF plasma CVD method, an i-type semiconductor layer film forming chamber 204 which depends on the RF plasma CVD method, a p(or n)-type semiconductor layer film forming chamber 205C which depends on plasma doping, and a strip type substrate takeup chamber 206.

A series of film forming chambers are arranged in a concaved shape toward the direction of gravity as a catenary curve or an arc along a profile of the strip type substrate formed with drooling due to its own weight, the strip type substrate is tensioned without any slackness by a slight tensile force and maintained in a given profile during film formation, a stress to be applied to the strip type substrate and semiconductor films formed thereon is reduced when the strip type substrate is moved, and defects of the films due to deformation and stress of the substrate are prevented.

In the apparatus shown in Fig. 2, the strip type substrate 208 is unwound from the bobbin 209 in the strip type substrate unwinding chamber 201, moved to pass through thirteen film forming chambers which are connected by gas gates 207, respectively, until the strip type substrate is taken up by the bobbin 210 of the strip type substrate takeup chamber 106, and amorphous semiconductor stacking films of an n-i-p-n-i-p or p-i-n-p-i-n structure is continuously formed on the surface of the strip type substrate.

The strip type substrate 208 supplied from the strip type substrate unwinding chamber 201 is treated as described below through the gas gates:

(1) the substrate is first entered into the n(or p)-type semiconductor layer forming chamber 202A which depends on the RF plasma CVD method and a silicon-based amorphous semiconductor layer is formed on the surface thereof by the RF plasma CVD method;

(2) subsequently, the substrate is fed into the i-type semiconductor layer forming chamber 211A which depends on the RF plasma CVD method and an extremely thin i-type silicon-based amorphous semiconductor layer is further formed and stacked thereon by the RF plasma CVD method;

(3) subsequently, the substrate is fed into the i-type semiconductor layer forming chamber 203A which depends on the microwave plasma CVD method and an extremely thin i-type silicon-based amorphous semiconductor layer is further formed and stacked thereon by the microwave plasma CVD method;

(4) subsequently, the substrate is fed into the i-type semiconductor layer forming chamber 212A which depends on the RF plasma CVD method and an extremely thin i-type silicon-based amorphous semiconductor layer is further formed and stacked thereon by the RF plasma CVD method;

(5) subsequently, the substrate is fed into the p(or n)-type semiconductor layer forming chamber 205A which depends on the RF plasma CVD method and a p(or n)-type silicon-based amorphous semiconductor layer is further formed and stacked thereon by the RF plasma CVD method;

(6) subsequently, the substrate is fed into the n(or p)-type semiconductor layer forming chamber 202B which depends on the RF plasma CVD method and an n(or p)-type silicon-based amorphous semiconductor layer is further formed and stacked thereon by the RF plasma CVD method;

(7) subsequently, the substrate is fed into the i-type semiconductor layer forming chamber 211B which depends on the RF plasma CVD method and an extremely thin i-type silicon-based amorphous semiconductor layer is further formed and stacked thereon by the RF plasma CVD method;

(8) subsequently, the substrate is fed into the i-type semiconductor layer forming chamber 203B which depends on the microwave plasma CVD method and an i-type silicon-based amorphous semiconductor layer is further formed and stacked thereon by the microwave plasma CVD method;

(9) subsequently, the substrate is fed into the i-type semiconductor layer forming chamber 212B and an extremely thin i-type silicon-based amorphous semiconductor layer is further formed and stacked thereon by the RF plasma CVD method;

(10) subsequently, the substrate is fed into the p(or n)-type semiconductor layer forming chamber 205B which depends on the RF plasma CVD method and a p(or n)-type silicon-based amorphous semiconductor layer is formed on the surface thereof by the RF plasma CVD method;

(11) subsequently, the substrate is fed into the p(or n)-type semiconductor layer forming chamber 202C which depends on the RF plasma CVD method and a p(or n)-type silicon-based amorphous semiconductor layer is formed on the surface thereof by the RF plasma CVD method;

(12) subsequently, the substrate is fed into the i-type semiconductor layer forming chamber 204 which depends on the microwave plasma CVD method and an i-type silicon-based amorphous semiconductor layer is further formed and stacked thereon by the microwave plasma CVD method;

(13) subsequently, the substrate is fed into the p(or n) type semiconductor layer forming chamber 205C and the p(or n)-type silicon-based amorphous semiconductor layer is formed thereon by plasma doping; and

finally, the substrate is taken up by the strip type substrate takeup chamber 206.

### Apparatus Example 2-3

An apparatus from which the i-type semiconductor layer forming chamber 211A and/or 211B, which depends on the RF plasma CVD method, shown in Fig. 10 and the gas gates to be connected to the chamber 211A and/or 211B are removed can be shown as an example of the apparatus according to the present invention.

In this case, all other than that the extremely thin semiconductor layer is not formed by the RF plasma CVD method below at least one i-type semiconductor layer to be formed by the RF plasma CVD method is not formed are the same as in the apparatus Example 2-2.

### Apparatus Example 2-4

An apparatus from which the i-type semiconductor layer forming chamber 211A and/or 211B, which depends on the RF plasma CVD method, shown in Fig. 10 and the gas gates to be connected to the chamber 212A and/or 212B are removed can be shown as an example of the apparatus according to the present invention.

In this case, all other than that the extremely thin semiconductor layer is not formed by the RF plasma CVD method above at least one i-type semiconductor layer to be formed by the RF plasma CVD method is not formed are the same as in the apparatus Example 2-2.

### Apparatus Example 2-5

Fig. 11 is a schematic illustration showing an example of the photovoltaic cell fabrication apparatus according to the present invention. The apparatus shown in Fig. 11 is additionally provided with the i-type semiconductor layer forming chambers 204 (1) and 204 (2) which depend on the RF plasma CVD method instead of the same chamber 204 and the construction thereof is the same as the apparatus Example 2-2 except that the i-type semiconductor layer at the position nearest the incident light side to be formed by the RF plasma CVD method is formed in a plurality of semiconductor layer forming chambers.

The following describes an example method for continuously forming semiconductor stacking layers for the photovoltaic cell by using the apparatus according to the present invention.

A method for fabricating the 2-layer tandem type photovoltaic cell, referring to the apparatus of the construction shown in Fig. 1.

Strip Type Substrate Introducing Process

For forming the semiconductor stacking films by using the apparatus according to the present invention shown in Fig. 1, a strip type substrate is introduced into the apparatus and set at a specified position.

For introducing the strip type substrate into the apparatus according to the present invention, an end of the strip type substrate 108 which is wound likewise a coil around a bobbin 109 is unwound from the bobbin 109, led to pass through the film forming chambers 102A to 105B via gas gates 107, extended and fastened to an empty bobbin 110 of the strip type substrate takeup chamber 106.

A protection film for protecting the surface of the strip type substrate from damage can be wound together with the strip type substrate 108 around the bobbin 109 onto which the strip type substrate on which films are not yet formed is wound. In the case that such protection film is wound, an extreme end of this protection film is fixed to the protection film takeup bobbin in the strip type substrate unwinding chamber 101.

Similarly, the protection film for protecting the surface of the strip type substrate from damage can be taken up by the bobbin 110 which also takes up the strip type substrate. For taking up this protection film, the protection film is unwound from the protection film unwinding bobbin in the strip type substrate takeup chamber 106 and the extreme end of the protection film is overlapped with the strip type substrate 108 and fixed to the empty bobbin 110 which will take up the strip type substrate.

After fixing the strip type substrate and the protection film respectively the bobbins, the shaft of the protection film takeup bobbin is fixed to be stationary and the strip type substrate and the protection film are tensioned without slackness by applying a torque for producing the tension to the unwinding bobbin.

Preheating and Baking Process

After the strip type substrate has been introduced and set, the strip type substrate is kept tensioned and stationary, the covers of the film forming chambers are closed and the interior of the apparatus is evacuated by vacuum pumps such as a rotary pump, a mechanical booster pump or the like. In this case, the interior of the apparatus is uniformly purged by the vacuum pumps connected to the strip type substrate unwinding chamber 101 and the takeup chamber 106, and it is preferable to purge the film forming chambers 102A to 105B through the gas gates 107 to ensure introduction of absorption gases from the strip type substrate unwinding chamber 101 and the takeup chamber 106 to the film forming chambers 102A to 105B and prevent intrusion of absorption gases from the impurity-doped layer film forming chambers 102A and 105B to the i-type semiconductor layer film forming chambers 103 and 104.

When the film forming chambers are purged to approximately 10Pa, the interiors of the film forming chambers are further purged to 1Pa or under by the vacuum pumps connected to respective film forming chambers.

When the internal pressures of the film forming chambers are reduced to 1Pa or under, purging of the film forming chambers 102A to 105B is stopped, gases such as $H_2$, He, Ar, Ne, Kr and Xe are introduced into the film forming chambers 103 and 104 to form gas flows from the film forming chambers to the strip type unwinding chamber 101 and the takeup chamber 106, and the pressures of the chambers 101 to 106 are controlled to approximately a few Pa.

When the pressures of the film forming chambers are stabilized, the film forming chambers are heated by lamp heaters, a substrate temperature control unit, a film forming chamber temperature control unit, and block heaters to preheat and bake the internal wall of the film forming chambers and the strip type substrate to 100 to 500°C.

Semiconductor Layer Forming Process

After preheating and baking of the film forming chambers, the strip type substrate 108 is continuously moved at a fixed speed from the unwinding chamber 101 to the takeup chamber 106 through the film forming chambers 102A, 103, 105A, 102B, 104 and 105B by rotating the shaft of the takeup bobbin 110 of the strip type substrate takeup chamber 106. The transfer speed of the strip type substrate is preferably 1 to 100mm/sec. and more preferably 5 to 50mm/sec.

The temperatures of the strip type substrate in the stacking films forming space of the film forming chambers and the temperatures of the internal walls of the film forming chambers are controlled to specified temperatures by the lamp heaters, the substrate temperature control unit, the film forming chamber temperature control unit, and block heaters of respective film forming chambers 102A to 105B while moving the strip type substrate.

When the temperature of the strip type substrate is stabilized, introduction of gases such as $H_2$, He, Ar, Ne, Kr, and Xe from the film forming chambers, the film forming chambers 102A to 105B are purged by the vacuum pumps respectively connected to the film forming chambers to introduce gases such as $H_2$, He, Ar, Ne, Kr, and Xe for separating the material gases from the gas cylinders to the gas gates 107 through the mass flow controller.

When the gas flow rate is stabilized, purging of the i-type semiconductor layer film forming chamber 103 which depends on the microwave plasma CVD method is changed over from the low vacuum pumps such as a rotary pump and a mechanical booster pump to high vacuum pumps such as a turbo molecular pump and an oil diffusion pump.

Specified quantities of material gases for forming semiconductor layers are introduced into the film forming chambers 102A to 105B at specified flow rates from gas cylinders through the mass flow controller.

When the flow rates of material gases to the film forming chambers are stabilized, the purging capacities for the film forming chambers are adjusted by the purging volume adjust valves provided in the purging pipes and the film forming chambers are set to specified pressures.

Preferable internal pressures for respective chambers into which material gases are introduced are 0.1 to 10Pa for the film forming chamber 103 which depends on the microwave plasma CVD method and 10 to 1000 Pa for other chambers. To prevent intrusion of impurity gases, it is preferable that the internal pressure of the i-type semiconductor film forming chamber 104 is slightly higher than the internal pressures of the n-type semiconductor layer film forming chamber 102B and the p-type semiconductor layer film forming chamber 105B, the internal pressure of the n-type semiconductor layer film forming chamber 102A is slightly higher than the internal pressure of the strip type substrate unwinding chamber 101, and the internal pressure of the p-type semiconductor layer film forming chamber 105B is slightly higher than the internal pressure of the strip type substrate takeup chamber 106.

When the pressures of the film forming chambers are stabilized, discharging powers such as a microwave power and an RF power are introduced into the film forming chambers 102A to 105B. Material gases in respective film forming chambers are ionized to form a plasma in respective film forming chambers.

As described above, the semiconductor layers are formed on the continuously moving strip type substrate in respective film forming chambers and a photovoltaic cell of the n-i-p-n-i-p or p-i-n-p-i-n structure is continuously fabricated by simultaneously forming the plasma in the film forming chambers 102A to 105B while moving the strip type substrate at a fixed speed.

A method for fabricating a 3-layer tandem type photovoltaic cell is described using an apparatus with a structure shown in Fig. 2.

Strip Type Substrate Introducing Process

For forming semiconductor layers by using the apparatus according to the present invention shown in Fig. 2, the strip type substrate is introduced into the apparatus and set at a specified position.

For introducing the strip type substrate into the apparatus according to the present invention, the bobbin 109 around which the strip type substrate 108 is wound is introduced into the strip type substrate unwinding chamber 101, the top end of the strip type substrate is unwound and guided to pass the film forming chambers 102A to 105C through the gas gates 107, extended to the empty bobbin 110 in the strip type substrate takeup chamber 106 and fastened thereto.

A protection film for protecting the surface of the strip type substrate from damage can be wound together with the strip type substrate 108 around the bobbin 109 onto which the strip type substrate on which films are not yet formed is wound. In the case that such protection film is wound, an extreme end of this protection film is fixed to the protection film takeup bobbin in the strip type substrate unwinding chamber 101.

Similarly, the protection film for protecting the surface of the strip type substrate from damage can be taken up by the bobbin 110 which also takes up the strip type substrate. For taking up this protection film, the protection film is unwound from the protection film unwinding bobbin in the strip type substrate takeup chamber 106 and the extreme end of the protection film is overlapped with the strip type substrate 108 and fixed to the empty bobbin 110 which will take up the strip type substrate.

After fixing the strip type substrate and the protection film respectively the bobbins, the shaft of the protection film takeup bobbin is fixed to be stationary and the strip type substrate and the protection film are tensioned without slackness by applying a torque for producing the tension to the unwinding bobbin.

After the strip type substrate has been introduced and set, the strip type substrate is kept tensioned and stationary, the covers of the film forming chambers are closed and the interior of the apparatus is evacuated by vacuum pumps such as a rotary pump, a mechanical booster pump or the like. In this case, the interior of the apparatus is uniformly purged by the vacuum pumps connected to the strip type substrate unwinding chamber 101 and the takeup chamber 106, and it is preferable to purge the film forming chambers 102A to 105B through the gas gates 107 to ensure introduction of absorption gases from the strip type substrate unwinding chamber 101 and the takeup chamber 106 to the film forming chambers 102A to 105B and prevent intrusion of absorption gases from the impurity-doped layer film forming chambers 102A and 105B to the i-type semiconductor layer film forming chambers 103 and 104.

When the film forming chambers are purged to approximately 10Pa, the interiors of the film forming chambers are further purged to 1Pa or under by the vacuum pumps connected to respective film forming chambers.

When the internal pressures of the film forming chambers are reduced to 1Pa or under, purging of the film forming chambers 102A to 105C is stopped, gases such as $H_2$, He, Ar, Ne, Kr and Xe are introduced into the film forming chambers 103A, 103B and 104 to form gas flows from the film forming chambers to the strip type unwinding chamber 101 and the takeup chamber 106, and the pressures of the chambers 101 to 106 are controlled to approximately a few Pa.

When the pressures of the film forming chambers are stabilized, the film forming chambers are heated by lamp heaters, a substrate temperature control unit, a film forming chamber temperature control unit, and block heaters to preheat and bake the internal wall of the film forming chambers and the strip type substrate to 100°C to 500°C.

Semiconductor Layer Forming Process

After preheating and baking of the film forming chambers, the strip type substrate 108 is continuously moved at a fixed speed from the unwinding chamber 101 to the takeup chamber 106 through the film forming chambers 102A, 103A, 105A, 102B, 103B, 105B, 102C, 104 and 105C by rotating the shaft of the takeup bobbin 110 of the strip type substrate takeup chamber 106. The transfer speed of the strip type substrate is preferably 1 to 100mm/sec. and more preferably 5 to 50mm/sec.

The temperatures of the strip type substrate in the stacking films forming space of the film forming chambers and the temperatures of the internal walls of the film forming chambers are controlled to the specified temperatures by the lamp heaters, the substrate temperature control unit, the film forming chamber temperature control unit, and block heaters of respective film forming chambers 102A to 105C while moving the strip type substrate.

When the temperature of the strip type substrate is stabilized, introduction of gases such as $H_2$, He, Ar, Ne, Kr, and Xe from the film forming chambers, the film forming chambers 102A to 105C are purged by the vacuum pumps respectively connected to the film forming chambers to introduce gases such as $H_2$, He, Ar, Ne, Kr, and Xe for separating the material gases from the gas cylinders to the gas gates 107 through the mass flow controller.

When the gas flow rate is stabilized, purging of the i-type semiconductor layer film forming chambers 103A and 103B which depends on the microwave plasma CVD method is changed over from the low vacuum pumps such as a rotary pump and a mechanical booster pump to high vacuum pumps such as a turbo molecular pump and an oil diffusion pump.

Specified quantities of material gases for forming semiconductor layers are introduced into the film forming chambers 102A to 105C at specified flow rates from gas cylinders through the mass flow controller.

When the flow rates of material gases to the film forming chambers are stabilized, the purging capacities for the film forming chambers are adjusted by the purging volume adjust valves provided in the purging pipes and the film forming chambers are set to specified pressures.

Preferable internal pressures for respective chambers into which material gases are introduced are 1 to 10Pa for the film forming chambers 103A and 103B which depend on the microwave plasma CVD method and 10 to 1000 Pa for other chambers. To prevent intrusion of impurity gases, it is preferable that the internal pressure of the i-type semiconductor film forming chamber 104 is slightly higher than the internal pressures of the n-type semiconductor layer film forming chamber 102C and the p-type semiconductor layer film forming chamber 105C, the internal pressure of the n-type semiconductor layer film forming chamber 102A is slightly higher than the internal pressure of the strip type substrate unwinding chamber 101, and the internal pressure of the p-type semiconductor layer film forming chamber 105B is slightly higher than the internal pressure of the strip type substrate takeup chamber 106.

When the pressures of the film forming chambers are stabilized, discharging powers such as a microwave power, high frequency power, low frequency power and a DC power are introduced into the film forming chambers 102A to 105C. Material gases in respective film forming chambers are ionized to form a plasma in respective film forming chambers.

As described above, the semiconductor layers are formed on the continuously moving strip type substrate in respective film forming chambers and a photovoltaic cell of the n-i-p-n-i-p or p-i-n-p-i-n structure is continuously fabricated by simultaneously forming the plasma in the film forming chambers 102A to 105C while moving the strip type substrate at a fixed speed.

Fabrication Method for 2-layer or 3-layer Tandem Type Photovoltaic Cell

The forming conditions for semiconductor layers for the 2-layer tandem type photovoltaic cell in the film forming chambers 102A to 105B shown in Fig. 1 and the 3-layer tandem type photovoltaic cell in the film forming chambers 102A to 105C shown in Fig. 2 are as described below.

[Film Forming Conditions in Film Forming Chambers 102A, 102B, 102C, 105A and 105B]

An n(or p)-type silicon-based amorphous semiconductor layer is formed by the RF plasma CVD method in the film forming chambers 102A, 102B, 102C, 105A and 105B.

Material gases to be introduced into these film forming chambers include compounds which can be gasified as gases containing at least silicon atoms. Those compounds which can be gasified as gases containing silicon atoms include $SiH_4$, $Si_2H_6$, $SiF_4$, $SiFH_3$, $SiF_2H_2$, $SiF_3H$, $Si_3H_8$, $SiD_4$, $SiHD_3$, $Si_2D_2$, $SiH_3D$ and $Si_2D_3H_3$. Material gases can contain compounds which contain Ge atoms and can be gasified to reduce the optical band gap.

Specifically, those compounds which contain Ge atoms and can be gasified include $GeH_4$, $GeD_4$, $GeF_4$, $GEFH_3$, $GeF_2H_2$, $GeF_3H$, $GeHD_3$, $GeH_2D_2$, and $GeH_3D$. Moreover, material gases may contain compounds which contain C, 0 and N atoms and can be gasified.

Specifically, those compounds which contain C atoms and can be gasified include $CH_4$, $CD_4$, $C_nH_{2n+2}$ (n is an integer), $C_nH_{2n}$ (n is an integer), $C_2H_2$, $C_6H_6$, $CO_2$ and CO.

Those compounds which contain 0 atoms and can be gasified include $O_2$, CO, $CO_2$, NO, $NO_2$, $N_2O$, $CH_3CH_2OH$ and $CH_3OH$.

Those compounds which contain N atoms and can be gasified include $N_2$, $NH_3$, $ND_3$, NO, $NO_2$ and $N_2O$.

Material gases include compounds which contain atoms belonging to the V or III group of the periodic law table and can be gasified to control the conductivity types of silicon-based amorphous semiconductor layers to be formed to n(or p)-type in terms of valence electron.

Specifically, starting materials to be effectively used for introducing the V group atoms (elements) include phosphorus hydrides such as $PH_3$ and $P_2H_4$ and phosphorus halides such as $PH_4I$, $PF_3$, $PF_5$, $PCl_3$, $PCl_5$, $PBr_3$, $PBr_5$, and $PI_3$ for introducing P atoms. Besides, $AsH_3$, $AsF_3$, $AsCl_3$, $AsBr_3$, $AsF_5$, $SbF_3$, $SbF_5$, $SbCl_3$, $SbCl_5$, $BiH_3$, $BiCl_3$, and $BiBr_3$ can be enumerated. Particularly, $PH_3$, $PF_3$ and $AsH_3$ are suitable.

Specifically, starting materials to be effectively used for introducing the III group atoms include boron hydrides such as $B_2H_6$, $B_4H_{10}$, $B_5H_9$, $B_6H_{11}$, $B_6H_{12}$, and $B_6H_{14}$ and boron halides such as $BP_3$ and $BCl_3$ for introducing B atoms. Besides, $AlCl_3$, $GaCl_3$ and $InCl_3$ can be enumerated. Particularly, $B_2H_6$ and $BF_3$ are suitable.

Material gases may include diluted gases such as $H_2$, $D_2$, He, Ne, Ar, Xe and Kr.

A discharging power to be supplied to the film forming chambers are used to form an RF plasma and includes at least an RF power. The RF power to be introduced is appropriately determined in accordance with the flow rates of material gases to be introduced into the film forming chambers and preferably a stable continuous oscillation waves with less fluctuations such as ripples within a range of 0.001 to $1W/cm^3$ for the plasma forming space. The frequency of the RF power is preferably within 1MHz to 500MHz and suitably 13.56MHz as an industrial frequency with less fluctuation.

A DC power may be introduced together with the RF power and, in this case, it is preferable to supply a voltage of 10 to 200V to the RF discharging electrode or an electrode separately provided besides the discharging electrode in a direction where the electrode side is positive in a range where abnormal discharging such as spark will not occur.

Such RF power is introduced into the film forming chambers and preferably a DC power is simultaneously introduced and material gases are ionized and decomposed in the film forming chambers to form the n( or p)-type silicon-based amorphous semiconductor layer on the strip type substrate.

The semiconductor layer to be formed under these film forming conditions are formed with amorphous materials from silicon-based amorphous (including micro crystals) to poly crystalline materials.

[Film Forming Conditions in Film Forming Chambers 103, 103A and 103B]

In the film forming chambers 103, 103A and 103B, the i-type silicon-based amorphous semiconductor layers are formed by the microwave plasma CVD method.

Material gases to be introduced into these film forming chambers include compounds which can be gasified as gases containing at least silicon atoms. Those compounds which can be gasified as gases containing silicon atoms include $SiH_4$, $Si_2H_6$, $SiF_4$, $SiFH_3$, $SiF_2H_2$, $SiF_3H$, $Si_3H_8$, $SiD_4$, $SiHD_3$, $Si_2D_2$, $SiH_3D$ and $Si_2D_3H_3$. Material gases can contain compounds which contain Ge atoms and can be gasified to reduce the optical band gap.

Specifically, those compounds which contain Ge atoms and can be gasified include $GeH_4$, $GeD_4$, $GeF_4$, $GeFH_3$, $GeF_2H_2$, $GeF_2H$, $GeHD_3$, $GeH_2D_2$, and $GeH_3D$. Moreover, material gases may contain compounds which contain C, 0 and N atoms and can be gasified.

Specifically, those compounds which contain C atoms and can be gasified include $CH_4$, $CD_4$, $C_nH_{2n+2}$ (n is an integer), $C_nH_{2n}$ (n is an integer), $C_2H_2$, $C_6H_6$, $CO_2$ and CO.

Those compounds which contain 0 atoms and can be gasified include $O_2$, CO, $CO_2$, NO, $NO_2$, $N_2O$, $CH_3CH_2OH$ and $CH_3OH$.

Those compounds which contain N atoms and can be gasified include $N_2$, $NH_3$, $ND_3$, NO, $NO_2$ and $N_2O$.

The semiconductor layers to be formed in the above film forming chambers may contain micro quantities of impurities for valence electron control as far as these impurities are substantially genuine and material gases may contain micro quantities of compounds which contain the V or III group atoms shown in the periodic law table and can be gasified.

Specifically, starting materials to be effectively used for introducing the V group atoms include phosphorus hydrides such as $PH_3$ and $P_2H_4$ and phosphorus halides such as $PH_4I$, $PF_3$, $PF_5$, $PCl_3$, $PCl_5$, $PBr_3$, $PBr_5$, and $PI_3$ for introducing P atoms. Besides, $AsH_3$, $AsF_3$, $AsCl_3$, $AsBr_3$, $AsF_5$, $SbF_3$, $SbF_5$, $SbCl_3$, $SbCl_5$, $BiH_3$, $BiCl_3$, and $BiBr_3$ can be enumerated. Particularly, $PH_3$, $PF_3$ and $AsH_3$ are suitable.

Specifically, starting materials to be effectively used for introducing the III group atoms include boron hydrides such as $B_2H_6$, $B_4H_{10}$, $B_5H_9$, $B_5H_{11}$, $B_6H_{12}$, and $B_6H_{14}$ and boron halides such as $BP_3$ and $BCl_3$ for introducing B atoms. Besides, $AlCl_3$, $GaCl_3$ and $InCl_3$ can be enumerated. Particularly, $B_2H_6$ and $BF_3$ are suitable.

Material gases may include diluted gases such as $H_2$, $D_2$, He, Ne, Ar, Xe and Kr.

A discharging power to be introduced into the film forming chambers is used to form a microwave plasma by ionizing the above-described material gases and includes at least a microwave power. The microwave power to be introduced is appropriately determined in accordance with the flow rates of the material gases to be introduced into the film forming chambers and preferably a stable continuous oscillation waves with less fluctuations such as ripples within a range of 0.001 to $1W/cm^3$ for the plasma forming space. The frequency of the microwave power is preferably within 500MHz to 10GHz and suitably 2.45GHz as an industrial frequency with less fluctuation.

In addition, it is preferable introduce the RF power and/or the DC power together with the microwave power into the i-type semiconductor layer film forming chambers 103A and 103B, which depend on the microwave plasma CVD method, of the apparatus according to the present invention by providing a bias electrode in the microwave plasma forming space.

The RF power to be introduced is preferably within the range of 0.02 to $2W/cm^2$ and the frequency thereof is preferably within the range of 1MHz to 500MHz and suitably 13.56MHz as an industrial frequency. For introducing the DC power, it is preferable to introduce a voltage of 10 to 300V in the direction where the bias electrode side is positive within a range where abnormal discharging such as spark will not be caused.

Such microwave power is introduced into the film forming chambers and preferably the RF power or the DC power is simultaneously introduced and material gases are ionized and decomposed in the film forming chambers to form the i-type silicon-based amorphous semiconductor layer on the strip type substrate.

The semiconductor layer to be formed under these film forming conditions are formed with amorphous materials from silicon-based amorphous (including micro crystals) to poly crystalline materials.

[Film Forming Conditions in the Film Forming Chamber 104]

In the film forming chamber 104, the i-type silicon-based amorphous semiconductor layer is formed by the RF plasma CVD method.

Material gases to be introduced into these film forming chambers include compounds which can be gasified as gases containing at least silicon atoms. Those compounds which can be gasified as gases containing silicon atoms include $SiH_4$, $Si_2H_6$, $SiF_4$, $SiFH_3$, $SiF_2H_2$, $SiF_3H$, $Si_3H_8$, $SiD_4$, $SiHD_3$, $Si_2D_2$, $SiH_3D$ and $Si_2D_3H_3$. Material gases can contain compounds which contain Ge atoms and can be gasified to reduce the optical band gap.

Specifically, those compounds which contain Ge atoms and can be gasified include $GeH_4$, $GeD_4$, $GeF_4$, $GeFH_3$, $GeF_2H_2$, $GeF_2H$, $GeHD_3$, $GeH_2D_2$, and $GeH_3D$. Moreover, material gases may contain compounds which contain C, O and N atoms and can be gasified.

Specifically, those compounds which contain C atoms and can be gasified include $CH_4$, $CD_4$, $C_nH_{2n+2}$ (n is an integer), $C_nH_{2n}$ (n is an integer), $C_2H_2$, $C_6H_6$, $CO_2$ and CO.

Those compounds which contain O atoms and can be gasified include $O_2$, CO, $CO_2$, NO, $NO_2$, $N_2O$, $CH_3CH_2OH$ and $CH_3OH$.

EP 0 660 422 A2

Those compounds which contain N atoms and can be gasified include $N_2$, $NH_3$, $ND_3$, NO, $NO_2$ and $N_2O$.

The semiconductor layers to be formed in the above film forming chambers may contain micro quantities of impurities for valence electron control as far as these impurities are substantially genuine and material gases may contain micro quantities of compounds which contain the V or III group atoms shown in the periodic law table and can be gasified.

Specifically, starting materials to be effectively used for introducing the V group atoms include phosphorus hydrides such as $PH_3$ and $P_2H_4$ and phosphorus halides such as $PH_4I$, $PF_3$, $PF_5$, $PCl_3$, $PCl_5$, $PBr_3$, $PBr_5$, and $PI_3$ for introducing P atoms. Besides, $AsH_3$, $AsF_3$, $AsCl_3$, $AsBr_3$, $AsF_5$, $SbF_3$, $SbF_5$, $SbCl_3$, $SbCl_5$, $BiH_3$, $BiCl_3$, and $BiBr_3$ can be enumerated. Particularly, $PH_3$, $PF_3$ and $AsH_3$ are suitable.

Specifically, starting materials to be effectively used for introducing the III group atoms include boron hydrides such as $B_2H_6$, $B_4H_{10}$, $B_5H_9$, $B_5H_{11}$, $B_6H_{12}$, and $B_6H_{14}$ and boron halides such as $BP_3$ and $BCl_3$ for introducing B atoms. Besides, $AlCl_3$, $GaCl_3$ and $InCl_3$ can be enumerated. Particularly, $B_2H_6$ and $BF_3$ are suitable.

Material gases may include diluted gases such as $H_2$, $D_2$, He, Ne, Ar, Xe and Kr.

A discharging power to be introduced into the film forming chambers is used to form an RF plasma by ionizing the above-described material gases and includes at least an RF power. The RF power to be introduced is appropriately determined in accordance with the flow rates of the material gases to be introduced into the film forming chambers and preferably a stable continuous oscillation waves with less fluctuations such as ripples within a range of 0.001 to $1W/cm^3$ for the plasma forming space. The frequency of the microwave power is preferably within 1MHz to 500MHz and suitably 13.56MHz as an industrial frequency with less fluctuation.

A DC power can be introduced together with the RF power and it is preferable to introduce a voltage of 10 to 200V to the RF discharging electrode and an electrode provided separately from the RF discharging electrode in the direction where the electrode side is positive within a range where abnormal discharging such as spark will not be caused.

Such RF power is introduced into the film forming chambers and preferably the DC power is simultaneously introduced and material gases are ionized and decomposed in the film forming chambers to form the i-type silicon-based amorphous semiconductor layer on the strip type substrate.

The semiconductor layer to be formed under these film forming conditions are formed with amorphous materials from silicon-based amorphous (including micro crystals) to poly crystalline materials.

[Film Forming Conditions in the Film Forming Chambers 105B and 105C]

In the film forming chambers 105B and 105C, the p (or n)-type silicon-based amorphous semiconductor layer is formed by the plasma doping.

Material gases to be introduced into the above-described film forming chambers include those compounds which contain atoms of the III and V group shown in the periodic law table and can be gasified by changing the surface of the i-type amorphous semiconductor layer and its neighbor to the p(or n)-type by plasma doping.

Specifically, starting materials to be effectively used for introducing the III group atoms include boron hydrides such as $B_2H_6$, $B_4H_{10}$, $B_5H_9$, $B_5H_{11}$, $B_6H_{12}$, and $B_6H_{14}$ and boron halides such as $BP_3$ and $BCl_3$ for introducing B atoms. Besides, $AlCl_3$, $GaCl_3$ and $InCl_3$ can be enumerated. Particularly, $B_2H_6$ and $BF_3$ are suitable.

Specifically, starting materials to be effectively used for introducing the V group atoms include phosphorus hydrides such as $PH_3$ and $P_2H_4$ and phosphorus halides such as $PH_4I$, $PF_3$, $PF_5$, $PCl_3$, $PCl_5$, $PBr_3$, $PBr_5$, and $PI_3$ for introducing P atoms. Besides, $AsH_3$, $AsF_3$, $AsCl_3$, $AsBr_3$, $AsF_5$, $SbF_3$, $SbF_5$, $SbCl_3$, $SbCl_5$, $BiH_3$, $BiCl_3$, and $BiBr_3$ can be enumerated. Particularly, $PH_3$, $PF_3$ and $AsH_3$ are suitable.

Material gases may include diluted gases such as $H_2$, $D_2$, He, Ne, Ar, Xe and Kr.

In addition, material gases may contain a gas which contains a sufficiently small quantity of silicon atoms and/or a gas which contains C, O and N to form impurity-doped layers with a desired film thickness by stacking deposition.

Gases which include silicon atoms include $SiH_4$, $Si_2H_6$, $SiF_4$, $SiFH_3$, $SiF_2H_2$, $SiF_3H$, $Si_3H_8$, $SiD_4$, $SiHD_3$, $Si_2D_2$, $SiH_3D$ and $Si_2D_3H_3$. Gases which include carbon atoms include $CH_4$, $CD_4$, $C_nH_{2n+2}$ (n is an integer), $C_nH_{2n}$ (n is an integer), $C_2H_2$, $C_6H_6$, $CO_2$ and CO, gases which contain oxygen atoms include $O_2$, CO, $CO_2$, NO, $NO_2$, $N_2O$, $CH_3CH_2OH$ and $CH_3OH$, and gases which contain nitrogen atoms include $N_2$, $NH_3$, $ND_3$, NO, $NO_2$ and $N_2O$.

The discharging power to be introduced into the above-described film forming chambers is introduced to form a glow discharging RF or microwave plasma by ionizing the material gases and preferably a power of 1kHz to 13.56MHz. It seems that, the plasma doping is carried out with the frequency of 1kHz to 500kHz (low frequency), an ion moving distance is long and a thickness of ion implantation becomes large.

The power to be introduced is preferably within the range of 0.001 to $1W/cm^3$ for the volume of the plasma forming space and desired to be a stable continuous oscillation wave with less fluctuation such as ripples. A DC power can be introduced together with the discharging power and it is preferable to introduce a voltage of 10 to 200V to the discharging electrode and an electrode provided separately from the discharging electrode in the direction where the electrode side is positive within a range where abnormal discharging such as spark will not be caused.

Such RF power is introduced into the film forming chambers and preferably the DC power is simultaneously introduced and material gases are ionized and decomposed in the film forming chambers to form the p (or n)-type silicon-based amorphous semiconductor layer on the strip type substrate.

The semiconductor layer to be formed under these film forming conditions are formed with amorphous materials from silicon-based amorphous (including micro crystals) to poly crystalline materials.

Formation of semiconductor stacking films as described above is continued for a specified period of time simultaneously in the film forming chambers 102A to 105C while continuously moving the strip type substrate to form a given length of strip type substrate on the surface of which semiconductor stacking films have been formed, and the strip type substrate is continuously taken up by the takeup bobbin 110 in the strip type substrate takeup chamber 106.

Strip Type Substrate Take-out Process

When a given length of strip type substrate on the surface of which semiconductor stacking films have been formed is formed and taken up by the bobbin in the takeup chamber, introduction of the discharging power into the film forming chambers 102A to 105C, supplying of material gases and movement and heating of the strip type substrate are stopped and supplying of gate gases to the gas gates are also stopped. The film forming chambers 101 to 106 are purged by the vacuum pumps respectively connected to the film forming chambers and purging of the film forming chambers 103A and 103B is changed over from the high vacuum pumps to the low vacuum pumps. The film forming chambers and the material gas supplying system by which material gases are supplied to the film forming chambers are fully purged with an inert gas such as He and Ar.

When purging of the film forming chambers and the material gas supplying system by which material gases are supplied to the film forming chambers is finished, purging of the chambers 101 to 106 is stopped and the chambers and the strip type substrate are cooled by filling these chambers with the inert gas such as He and Ar with a pressure slightly lower than the atmospheric pressure.

When the chambers and the strip type substrate are cooled to room temperature or a similar level, the pressure of the apparatus is set to be equal to the atmospheric pressure by introducing gases such as dry $N_2$, Ar and He into the apparatus to reduce a driving force and torque applied to the bobbins, and the strip type substrate is cut in the takeup chamber 106 with a part of the strip type substrate from the unwinding chamber to the takeup chamber kept to remain and the bobbin 110 around which the strip type substrate is wound is taken out from the strip type substrate takeup chamber 106.

In the apparatus according to the present invention, the strip type substrate unwinding chamber 101 and the takeup chamber 106 are exposed to the air when the strip type substrate is introduced into or taken out from the chambers. If the air flows into a series of film forming chambers 102A to 105C, impurity gases such as steam and oxygen deposit on the internal walls of the film forming chambers and therefore the characteristics of the semiconductor films to be formed may be adversely affected. Accordingly, an appropriate air prevention means can be provided between the strip type substrate unwinding chamber 101 and the film forming chamber 102A and between the strip type substrate takeup chamber 106 and the film forming chamber 105C to form the apparatus as a load lock structure. In this case, the air prevention means includes vacuum sealing means for maintain the internal spaces of the film forming chambers 102A to 105C in a pressure-reduced condition air prevention means by which an inert gas such as He or a gas such as high purity nitrogen which does not affect formation of films into the film forming chambers 102A to 105C, the gas is pressurized over the atmospheric pressure and a clean gas flow to the unwinding chamber 101 and the takeup chamber 106 to block the intrusion of air.

If a sealing structure is employed, it is very difficult to pass the strip type substrate through the film forming chambers 102A to 105C while these chambers are kept in vacuum and therefore it is preferable to employ a mechanical sealing structure which uses 0-rings, gaskets, helicoflexes and magnetic fluid which are designed to maintain the vacuum in an arrangement where the strip type substrate is held by and between these components in a sealing structure so that a vacuum-tight condition can be maintained with the strip type substrate kept passing through the film forming chambers 102A to 105C.

The above-described air prevention means can be provided in the i-type semiconductor layer film forming chambers 103A and 103B which depend on the microwave plasma CVD method. Since film formation in the i-type film forming chambers which depend on the microwave plasma CVD method is carried out at a high speed, a larger quantity of semiconductor film adheres to their internal surfaces than in other film forming chambers. If formation of semiconductor films is continues with a large amount of film adhered, the microwave transmission factor of the microwave introducing window reduced to lower the power to be introduced or exfoliated film flakes fall on the semiconductor films to cause a defect and therefore it is necessary to periodically clean the interiors of the film forming chambers 103. In this case, provision of the above-described air prevention means is effective to prevent adverse effects due to intrusion of the air on other film forming chambers and it is therefore preferable to provide the air prevention means between the film forming chambers 103A and 103B and other film forming chambers.

A series of the above-described processes enable to continuously form the semiconductor stacking films on the strip type substrate in the apparatus according to the present invention.

While embodiments according to the present invention which use continuous forming apparatuses for semiconductor stacking films are shown below, the present invention is not limited to these embodiments.

An embodiment of a two-layer tandem type cell will be first described.

(Embodiment 1-1)

Using the continuous forming apparatus for semiconductor stacking films shown in Apparatus Example 1-1, two n-i-p structure type photovoltaic cells of which i-type semiconductor layers were respectively made of amorphous silicon germanium and amorphous silicon were laminated on a substrate in this order and photovoltaic cells that laminates silicon-based amorphous semiconductors of n-i-p-n-i-p structure were continuously fabricated. In this fabrication in the film forming chamber 103, the two i-type semiconductor layers were formed in different three chambers containing the material gases having different concentrations of germanium atom so that the i-type semiconductor layers formed continuously in the film forming chamber 103 have varied large-small-large germanium contents in the film thickness direction.

At first, a strip type substrate, having minute concave and convex surfaces, where an Ag layer of 500 nm thickness and a ZnO transparent conductive layer of about 2 $\mu$m thickness were formed and stacked on a SUS430HA strip type stainless plate (width 12 cm x length 200 m x thickness 0.15 mm) was set in a condition wound to the bobbin 109 to the strip type substrate, penetrated through film forming chambers 102A to 105B via respective gas gates 107 and delivered to the strip type substrate takeup chamber 106, which substrate was subjected to a tension so as to avoid loosing. A bobbin winding a dried enough protective film of aramid paper film (Normex (trade name) manufactured by Du pont, width 12 cm x length 200 m x thickness 0.05 mm) was set in the strip type substrate takeup chamber 106 so that the protective film was also wound together with the strip type substrate.

After the strip type substrate was set, internal of respective chambers 101 to 106 was once evacuated with a pump (not shown) which is a combination of a rotary pump and a mechanical booster pump, He gas was introduced to the chambers while being evacuated subsequently and thermal baking was applied in the respective chambers to a temperature of 350 °C approximately in He atmosphere of about 200Pa.

Following to the thermal baking, respective chambers 101 to 106 were once evacuated, the film forming chambers 101, 102A, 105A, 102B, 104, 105B, 106 were subsequently evacuated with a pump which is a combination of a rotary pump and a mechanical booster pump communicating to the respective film forming chambers while the film forming chamber 103A was evacuated by each two oil diffusion pumps (HS-6 manufactured by Varian) respectively connected to the chambers. While keeping such conditions, gate gas $H_2$ was fed to the respectively and respective material gases were fed to respective film forming chambers 102A through 105B in a predetermined amount and internal pressure of the chambers was adjusted by adjusting the opening of the throttle valves installed at the evacuation pipes of respective chambers 101 to 106 as follows. Strip type substrate unwinding chamber 101 and takeup chamber 101: 125 Pa, Film forming chambers 102A: 130 Pa, 103A: about 1 Pa, 105A: 130 Pa, 102B: 130 Pa, 104: 135 Pa, and 105B: 130 Pa.

When the internal pressure was stabilized in each chamber, the winding bobbin 110 in the strip type substrate takeup chamber 106 was started to rotate and the strip type substrate 108 was moved continuously at a constant speed of 100 cm/minute in the direction of from the film forming chamber 102A to 105B. Temperature control was made by temperature control units (not shown) fitted within respective film forming chambers 102A through 105C so that the moving strip type substrate was controlled to be of predetermined temperature in the film forming space at respective chambers.

When the temperature of the strip type substrate was stabilized, via matching devices from respective power sources (not shown), RF power of 13.56 MHz was introduced to the film forming chambers 102A, 105A, 102B, 104 from the parallel plate electrodes; microwave power of 2.45 GHz was introduced to the film forming chambers installed in the film forming chamber 103 from the microwave introduction window installed at each one side wall; and RF power of 75 KHz was introduced to the film forming chamber 105B from parallel plate electrodes. Then, the RF power of 13.56 MHz which was introduced via matching devices from respective power sources (not shown) was introduced to the film forming chambers installed in the film forming chamber 103 from bar-shaped vias electrodes installed in front of the microwave introduction window so as to be parallel with the strip type substrate. While the length relative to the moving direction of the strip type substrate in the film forming chamber inside 103 was about 20 cm in all the cases, the length relative to the moving direction of the strip type substrate in the formation areas of the semiconductor layers were adjusted by installing shield plates (that also function as guards for plasma leakage) of a constant length between the strip type substrate surface and the plasma. By turning the discharge power on, the material gases in the film forming chambers 102A to 105B were turned to plasma and semiconductor film was formed in respective film forming chambers onto the moving strip type substrate; thereby, semiconductor stacking film of n-i-p-n-i-p structure were continuously formed on the strip type substrate surface. Table 1 shows the film formation conditions for the first photovoltaic cell in the film forming chambers 102A through 105A and Table 2 shows the film formation conditions for the second photovoltaic cell in the film forming chambers 102B through 105B.

The strip type substrate was continuously moved for 180 minutes from the start of strip type substrate transportation, the semiconductor stacking film was formed continuously in 170 minutes of that period.

Following to the formation of the semiconductor stacking film for about 170 m, introducing of the charge power, feeding of the material gas, and heating of the strip type substrate and film forming chambers were stopped; internal of the film forming chambers was purged, and the strip type substrate and internal of the apparatus were allowed to cool enough. Thereafter, the strip type substrate wound on the bobbin 110 was removed from the strip type substrate takeup chamber 106 to outside of the apparatus.

The removing strip type substrate was further processed continuously with a continuous modulating apparatus. Thereby, thin film of ITO ($In_2O_3$ + $SnO_2$) of 70 nm was formed as an transparent electrode on the whole surface of the semiconductor stacking film that was formed by the apparatus according to the present invention, which electrode in fine lines with a constant space as a collector electrode. By modulation such as making unit cells in series, a solar cell module of 35 cm x 35 cm size comprising two-layer tandem solar cell with laminated photovoltaic cells having different band gaps was continuously fabricated. The product solar cell is shown on Fig. 5 schematically for its layer structure.

After the manufactured solar cell module was evaluated its characteristics under application of artificial sunbeams of AM 1.5 (100mW/cm$^2$), the mean value of its photovoltaic conversion efficiency presented good value of 1.15 relative to the mean value 1.00 of photovoltaic conversion efficiency of the solar cell module manufactured using conventional roll-to-roll system equipment that forms all p-type semiconductor layers using high-frequency plasma CVD method. The $\pm$ 5% dispersion of photovoltaic conversion efficiency between modules resulted from using conventional equipment decreased within $\pm$ 3%.

(Comparative Example 1-1)

Stacking film of silicon-based amorphous semiconductors of n-i-p-n-i-p structure was formed continuously in the same way as in those of the Embodiment 1-1 except that the film forming chamber 105B for p-type semiconductor p-type semiconductor of the apparatus according to the present invention shown in Apparatus Example 1-1 was replaced by a film forming chamber and that the p-type semiconductor layers which are impurity-doped layers on the i-type semiconductor layer were formed wholly by RF plasma CVD method, and a solar cell module was made therefrom. Table 3 shows the film formation conditions for the second photovoltaic cell in the film forming chambers 102B and 105B.

The product solar cell module was evaluated for its performance under pseudo sunlight of AM 1.5 (100 mW/cm$^2$). Its photoelectric transfer efficiency was low 1.00 in relative value against 1.15 for the solar cell modules fabricated in the Embodiment 1-1. The dispersion among the modules was $\pm$ 5%, not small.

(Comparative Example 1-2)

Stacking film of silicon-based amorphous semiconductors of n-i-p-n-i-p structure was formed continuously in same way as those of the Embodiment 1-1 except that the film forming chamber 105A for p-type semiconductor layers of the apparatus according to the present invention shown in apparatus Example 1-1 was replaced by a chamber for plasma doping and that the p-type semiconductor layers which are impurity dope layers were formed wholly by RF plasma CVD method, and a solar cell module was made therefrom. Table 4 shows the film formation conditions for the first photovoltaic cell in the film forming chambers 102A and 105A and table 2 shows the film formation conditions for the second photovoltaic cell in the film forming chambers 102B and 105B.

The product solar cell module was evaluated for its performance under pseudo sunlight of AM 1.5 (100mW/cm$^2$). The curve factor was low and its photoelectric transfer efficiency was low 0.95 in relative value against 1.15 for the solar cell modules fabricated in the Embodiment 1-1.

(Embodiment 1-2)

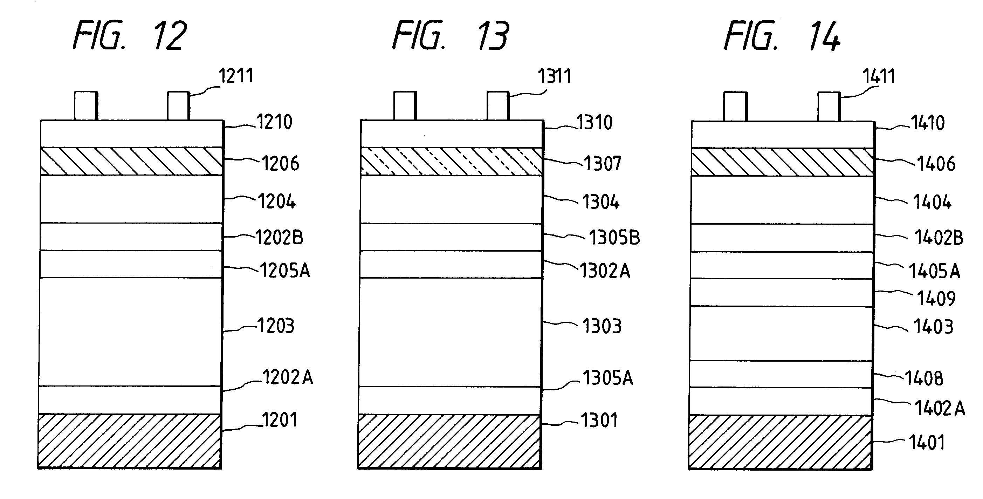

Using continuous forming apparatus for semiconductor stacking films of the present invention shown in the Apparatus Example 1-1, same as in the Embodiment 1-1 except replacing i-type semiconductor layer with amorphous silicon carbide, on the substrate i-type substrate semiconductor in turn layered two n-i-p structure photovoltaic cells consisting of amorphous silicon germanium and amorphous silicon carbide, which continuously formed two photovoltaic cells consisting of n-i-p-n-i-p structure silicon amorphous semiconductor. By continuing modularization, 35 cm x 35 cm solar cell module consisting of two-layer tandem type solar cell was continuously manufactured. The film forming conditions in film forming chambers 102A through 105A that forms the first photovoltaic cell are the same as those in the Embodiment 1-1 as shown in Fig. 1 and only the film forming conditions in film forming chambers 102B through 105B that forms the third photovoltaic cell are changed as shown in Table 5. Fig. 12 is a schematic drawing of the layer structure of the manufactured solar cell.

After the manufactured solar cell module was evaluated its characteristics under application of artificial sunlight of AM 1.5 (100 mW/cm$^2$), the mean value of its photovoltaic conversion efficiency presented good value of 1.15 relative to the mean value 1.00 of photovoltaic conversion efficiency of the solar cell module manufactured using conventional roll-to-roll system equipment that forms all p-type semiconductor layers using high frequency plasma CVD method. The ± 5% dispersion of photovoltaic conversion efficiency between modules resulted from using conventional equipment decreased within ± 3%.

(Embodiment 1-3)

Using the continuous forming apparatus for semiconductor stacking films of the present invention shown in the Apparatus Example 1-1, same as in the Embodiment 1-1, except altering discharge frequency of film forming chamber 105B of p-type semiconductor layer by plasma doping from 75 KHz to 13.56 MHz, stacking films of n-i-p-n-i-p structure silicon of non-single crystal was continuously formed. By further modularization, 35 cm x 35 cm solar cell module consisting of two-layer tandem type solar cell that layered photovoltaic cell with different band gap was continuously formed. Fig. 12 is a schematic drawing for the layer structure of the product solar cell.

After the manufactured solar cell module was evaluated its characteristics under application of artificial sunlight of AM 1.5 (100 mW/cm$^2$), the mean value of its photovoltaic conversion efficiency presented good value of 1.15 relative to the mean value 1.00 of photovoltaic conversion efficiency of the solar cell module manufactured using conventional roll-to-roll system equipment that forms all p-type semiconductor layers using high frequency plasma CVD method. The ± 5% dispersion of photovoltaic conversion efficiency between modules resulted from using conventional equipment decreased within ± 3%.

(Embodiment 1-4)

Using the continuous forming apparatus for semiconductor stacking films of the present invention shown the Apparatus Example 1-1, in the same manner as those of the Embodiment 1-1 except adding SiH$_4$ gas, in an enough small quantity of 3 sccm to form semiconductor layer of 10 nm by deposition, into the source gas which is to be introduced into film forming chamber 105B of p-type semiconductor through plasma doping, stacking films of n-i-p-n-i-p structure silicon non-single crystal semiconductor was continuously formed. By further modularization, 35 cm x 35 cm solar cell module consisting of two-layer tandem type solar cell that layered photovoltaic device with different band gap was continuously formed. Fig. 13 is a schematic drawing of layer structure of the manufactured solar cell.

After the manufactured solar cell module was evaluated its characteristics under application of artificial sunlight of AM 1.5 (100 Mw/cm$^2$), the mean value of its photovoltaic conversion efficiency presented good value of 1.14 relative to the mean value 1.00 of photovoltaic conversion efficiency of the solar cell module manufactured using conventional roll-to-roll system equipment that forms all p-type semiconductor layers using high-frequency plasma CVD method. The ± 5% dispersion of photovoltaic conversion efficiency between modules resulted from using conventional equipment decreased within ± 3%.

(Comparative Example 1-3)

The stacking films of the n-i-p-n-i-p structure type silicon-based amorphous semiconductor were continuously formed in the same manner as those of the Embodiment 1-4 except for adding $SiH_4$ gas only at 30 sccm to the material gases efficient to form a 10 nm thick semiconductor layer by depositing the material gases introduced into the film forming chamber 105B for p-type semiconductor layer of the apparatus according to the present invention shown in the exemplary apparatus 1-1, and then a solar cell module was fabricated.

The product solar cell module was evaluated for its performance under pseudo sunlight of AM 1.5 (100 Mw/cm2). Its photoelectric conversion efficiency was low 0.85 in relative to the mean value 1.00 of photovoltaic conversion efficiency of the solar cell module manufactured using conventional roll-to-roll system equipment that forms all p-type semiconductor layers using high-frequency plasma CVD method. The dispersion among the modules was ± 6%, not small.

(Embodiment 1-5)

Using the continuous forming apparatus for semiconductor stacking films according to the present invention shown in the Apparatus Example 1-1, the stacking films of the n-i-p-n-i-p structure type silicon-based amorphous semiconductor were continuously formed in the same manner as those of the Embodiment 1-1 except that conductivity types of the formed semiconductor layers are changed oppositely so as to form the p-type semiconductor layer in the film forming chambers 102A and 102B and the n-type semiconductor layer in the film forming chambers 105A and 105B. Then, the stacking films were combined into a module to continuously fabricate a 35 cm x 35 cm solar cell module which is constituted of two-layer tandem type solar cells stacked photovoltaic cells different in band gap. The film formation conditions in the film forming chambers 102A and 105A for forming the first photovoltaic cell are shown in table 6 and the film formation conditions in the film forming chambers 102B and 105B for forming the second photovoltaic cell are shown in table 7. Also, a schematic figure illustrating a layer structure of the fabricated solar cell is shown in Fig. 14.

After the manufactured solar cell module was evaluated its characteristics under application of artificial sunbeams of AM 1.5 (100mW/cm2), the mean value of its photovoltaic conversion efficiency presented good value of 1.15 relative to the mean value 1.00 of photovoltaic conversion efficiency of the solar cell module manufactured using conventional system equipment that forms all n-type semiconductor layers using high-frequency plasma CVD method. The ± 5% dispersion of photovoltaic conversion efficiency between modules resulted from using conventional equipment decreased within ± 3%.

(Embodiment 1-6)

Using the continuous forming apparatus for semiconductor stacking films according to the present invention shown in the Apparatus Example 1-2, two n-i-p structure type photovoltaic cells each i-type semiconductor of which is formed of amorphous silicon germanium and amorphous silicon on the substrate were stacked in due order and stacking films of the n-i-p-n-i-p structure type silicon-based amorphous semiconductor were continuously formed essentially in the same manner as those of the Embodiment 1-1 except that the i-type semiconductor layer was formed by the RF plasma CVD method before and after forming the i-type semiconductor layer along the microwave plasma CVD method. Then, the stacking films were combined into a module to continuously fabricate a 35 cm x 35 cm solar cell module which is constituted of two-layer tandem type solar cells stacked photovoltaic cells different in band gap. The film formation conditions in the film forming chambers 202A and 205A for forming the first photovoltaic cell are shown in table 8 and the film formation conditions in the film forming chambers 202B and 205B for forming the second photovoltaic cell are shown in table 2. Also, a schematic figure illustrating a layer structure of the fabricated solar cell is shown in Fig. 14.

After the manufactured solar cell module was evaluated its characteristics under application of artificial sunbeams of AM 1.5 (100mW/cm2), the mean value of its photovoltaic conversion efficiency presented good value of 1.18 relative to the mean value 1.00 of photovoltaic conversion efficiency of the solar cell module manufactured using conventional system equipment that forms all p-type semiconductor layers using high-frequency plasma CVD method. The ± 5% dispersion of photovoltaic conversion efficiency between modules resulted from using conventional equipment decreased within ± 2%.

(Embodiment 1-7)

Using the continuous forming apparatus for semiconductor stacking films according to the present invention shown in the Apparatus Example 1-2, the stacking films of the n-i-p-n-i-p structure type silicon-based amorphous semiconductor were continuously formed essentially in the same manner as those of the Embodiment 1-6 except for using a wide strip type substrate having a 36 cm width and then a 35 cm x 35 cm solar cell module which is constituted of two-layer tandem type solar cells stacked solar cells different in band gap was continuously fabricated.

The apparatus used in this embodiment has three times the dimension of the apparatus which was used in the Embodiments 1-1 to 1-6 relative to only a dimension along the wide direction of the strip type substrate. In three film forming chambers provided in a film forming chamber 203 for use of the microwave plasma CVD method, microwave casting means were respectively provided to be opposite to each other at the both sides of the strip type substrate so that microwave power is casted from six microwave casting means in the film forming chamber 203. Each electric field of the microwave casting means provided to be opposite to each other oriented in the vertical direction. The film formation conditions in the film forming chambers 202A and 205A for forming the first photovoltaic cell are shown in table 9 and the film formation conditions in the film forming chambers 202B and 205B for forming the second photovoltaic cell are shown in table 10. Also, a schematic figure illustrating a layer structure of the fabricated solar cell is shown in Fig. 14.

After the manufactured solar cell module was evaluated its characteristics under application of artificial sunbeams of AM 1.5 (100mW/cm$^2$), the mean value of its photovoltaic conversion efficiency presented good value of 1.18 relative to the mean value 1.00 of photovoltaic conversion efficiency of the solar cell module manufactured using conventional system equipment that forms all p-type semiconductor layers using high-frequency plasma CVD method. The ± 5% dispersion of photovoltaic conversion efficiency between modules resulted from using conventional equipment decreased within ± 2.5% and this confirmed that a high-quality semiconductor stacking film for the photovoltaic cell was formed on a large area with uniformity.

Next, an embodiment of a three-layer tandem type cell will be described.

(Embodiment 2-1)

Using the continuous forming apparatus for semiconductor stacking films shown in Apparatus Example 2-1, three n-i-p structure photovoltaic cells of which i-type semiconductor layers were respectively made of amorphous silicon germanium, amorphous silicon germanium, and amorphous silicon were laminated in this order on a substrate and photovoltaic cells that laminates silicon-based amorphous semiconductors of n-i-p-n-i-p-n-i-p structure were continuously fabricated. In this fabrication in the film forming chambers 103A and 103B, the three i-type semiconductor layers were formed in different three chambers containing the material gases having different concentrations of germanium atom so that the i-type semiconductor layers formed continuously in the film forming chambers 103A and 103B have varied large-small-large germanium contents in the film thickness direction.

At first, a strip type substrate, having minute concave and convex surfaces, where an Ag layer of 500 nm thickness and a ZnO transparent conductive layer of about 2 μm thickness were formed and laminated on a SUS 430BA strip type stainless plate (width 12 cm x length 200 m x thickness 0.15 mm) was set in a condition wound to the bobbin 109 to the strip type substrate unwinding chamber 101; the strip type substrate was penetrated through film forming chambers 102A to 105C via respective gas gates 107 and delivered to the strip type substrate takeup chamber 106, which substrate was subjected to a tension so as to avoid loosing. A bobbin winding a dried enough protective film of aramid paper film (Normex (trade name) manufactured by Du pont, width 12 cm x length 200 m x thickness 0.05 mm) was set in the strip type substrate takeup chamber 106 so that the protective film was also wound together with the strip type substrate.

After the strip type substrate was set, internal of respective chambers 101 to 106 was once evacuated by, He gas was introduced to the chambers while being evacuated subsequently and thermal baking was applied in the respective chambers to a temperature of 350 °C approximately in He atmosphere of about 200 Pa.

Following to the thermal baking, respective chambers 101 to 106 was once evacuated, the film forming chambers 101, 102A, 105A, 102B, 105B, 102C, 104, 105C, 106 were subsequently evacuated with a pump which is a combination of a rotary pump and a mechanical booster pump communicating to the respective film forming chambers while the film forming chambers 103A and 103B were evacuated by each two oil diffusion pumps (HS-16 manufactured by Varian) respectively connected to the chambers. While keeping such conditions, gate gas H$_2$ was fed to the respective gates 107 in an amount of 500 sccm respectively and respective material gases were fed to respective film forming chambers 102A through 105C in a predetermined amount. Internal pressure of the chambers was adjusted by adjusting the opening of the throttle valves installed at the evacuation pipes of respective chambers 101 to 106 as follows. Strip type substrate unwinding chamber 101 and takeup chamber 101: 125 Pa, Film forming chambers 102A: 130 Pa, 103A: about 1 Pa, 105A: 130 Pa, 102B: about 130 Pa, 103B: 1 Pa, 105B: 130 Pa, 102C: 130 Pa, 104: 135 Pa, and 105C: 130 Pa.

When the internal pressure was stabilized in each chamber, the winding bobbin 110 in the strip type substrate takeup chamber 106 was started to rotate and the strip type substrate 108 was moved continuously to at a constant speed of 100 cm/minute in the direction of from the film forming chamber 102A to 105C. Temperature control was made by temperature control units (not shown) fitted within respective film forming chambers 102A through 105C so that the moving strip type substrate was controlled to be of predetermined temperature in the film forming space at respective chambers.

When the temperature of the strip type substrate was stabilized, via matching devices from respective power sources (not shown), RF power of 13.56 MHz was introduced to the film forming chambers 102A, 105A, 102B, 105B, 102C, 104 from the parallel plate electrodes; microwave power of 2.45 GHz was introduced to the film forming chambers installed in film forming chambers 103A and 103B from the microwave introduction window installed at each one side wall; and RF power of 75 kHz was introduced to the film forming chamber 105C from parallel plate electrodes. While the length to the moving direction of the strip type substrate in the film forming chambers inside 103A and 103B was about 20 cm in all the cases, the length to the moving direction of the strip type substrate in the formation areas of the semiconductor layers were adjusted by installing shield plates (that also function as guards for plasma leakage) of a constant length between the strip type substrate surface and the plasma. By turning the discharge power on, the material gas in the film forming chambers 102A to 105C were turned to plasma and semiconductor film was formed in respective film forming chambers on to the moving strip type substrate; thereby, semiconductor laminate film of n-i-p-n-i-p-n-i-p structure were continuously formed on the strip type substrate surface. Table 11 shows the film formation conditions for the first photovoltaic cell in the film forming chambers 102A through 105A; Table 12 shows the film formation conditions for the second photovoltaic cell in the film forming chambers 102B through 105B; and Table 13 shows the film formation conditions for the third photovoltaic cell in the film forming chambers 102C through 105C.

The strip type substrate was continuously moved for 180 minutes from the start of strip type substrate transportation, the semiconductor laminate film was formed continuously in 170 minutes of that period.

Following to the formation of the semiconductor laminate film for about 170 m, introducing of the charge power, feeding of the material gas, and heating of the strip type substrate and film forming chambers were stopped; internal of the film forming chambers was purged, and the strip type substrate and internal of the apparatus were allowed to cool enough. Thereafter, the strip type substrate wound on the bobbin 110 was removed from the strip type substrate takeup chamber 106 to outside of the apparatus.

The removed strip type substrate was further processed continuously with a continuous modulating apparatus. Thereby, thin film of ITO ($In_2O_3$ + $SnO_2$) of 70 nm was formed as an transparent electrode on the whole surface of the semiconductor laminate film that was formed by the apparatus according to the present invention, which electrode formed an Ag electrode in fine lines with a constant space as a collector electrode. By modulation such as making unit cells in series, a solar cell module of 35 cm x 35 cm size comprising three layers tandem solar celll with laminated photovoltaic cells having different band gaps was continuously fabricated. The product solar cell is shown in Fig. 5 schematically for its layer composition. The product solar cell module was evaluated for its performance under pseudo sunlight of AM 1.5 (100 Mw/cm$^2$). Excellently, its photoelectric transfer efficiency was, in average, 1.15 against 1.00 of the average efficiency for the solar cell modules conventionally produced by the roll-to-roll apparatus by means of RF plasma CVD for all the p-type semiconductor layers. The dispersion of ± 5% among the modules for the conventional products is decreased to ± 3% for the present product.

(Comparative Example 2-1)

Stacking film of silicon-based amorphous semiconductors of n-i-p-n-i-p-n-i-p structure was formed continuously in same way as Apparatus Example 2-1 except that the film forming chamber 105C for p-type semiconductor layers is replaced by a film forming chamber and that the p-type semiconductor layers which are impurity-doped layers were formed wholly by RF plasma CVD method, and a solar cell module was made therefrom.

Table 14 shows the film formation conditions for the third photovoltaic cell in the film forming chambers 102C through 105C.

The product solar cell is shown in Fig. 5 schematically for its layer composition.

The product solar cell module was evaluated for its performance under pseudo sunlight of AM1.5 (100 mW/cm$^2$). Its photoelectric transfer efficiency was low 1.00 in relative value against 1.15 for the solar cell modules fabricated in Embodiment 2-1. The dispersion among the modules was ± 5%, not small.

(Comparative Example 2-2)

Stacking film of silicon-based amorphous semiconductors of n-i-p-n-i-p-n-i-p structure was formed continuously in same way as Apparatus Example 2-1 except that the film forming chamber 105A and 105B were replaced respectively by chambers for plasma doping and that the p-type semiconductor layers which are impurity dope layers were formed wholly by RF plasma CVD method, and a solar cell module was made therefrom. Table 15 shows the film formation conditions for the second photovoltaic cell in the film forming chambers 102C through 105C.

The product solar cell module was evaluated for its performance under pseudo sunlight of AM1.5 (100mW/cm²). The curve factor was low and its photoelectric transfer efficiency was low 0.95 in relative value against 1.15 for the solar cell modules fabricated in the Embodiment 2-1.

(Embodiment 2-2)

Using continuous forming apparatus for semiconductor stacking films of the present invention shown in Apparatus Example 2-1, same as in Embodiment 2-1 except replacing i-type semiconductor layer with amorphous silicon carbide, on the substrate i-type substrate semiconductor in turn layered n-i-p-n-i-p-n-i-p structure photovoltaic device consisting of amorphous silicon germanium, amorphous silicon germanium, and amorphous silicon carbide, which continuously formed photovoltaic devices consisting of n-i-p-n-i-p-n-i-p structure silicon amorphous semiconductor.

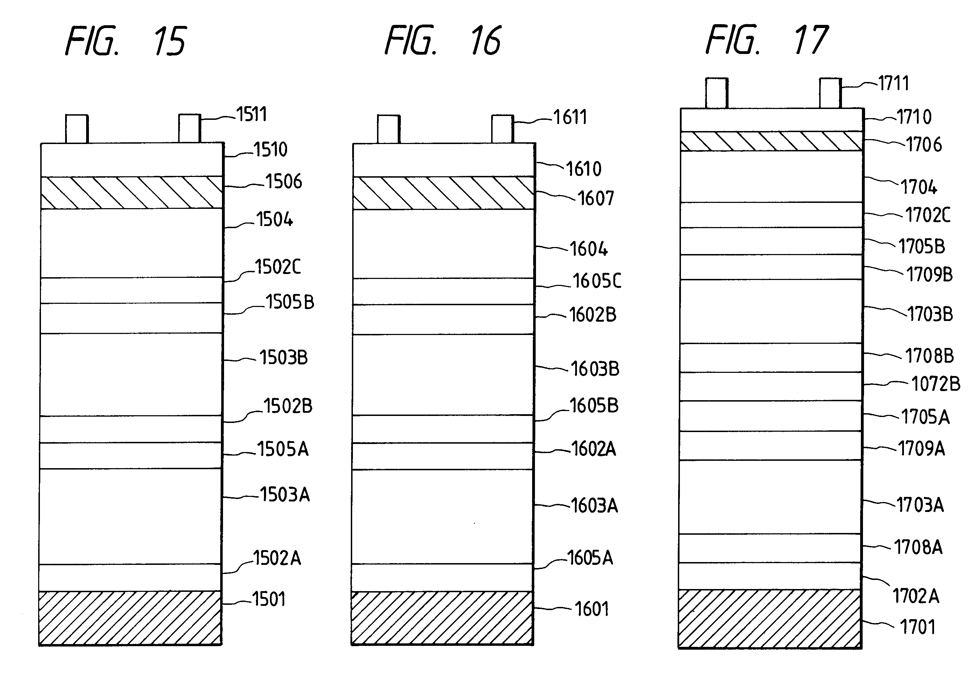

By continuing modularization, 35 cm x 35 cm solar cell module consisting of three-layered tandem type solar cell was continuously manufactured. The film forming conditions in film forming chambers 102A through 105A that forms the first photovoltaic device and the film forming conditions in film forming chambers 102B through 105B that forms the second photovoltaic device are same as in Embodiment 2-1 as shown in Tables 11 and 12, and only the film forming conditions in film forming chambers 102C through 105C that forms the third photovoltaic device are changed as shown in Table 7. Fig. 15 is a schematic drawing of the layer structure of the manufactured solar cell.

After the manufactured solar cell module was evaluated its characteristics under application of artificial sunlight of AM1.5 (100 mW/cm²), the mean value of its photovoltaic conversion efficiency presented good value of 1.15 relative to the mean value 1.00 of photovoltaic conversion efficiency of the solar cell module manufactured using conventional roll-to-roll system equipment that forms all p-type semiconductor layers using high frequency plasma CVD method. The ± 5% dispersion of photovoltaic conversion efficiency between modules resulted from using conventional equipment decreased within ± 3%.

(Embodiment 2-3)

Using the continuous forming apparatus for semiconductor stacking films of the present invention shown in Apparatus Example 2-1, same as in Embodiment 2-1, except altering discharge frequency of film forming chamber 105C of p-type semiconductor layer by plasma doping from 75 kHz to 13.56 MHz, stacking films of n-i-p-n-i-p-n-i-p structure silicon of non-single crystal was continuously formed. By further modularization, 35 cm x 35 cm solar cell module consisting of three-layered tandem type solar cell that layered photovoltaic device with different band gap was continuously formed. Fig. 15 is a schematic drawing for the layer structure of the product solar cell.

After the manufactured solar cell module was evaluated its characteristics under application of artificial sunlight of AM1.5 (100 mW/cm²), the mean value of its photovoltaic conversion efficiency presented good value of 1.15 relative to the mean value 1.00 of photovoltaic conversion efficiency of the solar cell module manufactured using conventional roll-to-roll system equipment that forms all p-type semiconductor layers using high frequency plasma CVD method. The ± 5% dispersion of photovoltaic conversion efficiency between modules resulted from using conventional equipment decreased within ± 3%.

(Embodiment 2-4)

Using the continuous forming apparatus for semiconductor stacking films of the present invention same as shown in Apparatus Example 2-1, except adding SiH₄ gas, in an enough small quantity of 3 sccm to form semiconductor layer of 10 nm by deposition, into the source gas which is to be introduced into film forming chamber 105C of p-type semiconductor through plasma doping, stacking films of n-i-p-n-i-p-n-i-p structure silicon non-single crystal semiconductor was continuously formed. By further modularization, 35 cm x 35 cm solar cell module consisting of three-layered tandem type solar cell that layered photovoltaic device with different band gap was continuously formed. Fig. 15 is a schematic drawing of layer structure of the manufactured solar cell.

After the manufactured solar cell module was evaluated its characteristics under application of artificial sunlight of AM1.5 (100 mW/cm²), the mean value of its photovoltaic conversion efficiency presented good value

40

of 1.14 relative to the mean value 1.00 of photovoltaic conversion efficiency of the solar cell module manufactured using conventional roll-to-roll system equipment that forms all p-type semiconductor layers using high-frequency plasma CVD method. The ± 5% dispersion of photovoltaic conversion efficiency between modules resulted from using conventional equipment decreased within ± 3%.

(Comparative Example 2-3)

Same as in Embodiment 2-4, except adding $SiH_4$ gas, enough quantity of 30 sccm to form semiconductor layer of 10 nm by deposition, into the source gas which is to be introduced into film forming chamber 105C of p-type semiconductor of the present invention shown in Apparatus Example 2-1, stacking films of n-i-p-n-i-p-n-i-p structure silicon non-single crystal semiconductor was continuously formed to manufacture solar cell module.

After the manufactured solar cell module was evaluated its characteristics under application of artificial sunlight of AM1.5 (100 mW/cm$^2$), the mean value of its photovoltaic conversion efficiency presented poor value of 0.85 compared relative to the mean value 1.00 of photovoltaic conversion efficiency of the solar cell module manufactured using conventional roll-to-roll system equipment that forms all p-type semiconductor layers using high-frequency plasma CVD method. The dispersion of photovoltaic conversion efficiency between modules presented large value of ± 6%.

(Embodiment 2-5)

Using the continuous forming apparatus according to the present invention shown in Apparatus Example 2-1 for forming semiconductor stacking films, forming p-type semiconductor layers in film forming chambers 102A, 102B, 102C, forming n-type semiconductor layers in film forming chambers 105A, 105B, 105C, same as in Embodiment 2-1 except turning the conduction type of semiconductor layers upside down, stacking films of n-i-p-n-i-p-n-i-p structure silicon non-single crystal semiconductor was continuously formed. By further modularization, 35 cm x 35 cm solar cell module consisting of three-layered tandem type solar cell that layered photovoltaic device with different band gap was continuously formed.

Table 18 lists film forming conditions of film forming chambers 102A through 105A forming the first photovoltaic device, Table 19 lists film forming conditions of film forming chambers 102B through 105B forming the second photovoltaic device, and Table 20 lists film forming conditions of film forming chambers 102C through 105C forming the third photovoltaic device. Fig. 16 shows a schematic drawing of film structure of the manufactured solar cell.

After the manufactured solar cell module was evaluated its characteristics under application of artificial sunlight of AM1.5 (100 mW/cm$^2$), the mean value of its photovoltaic conversion efficiency presented good value of 1.15 relative to the mean value 1.00 of photovoltaic conversion efficiency of the solar cell module manufactured using conventional roll-to-roll system equipment that forms all p-type semiconductor layers using high-frequency plasma CVD method. The ± 5% dispersion of photovoltaic conversion efficiency between modules resulted from using conventional equipment decreased within ± 3%.

(Embodiment 2-6)

Using continuous forming apparatus according to the present invention as shown in Apparatus Example 2-2 for semiconductor stacking films formation, almost same procedures as in Embodiment 2-1 are followed except that i-type semiconductor layers comprising amorphous silicon germanium, amorphous silicon germanium, amorphous silicon, on the substrate in this order are laminated as the three n-i-p-n-i-p-n-i-p structure photovoltaic cell to continuously form stacking films of n-i-p-n-i-p-n-i-p structure silicon non-monocrystalline semiconductor. By further modularization, a 35 cm x 35 cm solar cell module comprising three-layered tandem type solar cell that layered photovoltaic device with different band gap was continuously formed.

Table 21 lists film forming conditions in film forming chambers 202A through 205A forming the first photovoltaic device, Table 22 lists film forming conditions in film forming chambers 202B through 205B forming the second photovoltaic device, Table 23 lists film forming conditions in film forming chambers 202C through 205C forming the third photovoltaic device. Fig. 17 is a schematic drawing of the layer structure of the manufactured solar cell.

The product solar cell module was evaluated for its performance under pseudo sunlight of AM1.5 (100 mW/cm$^2$). Its photoelectric transfer efficiency was high 1.18 in relative value against 1.00 of the average efficiency for the solar cell modules conventionally produced wherein RF plasma CVD is applied for all the p-type semiconductor layers. The dispersion of ± 5% among the modules for the conventional products is decreased to ± 2% for the present product.

(Embodiment 2-7)

Using the continuous forming apparatus according to the present invention shown in Apparatus Example 2-2 for semiconductor of n-i-p-n-i-p-n-i-p structure was formed continuously in same way as Embodiment 2-6 except that a strip substrate of 36 cm width was used, and a solar cell module of 35 cm x 35 cm size comprising three layers tandem solar cell with laminated photovoltaic cells having different band gaps was continuously fabricated.

The apparatus used in the present Example differs from what was used in Examples 2-1 through 2-6 only in that the width dimension of the strip type substrate is three times what was used in Embodiments 2-1 through 2-6. Three film forming chambers were provided in the film forming chambers 203A and 203B by microwave plasma CVD method and had microwave introduction means on the both sides of the strip type substrate in the way of facing; the film forming chambers 203A and 203B received the microwave power respectively from six microwave introduction means. The two electric field of the microwave introduction means arranged in face to face oppositely were perpendicular each other. Table 24 shows the film formation conditions for the first photovoltaic cell in the film forming chambers 220A through 205A; Table 25 shows the film formation conditions for the second photovoltaic cell in the film forming chambers 202B through 205B; and Table 26 shows the film formation conditions for the third photovoltaic cell in the film forming chambers 202C through 205C. The product solar cell is shown on Fig. 17 schematically for its layer composition.

The product solar cell module was evaluated for its performance under pseudo sunlight of AM1.5 (100 mW/cm$^2$). Excellently, its photoelectric transfer efficiency was, in average, 1.18, in relative value, against 1.00 of the average efficiency for the solar cell modules produced by means of RF plasma CVD for all the p-type semiconductor layers. The dispersion of ± 6% among the modules for the conventional products is decreased to ± 2.5% for the present product; thus it was confirmed that high quality semiconductor layers for photovoltaic cell were uniformly fabricated for a large area.

Table 1

| Film forming condition \ Film forming chamber | 102A | 103(1) | 103(2) | 103(3) | 105A |
|---|---|---|---|---|---|
| Semiconductor layer forming method | RF plasma CVD method | Microwave plasma CVD method | Microwave plasma CVD method | Microwave plasma CVD method | RF plasma CVD method |
| Semiconductor layer to be formed (nm) | n-type amorphous Si layer 20 | i-type amorphous SiGe layer 50 | i-type amorphous SiGe layer 100 | i-type amorphous SiGe layer 25 | p-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$PH_3$ 3<br>$H_2$ 1500 | $SiH_4$ 125<br>$GeH_4$ 25<br>$H_2$ 200 | $SiH_4$ 100<br>$GeH_4$ 50<br>$H_2$ 200 | $SiH_4$ 125<br>$GeH_4$ 25<br>$H_2$ 200 | $SiH_4$ 30<br>$BF_3$ 1<br>$H_2$ 500 |
| Internal pressure of the film forming chamber (Pa) | 130 | 0.9 | 1 | 0.9 | 130 |
| Temperature of strip type substrate (°C) | 350 | 350 | 350 | 350 | 150 |
| Discharging power (W) | High frequency (13.56MHz) 150 | Microwave (2.45GHz) 300 | Microwave (2.45GHz) 300 | Microwave (2.45GHz) 300 | High frequency (13.56MHz)1000 |
| Bias power (W) | – | High frequency (13.56MHz) 600 | High frequency (13.56MHz) 600 | High frequency (13.56MHz) 600 | – |

Table 2

| Film forming chamber / Film forming condition | 102B | 104(1) | 104(2) | 105B |
|---|---|---|---|---|
| Semiconductor layer forming method | RF plasma CVD method | RF plasma CVD method | RF plasma CVD method | Plasma doping |
| Semiconductor layer to be formed (nm) | n-type amorphous Si layer 20 | i-type amorphous Si layer 80 | i-type amorphous Si layer 80 | p-type amorphous Si layer about 10 |
| Length of the semiconductor layer forming region in the strip type substrate moving direction (cm) | 60 | 200 | 200 | 100 |
| Material gas (sccm) | $SiH_4$ 150<br>$PH_3$ 3<br>$H_2$ 1500 | $SiH_4$ 400<br>$H_2$ 4000 | $SiH_4$ 400<br>$H_2$ 4000 | $BF_3$ 1<br>$H_2$ 500 |
| Internal pressure of the film forming chamber(Pa) | 130 | 135 | 135 | 130 |
| Temperature of strip type substrate (°C) | 300 | 300 | 300 | 150 |
| Discharging power (W) | High frequency (13.56MHz) 150 | High frequency (13.56MHz) 400 | High frequency (13.56MHz) 400 | Low frequency (75kHz) 1000 |
| Bias power (W) | - | - | - | - |

Table 3

| Film forming condition \ Film forming chamber | 102B | 104(1) | 104(2) | 105B |
|---|---|---|---|---|
| Semiconductor layer forming method | RF plasma CVD method | RF plasma CVD method | RF plasma CVD method | RF plasma CVD method |
| Semiconductor layer to be formed (nm) | n-type amorphous Si layer 20 | i-type amorphous Si layer 80 | i-type amorphous Si layer 80 | p-type amorphous Si layer about 10 |
| Length of the semiconductor layer forming region in the strip type substrate moving direction (cm) | 60 | 200 | 200 | 100 |
| Material gas (sccm) | $SiH_4$ 150<br>$PH_3$ 5<br>$H_2$ 1500 | $SiH_4$ 400<br>$H_2$ 4000 | $SiH_4$ 400<br>$H_2$ 4000 | $SiH_4$ 30<br>$BF_3$ 1<br>$H_2$ 500 |
| Internal pressure of the film forming chamber (Pa) | 130 | 135 | 135 | 130 |
| Temperature of strip type substrate (°C) | 300 | 300 | 300 | 150 |
| Discharging power (W) | High frequency (13.56MHz) 150 | High frequency (13.56MHz) 400 | High frequency (13.56MHz) 400 | High frequency (13.56MHz) 1000 |
| Bias power (W) | - | - | - | - |

EP 0 660 422 A2

Table 4

| Film forming chamber / Film forming condition | 102A | 103(1) | 103(2) | 103(3) | 105A |
|---|---|---|---|---|---|
| Semiconductor layer forming method | RF plasma CVD method | Microwave plasma CVD method | Microwave plasma CVD method | Microwave plasma CVD method | Plasma doping |
| Semiconductor layer to be formed (nm) | n-type amorphous Si layer 20 | i-type amorphous SiGe layer 50 | i-type amorphous SiGe layer 100 | i-type amorphous SiGe layer 25 | p-type amorphous Si layer about 10 |
| Length of the semiconductor layer forming region in the strip type substrate moving direction (cm) | 60 | 10 | 20 | 5 | 100 |
| Material gas (sccm) | $SiH_4$  150<br>$PH_3$  3<br>$H_2$  1500 | $SiH_4$  125<br>$GeH_4$  25<br>$H_2$  200 | $SiH_4$  100<br>$GeH_4$  50<br>$H_2$  200 | $SiH_4$  125<br>$GeH_4$  25<br>$H_2$  200 | $BF_3$  1<br>$H_2$  500 |
| Internal pressure of the film forming chamber (Pa) | 130 | 0.9 | 1 | 0.9 | 130 |
| Temperature of strip type substrate (°C) | 350 | 350 | 350 | 350 | 150 |
| Discharging power (W) | High frequency (13.56MHz) 150 | Microwave (2.45GHz) 300 | Microwave (2.45GHz) 300 | Microwave (2.45GHz) 300 | Low frequency (75kHz) 1000 |
| Bias power (W) | – | High frequency (13.56MHz) 600 | High frequency (13.56MHz) 600 | High frequency (13.56MHz) 600 | – |

EP 0 660 422 A2

Table 5

| Film forming condition / Film forming chamber | 102B | 104(1) | 104(2) | 105B |
|---|---|---|---|---|
| Semiconductor layer forming method | RF plasma CVD method | RF plasma CVD method | RF plasma CVD method | Plasma doping |
| Semiconductor layer to be formed (nm) | n-type amorphous Si layer 20 | i-type amorphous SiC layer 120 | i-type amorphous SiC layer 120 | p-type amorphous Si layer about 10 |
| Length of the semiconductor layer forming region in the strip type substrate moving direction (cm) | 100 | 300 | 300 | 100 |
| Material gas (sccm) | $SiH_4$ 150 <br> $PH_3$ 3 <br> $H_2$ 1500 | $SiH_4$ 400 <br> $CH_4$ 200 <br> $H_2$ 4000 | $SiH_4$ 400 <br> $CH_4$ 200 <br> $H_2$ 4000 | $BF_3$ 1 <br> $H_2$ 500 |
| Internal pressure of the film forming chamber (Pa) | 130 | 135 | 135 | 130 |
| Temperature of strip type substrate (°C) | 300 | 300 | 300 | 150 |
| Discharging power (W) | High frequency (13.56MHz) 150 | High frequency (13.56MHz) 600 | High frequency (13.56MHz) 600 | Low frequency (75kHz) 1000 |
| Bias power (W) | - | - | - | - |

EP 0 660 422 A2

Table 6

| Film forming condition \ Film forming chamber | 102A | 103(1) | 103(2) | 103(3) | 105A |
|---|---|---|---|---|---|
| Semiconductor layer forming method | RF plasma CVD method | Microwave plasma CVD method | Microwave plasma CVD method | Microwave plasma CVD method | RF plasma CVD method |
| Semiconductor layer to be formed (nm) | p-type amorphous Si layer 20 | i-type amorphous SiGe layer 50 | i-type amorphous SiGe layer 100 | i-type amorphous SiGe layer 25 | n-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$B_2H_6$ 3<br>$H_2$ 1500 | $SiH_4$ 125<br>$GeH_4$ 25<br>$H_2$ 200 | $SiH_4$ 100<br>$GeH_4$ 50<br>$H_2$ 200 | $SiH_4$ 125<br>$GeH_4$ 25<br>$H_2$ 200 | $SiH_4$ 30<br>$PH_3$ 1<br>$H_2$ 500 |
| Internal pressure of the film forming chamber (Pa) | 130 | 0.9 | 1 | 0.9 | 130 |
| Temperature of strip type substrate (°C) | 350 | 350 | 350 | 350 | 150 |
| Discharging power (W) | High frequency (13.56MHz) 150 | Microwave (2.45GHz) 300 | Microwave (2.45GHz) 300 | Microwave (2.45GHz) 300 | High frequency (13.56MHz)1000 |
| Bias power (W) | − | High frequency (13.56MHz) 600 | High frequency (13.56MHz) 600 | High frequency (13.56MHz) 600 | − |

EP 0 660 422 A2

Table 7

| Film forming condition \ Film forming chamber | 102B | 104(1) | 104(2) | 105B |
|---|---|---|---|---|
| Semiconductor layer forming method | RF plasma CVD method | RF plasma CVD method | RF plasma CVD method | Plasma doping |
| Semiconductor layer to be formed (nm) | p-type amorphous Si layer 20 | i-type amorphous Si layer 80 | i-type amorphous Si layer 80 | n-type amorphous Si layer about 10 |
| Length of the semiconductor layer forming region in the strip type substrate moving direction (cm) | 60 | 200 | 200 | 100 |
| Material gas (sccm) | $SiH_4$ 150 $B_2H_6$ 3 $H_2$ 1500 | $SiH_4$ 400 $H_2$ 4000 | $SiH_4$ 400 $H_2$ 4000 | $PH_3$ 1 $H_2$ 500 |
| Internal pressure of the film forming chamber(Pa) | 130 | 135 | 135 | 130 |
| Temperature of strip type substrate (°C) | 300 | 300 | 300 | 150 |
| Discharging power (W) | High frequency (13.56MHz) 150 | High frequency (13.56MHz) 400 | High frequency (13.56MHz) 400 | Low frequency (75kHz) 1000 |
| Bias power (W) | – | – | – | – |

EP 0 660 422 A2

Table 8

| Film forming chamber / Film forming Condition | 202A | 211 | 203(1) | 203(2) | 203(3) | 212 | 205A |
|---|---|---|---|---|---|---|---|
| Semiconductor layer forming method (or surface treatment method) | RF plasma CVD method | RF plasma CVD method | Microwave plasma CVD method | Microwave plasma CVD method | Microwave plasma CVD method | RF plasma CVD method | RF plasma CVD method |
| Semiconductor layer to be formed (nm) | n-type amorphous Si layer 20 | i-type amorphous Si layer 10 | i-type amorphous SiGe layer 50 | i-type amorphous SiGe layer 100 | i-type amorphous SiGe layer 25 | i-type amorphous Si layer 20 | p-type amorphous Si layer about 10 |
| Length of the region where the strip type substrate is exposed to plasma (cm) | 60 | 60 | 10 | 20 | 5 | 60 | 100 |
| Material gas (sccm) | $SiH_4$ 150<br>$PH_3$ 3<br>$H_2$ 1500 | $SiH_4$ 75<br>$H_2$ 750 | $SiH_4$ 125<br>$GeH_4$ 25<br>$H_2$ 200 | $SiH_4$ 100<br>$GeH_4$ 50<br>$H_2$ 200 | $SiH_4$ 125<br>$GeH_4$ 25<br>$H_2$ 200 | $SiH_4$ 150<br>$H_2$ 1500 | $SiH_4$ 30<br>$BF_3$ 1<br>$H_2$ 500 |
| Internal pressure of the film forming chamber (Pa) | 130 | 135 | 0.9 | 1 | 0.9 | 135 | 130 |
| Temperature of strip type substrate (°C) | 350 | 350 | 350 | 350 | 350 | 350 | 150 |
| Discharging power (W) | High frequency (13.56MHz) 150 | High frequency (13.56MHz) 75 | Microwave (2.45GHz) 300 | Microwave (2.45GHz) 300 | Microwave (2.45GHz) 300 | High frequency (13.56MHz) 150 | High frequency (13.56MHz)1000 |
| Bias power (W) | − | − | High frequency (13.56MHz) 600 | High frequency (13.56MHz) 600 | High frequency (13.56MHz) 600 | − | − |

EP 0 660 422 A2

Table 9

| Film forming chamber<br>Film forming Condition | 202A | 211 | 203(1) | 203(2) | 203(3) | 212 | 205A |
|---|---|---|---|---|---|---|---|
| Semiconductor layer forming method (or surface treatment method) | RF plasma CVD method | RF plasma CVD method | Microwave plasma CVD method | Microwave plasma CVD method | Microwave plasma CVD method | RF plasma CVD method | RF plasma CVD method |
| Semiconductor layer to be formed (nm) | n-type amorphous Si layer 20 | i-type amorphous Si layer 10 | i-type amorphous SiGe layer 50 | i-type amorphous SiGe layer 100 | i-type amorphous SiGe layer 25 | i-type amorphous Si layer 20 | p-type amorphous Si layer about 10 |
| Length of the region where the strip type substrate is exposed to plasma (cm) | 60 | 60 | 10 | 20 | 5 | 60 | 100 |
| Material gas (sccm) | $SiH_4$ 450<br>$PH_3$ 9<br>$H_2$ 4500 | $SiH_4$ 225<br>$H_2$ 2250 | $SiH_4$ 375<br>$GeH_4$ 75<br>$H_2$ 600 | $SiH_4$ 300<br>$GeH_4$ 150<br>$H_2$ 600 | $SiH_4$ 375<br>$GeH_4$ 75<br>$H_2$ 600 | $SiH_4$ 450<br>$H_2$ 4500 | $SiH_4$ 90<br>$BF_3$ 3<br>$H_2$ 1500 |
| Internal pressure of the film forming chamber (Pa) | 130 | 135 | 0.9 | 1 | 0.9 | 135 | 130 |
| Temperature of strip type substrate (°C) | 350 | 350 | 350 | 350 | 350 | 350 | 150 |
| Discharging power (W) | High frequency (13.56MHz) 450 | High frequency (13.56MHz) 225 | Microwave (2.45GHz)450x2 | Microwave (2.45GHz)450x2 | Microwave (2.45GHz)450x2 | High frequency (13.56MHz) 450 | High frequency (13.56MHz)3000 |
| Bias power (W) | - | - | High frequency (13.56MHz)1800 | High frequency (13.56MHz)1800 | High frequency (13.56MHz)1800 | - | - |

EP 0 660 422 A2

Table 10

| Film forming condition / Film forming chamber | 202B | 204(1) | 204(2) | 205B |
|---|---|---|---|---|
| Semiconductor layer forming method (or surface treatment method) | RF plasma CVD method | RF plasma CVD method | RF plasma CVD method | Plasma doping |
| Semiconductor layer to be formed (nm) | n-type amorphous Si layer 20 | i-type amorphous Si layer 80 | i-type amorphous Si layer 80 | p-type amorphous Si layer about 10 |
| Length of the region where the strip type substrate is exposed to plasma (cm) | 60 | 200 | 200 | 100 |
| Material gas (sccm) | $SiH_4$ 450<br>$PH_3$ 9<br>$H_2$ 4500 | $SiH_4$ 1200<br>$H_2$ 12000 | $SiH_4$ 1200<br>$H_2$ 12000 | $BF_3$ 3<br>$H_2$ 1500 |
| Internal pressure of the film form-ing chamber(Pa) | 130 | 135 | 135 | 130 |
| Temperature of strip type substrate (°C) | 300 | 300 | 300 | 150 |
| Discharging power (W) | High frequency (13.56MHz) 450 | High frequency (13.56MHz)1200 | High frequency (13.56MHz)1200 | Low frequency (75kHz) 3000 |
| Bias power (W) | - | - | - | - |

EP 0 660 422 A2

Table 11

| Film forming chamber / Film forming condition | 102A | 103A(1) | 103A(2) | 103A(3) | 105A |
|---|---|---|---|---|---|
| Semiconductor layer forming method | RF plasma CVD method | Microwave plasma CVD method | Microwave plasma CVD method | Microwave plasma CVD method | RF plasma CVD method |
| Semiconductor layer to be formed (nm) | n-type amorphous Si layer 20 | i-type amorphous SiGe layer 50 | i-type amorphous SiGe layer 100 | i-type amorphous SiGe layer 25 | p-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$PH_3$ 3<br>$H_2$ 1500 | $SiH_4$ 125<br>$GeH_4$ 25<br>$H_2$ 200 | $SiH_4$ 100<br>$GeH_4$ 50<br>$H_2$ 200 | $SiH_4$ 125<br>$GeH_4$ 25<br>$H_2$ 200 | $SiH_4$ 30<br>$BF_3$ 1<br>$H_2$ 500 |
| Internal pressure of the film forming chamber (Pa) | 130 | 0.9 | 1 | 0.9 | 130 |
| Temperature of strip type substrate (°C) | 350 | 350 | 350 | 350 | 150 |
| Discharging power (W) | High frequency (13.56MHz) 150 | Microwave (2.45GHz) 300 | Microwave (2.45GHz) 300 | Microwave (2.45GHz) 300 | High frequency (13.56MHz)1000 |
| Bias power (W) | – | High frequency (13.56MHz) 600 | High frequency (13.56MHz) 600 | High frequency (13.56MHz) 600 | – |

EP 0 660 422 A2

Table 12

| Film forming condition / Film forming chamber | 102B | 103B(1) | 103B(2) | 103B(3) | 105B |
|---|---|---|---|---|---|
| Semiconductor layer forming method | RF plasma CVD method | Microwave plasma CVD method | Microwave plasma CVD method | Microwave plasma CVD method | RF plasma CVD method |
| Semiconductor layer to be formed (nm) | n-type amorphous Si layer 20 | i-type amorphous SiGe layer 50 | i-type amorphous SiGe layer 100 | i-type amorphous SiGe layer 25 | p-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$PH_3$ 3<br>$H_2$ 1500 | $SiH_4$ 140<br>$GeH_4$ 10<br>$H_2$ 200 | $SiH_4$ 120<br>$GeH_4$ 30<br>$H_2$ 200 | $SiH_4$ 140<br>$GeH_4$ 10<br>$H_2$ 200 | $SiH_4$ 30<br>$BF_3$ 1<br>$H_2$ 500 |
| Internal pressure of the film forming chamber (Pa) | 130 | 0.9 | 1 | 0.9 | 130 |
| Temperature of strip type substrate (°C) | 300 | 300 | 350 | 300 | 150 |
| Discharging power (W) | High frequency (13.56MHz) 150 | Microwave (2.45GHz) 300 | Microwave (2.45GHz) 300 | Microwave (2.45GHz) 300 | High frequency (13.56MHz)1000 |
| Bias power (W) | - | High frequency (13.56MHz) 600 | High frequency (13.56MHz) 600 | High frequency (13.56MHz) 600 | - |

EP 0 660 422 A2

EP 0 660 422 A2

Table 13

| Film forming chamber / Film forming condition | 102C | 104 | 105C |
|---|---|---|---|
| Semiconductor layer forming method | RF plasma CVD method | RF plasma CVD method | Plasma doping |
| Semiconductor layer to be formed (nm) | n-type amorphous Si layer 20 | i-type amorphous Si layer 80 | p-type amorphous Si layer about 10 |
| Length of the semiconductor layer forming region in the strip type substrate moving direction (cm) | 60 | 200 | 100 |
| Material gas (sccm) | $SiH_4$ 150<br>$PH_3$ 3<br>$H_2$ 1500 | $SiH_4$ 400<br>$H_2$ 4000 | $BF_3$ 1<br>$H_2$ 500 |
| Internal pressure of the film forming chamber (Pa) | 130 | 135 | 130 |
| Temperature of strip type substrate (°C) | 250 | 250 | 150 |
| Discharging power (W) | High frequency (13.56MHz) 150 | High frequency (13.56MHz) 400 | Low frequency (75KHZ) 1000 |
| Bias power (W) | - | - | - |

55

Table 14

| Film forming chamber / Film forming condition | 102C | 104 | 105C |
|---|---|---|---|
| Semiconductor layer forming method | RF plasma CVD method | RF plasma CVD method | RF plasma CVD method |
| Semiconductor layer to be formed (nm) | n-type amorphous Si layer 20 | i-type amorphous Si layer 80 | p-type amorphous Si layer about 10 |
| Length of the semiconductor layer forming region in the strip type substrate moving direction (cm) | 60 | 200 | 100 |
| Material gas (sccm) | $SiH_4$ 150<br>$PH_3$ 3<br>$H_2$ 1500 | $SiH_4$ 400<br>$H_2$ 4000 | $SiH_4$ 30<br>$BF_3$ 1<br>$H_2$ 500 |
| Internal pressure of the film forming chamber (Pa) | 130 | 135 | 130 |
| Temperature of strip type substrate (°C) | 250 | 250 | 150 |
| Discharging power (W) | High frequency (13.56MHz) 150 | High frequency (13.56MHz) 400 | High frequency (13.56MHz) 1000 |
| Bias power (W) | - | - | - |

EP 0 660 422 A2

Table 15

| Film forming condition \ Film forming chamber | 102A | 103A(1) | 103A(2) | 103A(3) | 105A |
|---|---|---|---|---|---|
| Semiconductor layer forming method | RF plasma CVD method | Microwave plasma CVD method | Microwave plasma CVD method | Microwave plasma CVD method | Plasma doping |
| Semiconductor layer to be formed (nm) | n-type amorphous Si layer 20 | i-type amorphous SiGe layer 50 | i-type amorphous SiGe layer 100 | i-type amorphous SiGe layer 25 | p-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$PH_3$ 3<br>$H_2$ 1500 | $SiH_4$ 125<br>$GeH_4$ 25<br>$H_2$ 200 | $SiH_4$ 100<br>$GeH_4$ 50<br>$H_2$ 200 | $SiH_4$ 125<br>$GeH_4$ 25<br>$H_2$ 200 | $BF_3$ 1<br>$H_2$ 500 |
| Internal pressure of the film forming chamber (Pa) | 130 | 0.9 | 1 | 0.9 | 130 |
| Temperature of strip type substrate (°C) | 350 | 350 | 350 | 350 | 150 |
| Discharging power (W) | High frequency (13.56MHz) 150 | Microwave (2.45GHz) 300 | Microwave (2.45GHz) 300 | Microwave (2.45GHz) 300 | Low frequency (75KHz)1000 |
| Bias power (W) | - | High frequency (13.56MHz) 600 | High frequency (13.56MHz) 600 | High frequency (13.56MHz) 600 | - |

EP 0 660 422 A2

Table 16

| Film forming chamber / Film forming condition | 102B | 103B(1) | 103B(2) | 103B(3) | 105B |
|---|---|---|---|---|---|
| Semiconductor layer forming method | RF plasma CVD method | Microwave plasma CVD method | Microwave plasma CVD method | Microwave plasma CVD method | Plasma doping |
| Semiconductor layer to be formed (nm) | n-type amorphous Si layer 20 | i-type amorphous SiGe layer 50 | i-type amorphous SiGe layer 100 | i-type amorphous SiGe layer 25 | p-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$PH_3$ 3<br>$H_2$ 1500 | $SiH_4$ 140<br>$GeH_4$ 10<br>$H_2$ 200 | $SiH_4$ 120<br>$GeH_4$ 30<br>$H_2$ 200 | $SiH_4$ 140<br>$GeH_4$ 10<br>$H_2$ 200 | $BF_3$ 1<br>$H_2$ 500 |
| Internal pressure of the film forming chamber (Pa) | 130 | 0.9 | 1 | 0.9 | 130 |
| Temperature of strip type substrate (°C) | 300 | 300 | 300 | 300 | 150 |
| Discharging power (W) | High frequency (13.56MHz) 150 | Microwave (2.45GHz) 300 | Microwave (2.45GHz) 300 | Microwave (2.45GHz) 300 | Low frequency (75KHz)1000 |
| Bias power (W) | - | High frequency (13.56MHz) 600 | High frequency (13.56MHz) 600 | High frequency (13.56MHz) 600 | - |

EP 0 660 422 A2

Table 17

| Film forming condition \ Film forming chamber | 102C | 104 | 105C |
|---|---|---|---|
| Semiconductor layer forming method | RF plasma CVD method | RF plasma CVD method | Plasma doping |
| Semiconductor layer to be formed (nm) | n-type amorphous Si layer 20 | i-type amorphous SiC layer 120 | p-type amorphous Si layer about 10 |
| Length of the semiconductor layer forming region in the strip type substrate moving direction (cm) | 60 | 300 | 100 |
| Material gas (sccm) | $SiH_4$ 150<br>$PH_3$ 3<br>$H_2$ 1500 | $SiH_4$ 400<br>$CH_4$ 200<br>$H_2$ 4000 | $BF_3$ 1<br>$H_2$ 500 |
| Internal pressure of the film forming chamber (pa) | 130 | 135 | 130 |
| Temperature of strip type substrate (°C) | 250 | 250 | 150 |
| Discharging power (W) | High frequency (13.56MHz) 150 | High frequency (13.56MHz) 600 | Low frequency (75KHz) 1000 |
| Bias power (W) | - | - | - |

Table 18

| Film forming chamber / Film forming condition | 102A | 103A(1) | 103A(2) | 103A(3) | 105A |
|---|---|---|---|---|---|
| Semiconductor layer forming method | RF plasma CVD method | Microwave plasma CVD method | Microwave plasma CVD method | Microwave plasma CVD method | RF plasma CVD method |
| Semiconductor layer to be formed (nm) | p-type amorphous Si layer 20 | i-type amorphous SiGe layer 50 | i-type amorphous SiGe layer 100 | i-type amorphous SiGe layer 25 | n-type amorphous Si layer about 10 |
| Length of the semiconductor layer forming region in the strip type substrate moving direction (cm) | 60 | 10 | 20 | 5 | 100 |
| Material gas (sccm) | $SiH_4$  150<br>$B_2H_6$  3<br>$H_2$  1500 | $SiH_4$  125<br>$GeH_4$  25<br>$H_2$  200 | $SiH_4$  100<br>$GeH_4$  50<br>$H_2$  200 | $SiH_4$  125<br>$GeH_4$  25<br>$H_2$  200 | $SiH_4$  30<br>$PH_3$  1<br>$H_2$  500 |
| Internal pressure of the film forming chamber (Pa) | 130 | 0.9 | 1 | 0.9 | 130 |
| Temperature of strip type substrate (°C) | 350 | 350 | 350 | 350 | 150 |
| Discharging power (W) | High frequency (13.56MHz) 150 | Microwave (2.45GHz) 300 | Microwave (2.45GHz) 300 | Microwave (2.45GHz) 300 | High frequency (13.56MHz)1000 |
| Bias power (W) | - | High frequency (13.56MHz) 600 | High frequency (13.56MHz) 600 | High frequency (13.56MHz) 600 | - |

EP 0 660 422 A2

EP 0 660 422 A2

Table 19

| Film forming chamber / Film forming condition | 102B | 103B(1) | 103B(2) | 103B(3) | 105B |
|---|---|---|---|---|---|
| Semiconductor layer forming method | RF plasma CVD method | Microwave plasma CVD method | Microwave plasma CVD method | Microwave plasma CVD method | RF plasma CVD method |
| Semiconductor layer to be formed (nm) | p-type amorphous Si layer 20 | i-type amorphous SiGe layer 50 | i-type amorphous SiGe layer 100 | i-type amorphous SiGe layer 25 | n-type amorphous Si layer about 10 |
| Length of the semiconductor layer forming region in the strip type substrate moving direction (cm) | 60 | 10 | 20 | 5 | 100 |
| Material gas (sccm) | $SiH_4$ 150<br>$B_2H_6$ 3<br>$H_2$ 1500 | $SiH_4$ 140<br>$GeH_4$ 10<br>$H_2$ 200 | $SiH_4$ 120<br>$GeH_4$ 30<br>$H_2$ 200 | $SiH_4$ 140<br>$GeH_4$ 10<br>$H_2$ 200 | $SiH_4$ 30<br>$PH_3$ 1<br>$H_2$ 500 |
| Internal pressure of the film forming chamber (Pa) | 130 | 0.9 | 1 | 0.9 | 130 |
| Temperature of strip type substrate (°C) | 300 | 300 | 300 | 300 | 150 |
| Discharging power (W) | High frequency (13.56MHz) 150 | Microwave (2.45GHz) 300 | Microwave (2.45GHz) 300 | Microwave (2.45GHz) 300 | High frequency (13.56MHz)1000 |
| Bias power (W) | - | High frequency (13.56MHz) 600 | High frequency (13.56MHz) 600 | High frequency (13.56MHz) 600 | - |

Table 20

| Film forming condition \ Film forming chamber | 102C | 104 | 105C |
|---|---|---|---|
| Semiconductor layer forming method | RF plasma CVD method | RF plasma CVD method | Plasma doping |
| Semiconductor layer to be formed (nm) | p-type amorphous Si layer 20 | i-type amorphous Si layer 80 | n-type amorphous Si layer about 10 |
| Length of the semiconductor layer forming region in the strip type substrate moving direction (cm) | 60 | 200 | 100 |
| Material gas (sccm) | $SiH_4$ 150<br>$B_2H_6$ 3<br>$H_2$ 1500 | $SiH_4$ 400<br>$H_2$ 4000 | $PH_3$ 1<br>$H_2$ 500 |
| Internal pressure of the film form-ing chamber (Pa) | 130 | 135 | 130 |
| Temperature of strip type substrate (°C) | 250 | 250 | 150 |
| Discharging power (W) | High frequency (13.56MHz) 150 | High frequency (13.56MHz) 400 | Low frequency (75KHz) 1000 |
| Bias power (W) | – | – | – |

EP 0 660 422 A2

EP 0 660 422 A2

Table 21

| Film forming chamber / Film forming condition | 202A | 211A | 203A(1) | 203A(2) | 203A(3) | 212A | 205A |
|---|---|---|---|---|---|---|---|
| Semiconductor layer forming method (or surface treatment method) | RF plasma CVD method | RF plasma CVD method | Microwave plasma CVD method | Microwave plasma CVD method | Microwave plasma CVD method | RF plasma CVD method | RF plasma CVD method |
| Semiconductor layer to be formed (nm) | n-type amorphous Si layer 20 | i-type amorphous Si layer 10 | i-type amorphous SiGe layer 50 | i-type amorphous SiGe layer 100 | i-type amorphous SiGe layer 25 | i-type amorphous Si layer 20 | p-type amorphous Si layer about 10 |
| Length of the region where the strip type substrate is exposed to plasma (cm) | 60 | 60 | 10 | 20 | 5 | 60 | 100 |
| Material gas (sccm) | $SiH_4$ 150 $PH_3$ 3 $H_2$ 1500 | $SiH_4$ 75 $H_2$ 750 | $SiH_4$ 125 $GeH_4$ 25 $H_2$ 200 | $SiH_4$ 100 $GeH_4$ 50 $H_2$ 200 | $SiH_4$ 125 $GeH_4$ 25 $H_2$ 200 | $SiH_4$ 150 $H_2$ 1500 | $SiH_4$ 30 $BF_3$ 1 $H_2$ 500 |
| Internal pressure of the film forming chamber (Pa) | 130 | 135 | 0.9 | 1 | 0.9 | 135 | 130 |
| Temperature of strip type substrate (°C) | 350 | 350 | 350 | 350 | 350 | 350 | 150 |
| Discharging power (W) | High frequency (13.56MHz) 150 | High frequency (13.56MHz) 75 | Microwave (2.45GHz) 300 | Microwave (2.45GHz) 300 | Microwave (2.45GHz) 300 | High frequency (13.56MHz) 150 | High frequency (13.56MHz)1000 |
| Bias power (W) | – | – | High frequency (13.56MHz) 600 | High frequency (13.56MHz) 600 | High frequency (13.56MHz) 600 | – | – |

63

Table 22

| Film forming chamber / Film forming condition | 202B | 211B | 203B(1) | 203B(2) | 203B(3) | 212B | 205B |
|---|---|---|---|---|---|---|---|
| Semiconductor layer forming method (or surface treatment method) | RF plasma CVD method | RF plasma CVD method | Microwave plasma CVD method | Microwave plasma CVD method | Microwave plasma CVD method | RF plasma CVD method | RF plasma CVD method |
| Semiconductor layer to be formed (nm) | n-type amorphous Si layer 20 | i-type amorphous Si layer 10 | i-type amorphous SiGe layer 50 | i-type amorphous SiGe layer 100 | i-type amorphous SiGe layer 25 | i-type amorphous Si layer 20 | p-type amorphous Si layer about 10 |
| Length of the region where the strip type substrate is exposed to plasma (cm) | 60 | 60 | 10 | 20 | 5 | 60 | 100 |
| Material gas (sccm) | $SiH_4$ 150<br>$PH_3$ 3<br>$H_2$ 1500 | $SiH_4$ 75<br>$H_2$ 750 | $SiH_4$ 140<br>$GeH_4$ 10<br>$H_2$ 200 | $SiH_4$ 120<br>$GeH_4$ 30<br>$H_2$ 200 | $SiH_4$ 140<br>$GeH_4$ 10<br>$H_2$ 200 | $SiH_4$ 150<br>$H_2$ 1500 | $SiH_4$ 30<br>$BF_3$ 1<br>$H_2$ 500 |
| Internal pressure of the film forming chamber (Pa) | 130 | 135 | 0.9 | 1 | 0.9 | 135 | 130 |
| Temperature of strip type substrate (°C) | 300 | 300 | 300 | 300 | 300 | 300 | 150 |
| Discharging power (W) | High frequency (13.56MHz) 150 | High frequency (13.56MHz) 75 | Microwave (2.45GHz) 300 | Microwave (2.45GHz) 300 | Microwave (2.45GHz) 300 | High frequency (13.56MHz) 150 | High frequency (13.56MHz)1000 |
| Bias power (W) | - | - | High frequency (13.56MHz) 600 | High frequency (13.56MHz) 600 | High frequency (13.56MHz) 600 | - | - |

EP 0 660 422 A2

64

Table 23

| Film forming condition \ Film forming chamber | 202C | 204 | 205C |
|---|---|---|---|
| Semiconductor layer forming method (or surface treatment method) | RF plasma CVD method | RF plasma CVD method | Plasma doping |
| Semiconductor layer to be formed (nm) | n-type amorphous Si layer 20 | i-type amorphous Si layer 80 | p-type amorphous Si layer about 10 |
| Length of the region where the strip type substrate is exposed to plasma (cm) | 60 | 200 | 100 |
| Material gas (sccm) | SiH$_4$ 150, PH$_3$ 3, H$_2$ 1500 | SiH$_4$ 400, H$_2$ 4000 | BF$_3$ 1, H$_2$ 500 |
| Internal pressure of the film forming chamber (Pa) | 130 | 135 | 130 |
| Temperature of strip type substrate (°C) | 250 | 250 | 150 |
| Discharging power (W) | High frequency (13.56MHz) 150 | High frequency (13.56MHz) 400 | Low frequency (75kHz) 1000 |
| Bias power (W) | – | – | – |

Table 24

| Film forming condition \ Film forming chamber | 202A | 211A | 203A(1) | 203A(2) | 203A(3) | 212A | 205A |
|---|---|---|---|---|---|---|---|
| Semiconductor layer forming method (or surface treatment method) | RF plasma CVD method | RF plasma CVD method | Microwave plasma CVD method | Microwave plasma CVD method | Microwave plasma CVD method | RF plasma CVD method | RF plasma CVD method |
| Semiconductor layer to be formed (nm) | n-type amorphous Si layer 20 | i-type amorphous Si layer 10 | i-type amorphous SiGe layer 50 | i-type amorphous SiGe layer 100 | i-type amorphous SiGe layer 25 | i-type amorphous Si layer 20 | p-type amorphous Si layer about 10 |
| Length of the region where the strip type substrate is exposed to plasma (cm) | 60 | 60 | 10 | 20 | 5 | 60 | 100 |
| Material gas (sccm) | $SiH_4$ 450 $PH_3$ 9 $H_2$ 4500 | $SiH_4$ 225 $H_2$ 2250 | $SiH_4$ 375 $GeH_4$ 75 $H_2$ 600 | $SiH_4$ 300 $GeH_4$ 150 $H_2$ 600 | $SiH_4$ 375 $GeH_4$ 75 $H_2$ 600 | $SiH_4$ 450 $H_2$ 4500 | $SiH_4$ 90 $BF_3$ 3 $H_2$ 1500 |
| Internal pressure of the film forming chamber (Pa) | 130 | 135 | 0.9 | 1 | 0.9 | 135 | 130 |
| Temperature of strip type substrate (°C) | 350 | 350 | 350 | 350 | 350 | 350 | 150 |
| Discharging power (W) | High frequency (13.56MHz) 450 | High frequency (13.56MHz) 225 | Microwave (2.45GHz)450x2 | Microwave (2.45GHz)450x2 | Microwave (2.45GHz)450x2 | High frequency (13.56MHz) 450 | High frequency (13.56MHz)3000 |
| Bias power (W) | - | - | High frequency (13.56MHz)1800 | High frequency (13.56MHz)1800 | High frequency (13.56MHz)1800 | - | - |

EP 0 660 422 A2

66

Table 25

| Film forming chamber / Film forming condition | 202B | 211B | 203B(1) | 203B(2) | 202B(3) | 212B | 205B |
|---|---|---|---|---|---|---|---|
| Semiconductor layer forming method (or surface treatment method) | RF plasma CVD method | RF plasma CVD method | Microwave plasma CVD method | Microwave plasma CVD method | Microwave plasma CVD method | RF plasma CVD method | RF plasma CVD method |
| Semiconductor layer to be formed (nm) | n-type amorphous Si layer 20 | i-type amorphous Si layer 10 | i-type amorphous SiGe layer 50 | i-type amorphous SiGe layer 100 | i-type amorphous SiGe layer 25 | i-type amorphous Si layer 20 | p-type amorphous Si layer about 10 |
| Length of the region where the strip type substrate is exposed to plasma (cm) | 60 | 60 | 10 | 20 | 5 | 60 | 100 |
| Material gas (sccm) | $SiH_4$ 450<br>$PH_3$ 9<br>$H_2$ 4500 | $SiH_4$ 225<br>$H_2$ 2250 | $SiH_4$ 420<br>$GeH_4$ 30<br>$H_2$ 600 | $SiH_4$ 360<br>$GeH_4$ 90<br>$H_2$ 600 | $SiH_4$ 420<br>$GeH_4$ 30<br>$H_2$ 600 | $SiH_4$ 450<br>$H_2$ 4500 | $SiH_4$ 90<br>$BF_3$ 3<br>$H_2$ 1500 |
| Internal pressure of the film forming chamber (Pa) | 130 | 135 | 0.9 | 1 | 0.9 | 135 | 130 |
| Temperature of strip type substrate (°C) | 300 | 300 | 300 | 300 | 300 | 300 | 150 |
| Discharging power (W) | High frequency (13.56MHz) 450 | High frequency (13.56MHz) 225 | Microwave (2.45GHz)450x2 | Microwave (2.45GHz)450x2 | Microwave (2.45GHz)450x2 | High frequency (13.56MHz) 450 | High frequency (13.56MHz)3000 |
| Bias power (W) | - | - | High frequency (13.56MHz)1800 | High frequency (13.56MHz)1800 | High frequency (13.56MHz)1800 | - | - |

EP 0 660 422 A2

67

Table 26

| Film forming condition \ Film forming chamber | 202C | 204 | 205C |
|---|---|---|---|
| Semiconductor layer forming method (or surface treatment method) | RF plasma CVD method | RF plasma CVD method | Plasma doping |
| Semiconductor layer to be formed (nm) | n-type amorphous Si layer 20 | i-type amorphous Si layer 80 | p-type amorphous Si layer about 10 |
| Length of the region where the strip type substrate is exposed to plasma (cm) | 60 | 200 | 100 |
| Material gas (sccm) | $SiH_4$ 450<br>$PH_3$ 9<br>$H_2$ 4500 | $SiH_4$ 1200<br>$H_2$ 12000 | $BF_3$ 3<br>$H_2$ 1500 |
| Internal pressure of the film forming chamber (Pa) | 130 | 135 | 130 |
| Temperature of strip type substrate (°C) | 250 | 250 | 150 |
| Discharging power (W) | High frequency (13.56MHz) 450 | High frequency (13.56MHz)1200 | Low frequency (75kHz) 3000 |
| Bias power (W) | — | — | — |

The present invention enables to continuously form semiconductor stacking films for an amorphous photovoltaic cell on a large area without variations and unevenness of characteristics at high speeds by the roll-to-roll system.

In addition, the present invention also enables to continuously form semiconductor stacking films for a 2-layer or 3-layer tandem type photovoltaic cell capable of providing a high photoelectric conversion efficiency on a large area at high speed without less deterioration of light.

## Claims

1. A photovoltaic cell which has a stacking structure comprising a first semiconductor layer which is made of a silicon-based amorphous semiconductor and has a first conductivity type; a first i-type semiconductor

68

layer a main part of which is formed by a microwave plasma CVD method; a second semiconductor layer which has a conductivity type opposite to the first conductivity type; a third semiconductor layer which has the first conductivity type; a second i-type semiconductor layer which is formed by an RF plasma CVD method; and a fourth semiconductor layer which has a conductivity type opposite to the first conductivity type,

wherein said second semiconductor layer is formed by the RF plasma CVD method and said fourth semiconductor layer is formed by plasma doping.

2. A method for fabricating a photovoltaic cell by which stacking films of silicon-based amorphous semiconductors are formed on a substrate, comprising a step for forming an n(or p)-type semiconductor layer by an RF plasma CVD method; a step for forming an i-type semiconductor layer by a microwave plasma CVD method; a step for forming a p(or n)-type semiconductor layer by an RF plasma method; a step for forming an n(or p)-type semiconductor layer by the RF plasma CVD method; a step for forming the i-type semiconductor layer by the RF plasma CVD method; and a step for forming the p(or n)-type semiconductor layer by plasma doping.

3. A photovoltaic cell fabrication apparatus for continuously forming stacking films of silicon-based amorphous semiconductors on a strip type substrate, at least comprising a strip type substrate unwinding chamber; an n(or p)-type semiconductor layer film forming chamber which depends on an RF plasma CVD method; an i-type semiconductor layer film forming chamber which depends on a microwave plasma CVD method; a p(or n)-type semiconductor layer film forming chamber which depends on an RF plasma CVD method; an n(or p)-type semiconductor layer film forming chamber which depends on the RF plasma CVD method; an i-type semiconductor layer film forming chamber which depends on the RF plasma CVD method; a p(or n)-type semiconductor layer film forming chamber which depends on plasma doping; and a strip type substrate takeup chamber, wherein said chambers thereof are arranged in the above-described order along a direction where said strip type substrate is moved and connected with gas gates, respectively, to continuously form stacking films of silicon-based amorphous semiconductor layers on said strip type substrate which is continuously moved to pass through said film forming chambers.

4. A photovoltaic cell fabrication apparatus according to Claim 3, wherein an i-type semiconductor layer film forming chamber is further arranged with gas gates between said i-type semiconductor layer film forming chamber, which depends on said microwave plasma CVD method and said p(or n)-type semiconductor layer film forming chamber, which depends on said RF plasma CVD method which are arranged with said gas gates.

5. A photovoltaic cell fabrication apparatus according to Claim 3, wherein an i-type semiconductor layer film forming chamber is further arranged with gas gates between said i-type semiconductor layer film forming chamber, which depends on said microwave plasma CVD method and said n(or p)-type semiconductor layer film forming chamber, which depends on said RF plasma CVD method which are arranged with said gas gates.

6. A photovoltaic cell fabrication apparatus according to Claim 4, wherein an i-type semiconductor layer film forming chamber is further arranged with gas gates between said i-type semiconductor layer film forming chamber, which depends on said microwave plasma CVD method and said n(or p)-type semiconductor layer film forming chamber, which depends on said RF plasma CVD method which are arranged with said gas gates.

7. A photovoltaic cell which has a stacking structure comprising a first semiconductor layer which is made of a silicon-based amorphous semiconductor and has a first conductivity type; a first i-type semiconductor layer a main part of which is formed by a microwave plasma CVD method; a second semiconductor layer which has a conductivity type opposite to the first conductivity type; a third semiconductor layer which has the first conductivity type; a second i-type semiconductor layer a main part of which is formed by the microwave plasma CVD method; a fourth semiconductor layer which has a conductivity type opposite to the first conductivity type; a fifth semiconductor layer which has the first conductivity type; a third i-type semiconductor layer which is formed by an RF plasma CVD method; and a sixth semiconductor layer which has a conductivity type opposite to the first conductivity type,

wherein said second semiconductor layer and said fourth semiconductor layer are formed by the RF plasma CVD method and said sixth semiconductor layer is formed by plasma doping.

8. A method for fabricating a photovoltaic cell by which stacking films of silicon-based amorphous semiconductors are formed on a substrate, comprising a step for forming an n(or p)-type semiconductor layer by an RF plasma CVD method; a step for forming an i-type semiconductor layer by a microwave plasma CVD method; a step for forming a p(or n)-type semiconductor layer by an RF plasma method; a step for forming an n(or p)-type semiconductor layer by the RF plasma CVD method; a step for forming an i-type semiconductor layer by the microwave plasma CVD method; a step for forming a p(or n)-type semiconductor layer by the RF plasma CVD method; a step for forming an n(or p) semiconductor layer by the RF plasma method; a step for forming the i-type semiconductor layer by the RF plasma CVD method; and a step for forming the p(or n)-type semiconductor layer by plasma doping.

9. A photovoltaic cell fabrication apparatus for continuously forming stacking films of silicon-based amorphous semiconductors on a strip type substrate, at least comprising a strip type substrate unwinding chamber; an n(or p)-type semiconductor layer film forming chamber which depends on an RF plasma CVD method; an i-type semiconductor layer film forming chamber which depends on a microwave plasma CVD method; an p(or n)-type semiconductor layer film forming chamber which depends on an RF plasma CVD method; an n(or p)-type semiconductor layer film forming chamber which depends on the RF plasma CVD method; an i-type semiconductor layer film forming chamber which depends on the microwave plasma CVD method; a p(or n)-type semiconductor layer film forming chamber which depends on the RF plasma CVD method; an n(or p)-type semiconductor layer film forming chamber which depends on the RF plasma CVD method; an i-type semiconductor layer film forming chamber which depends on the RF plasma CVD method; a p(or n)-type semiconductor layer film forming chamber which depends on plasma doping; and a strip type substrate takeup chamber, wherein said chambers thereof are arranged in the above-described order along a direction where said strip type substrate is moved and connected with gas gates, respectively, to continuously form stacking films of silicon-based amorphous semiconductor layers on said strip type substrate which is continuously moved to pass through said film forming chambers.

10. A photovoltaic cell fabrication apparatus according to Claim 9, wherein an i-type semiconductor layer film forming chamber is further arranged with gas gates at least at one position between said i-type semiconductor layer film forming chamber, which depends on said microwave plasma CVD method and said p(or n)-type semiconductor layer film forming chamber, which depends on said RF plasma CVD method which are arranged with said gas gates.

11. A photovoltaic cell fabrication apparatus according to Claim 9, wherein an i-type semiconductor layer film forming chamber is further arranged with gas gates at least at one position between said i-type semiconductor layer film forming chamber, which depends on said microwave plasma CVD method and said n(or p)-type semiconductor layer film forming chamber, which depends on said RF plasma CVD method which are arranged with said gas gates.

12. A photovoltaic cell fabrication apparatus according to Claim 10, wherein an i-type semiconductor layer film forming chamber is further arranged with gas gates at least at one position between said i-type semiconductor layer film forming chamber, which depends on said microwave plasma CVD method and said n(or p)-type semiconductor layer film forming chamber, which depends on said RF plasma CVD method which are arranged with said gas gates.

13. A method for fabricating a photovoltaic cell according to Claim 2, wherein said plasma doping is a plasma CVD method.

14. A method for fabricating a photovoltaic cell according to Claim 13, wherein the frequency for said plasma CVD method is 1kHz to 500kHz.

15. A method for fabricating a photovoltaic cell according to Claim 2, wherein a flow rate of hydrogen gas in said plasma doping is ten times or over a flow rate of a gas containing impurities.

16. A method for fabricating a photovoltaic cell according to Claim 2, wherein a temperature of a strip type substrate in said plasma doping is 400°C or under.

17. A method for fabricating a photovoltaic cell according to Claim 8, wherein said plasma doping is a plasma CVD method.

18. A method for fabricating a photovoltaic cell according to Claim 17, wherein the frequency for said plasma CVD method is 1kHz to 500kHz.

19. A method for fabricating a photovoltaic cell according to Claim 8, wherein a flow rate of hydrogen gas in said plasma doping is ten times or over a flow rate of a gas containing impurities.

20. A method for fabricating a photovoltaic cell according to Claim 8, wherein a temperature of a strip type substrate in said plasma doping is 400°C or under.

# FIG. 1

FIG. 2

EP 0 660 422 A2

FIG. 3

EP 0 660 422 A2

# FIG. 4

505

529 521 506 515 522 507 516 523 508 517 529 524

501

528
529
528
518
519
520
511 514
528
553
552
551
550

EP 0 660 422 A2

FIG. 5

EP 0 660 422 A2

# FIG. 6A

702A
703A
707A
706A
705A
701A
704A
708A

# FIG. 6B

702B
703B
707B
706B
705B
701B
704B
708B

EP 0 660 422 A2

FIG. 7

802

804

805

801

803

806

FIG. 8

FIG. 9

FIG. 10

FIG. 11

EP 0 660 422 A2

EP 0 660 422 A2

## FIG. 12

- 1211
- 1210
- 1206
- 1204
- 1202B
- 1205A
- 1203
- 1202A
- 1201

## FIG. 13

- 1311
- 1310
- 1307
- 1304
- 1305B
- 1302A
- 1303
- 1305A
- 1301

## FIG. 14

- 1411
- 1410
- 1406
- 1404
- 1402B
- 1405A
- 1409
- 1403
- 1408
- 1402 A
- 1401

FIG. 17

FIG. 16

FIG. 15